# EUROPEAN PATENT APPLICATION

(11) **EP 4 637 304 A1**
(43) Date of publication of application: **22.10.2025**
(21) Application number: 25735432.4
(22) Date of filing: 10.02.2025
(51) Int. Cl.: H10F 77/20, H10F 71/00

(54) **BACK-CONTACT CELL AND MANUFACTURING METHOD THEREFOR**

(30) Priority: 27.02.2024 CN 202410216919
(71) Applicant: Longi Green Energy Technology Co., Ltd., Xi'an, Shaanxi 710100 (CN)
(72) Inventor: CHEN, Chen, Xi'an, Shaanxi 710100 (CN); CHEN, Yao, Xi'an, Shaanxi 710100 (CN); TONG, Hongbo, Xi'an, Shaanxi 710100 (CN)
(74) Representative: Grünecker Patent- und Rechtsanwälte PartG mbB
(86) International application number: PCT/CN2025/076689
(87) International publication number: WO 2025/180203

(57) **Abstract**

The present application relates to the field of photovoltaic technologies, and discloses a back contact solar cell and a method for manufacturing same, to mitigate a current leakage risk between a first doped semiconductor layer and a second doped semiconductor layer having opposite conductivity types in a back contact solar cell. The back contact solar cell includes a semiconductor substrate, a first doped semiconductor layer, a second doped semiconductor layer, a first dielectric layer, and a second dielectric layer. At least a portion of the first dielectric layer and at least a portion of the second dielectric layer are stacked between the first doped semiconductor layer and the second doped semiconductor layer in a direction in which first regions and second regions are arranged. At least a portion of the first dielectric layer is in contact with the first doped semiconductor layer. At least a portion of the second dielectric layer is in contact with the second doped semiconductor layer. A material of the first dielectric layer is different from that of the second dielectric layer. A structure formed by the first dielectric layer and the second dielectric layer is configured for electrically isolating at least some regions of the first doped semiconductor layer from at least some regions of the second doped semiconductor layer.

## Description

### CROSS-REFERENCE TO RELATED APPLICATIONS

The present application claims priority to Chinese Patent Application No. 202410216919.8 filed on February 27, 2024, which is incorporated herein by reference in its entirety.

### TECHNICAL FIELD

The present application relates to the field of photovoltaic technologies, and in particular, to a back contact solar cell and a method for manufacturing same.

### BACKGROUND

A back contact solar cell is a solar cell with both a positive electrode and a negative electrode located on a back surface of the solar cell and a front surface not covered by a metal electrode. Compared with a solar cell with a covered front surface, a back contact solar cell has a higher short-circuit current and higher photoelectric conversion efficiency, and is currently one of the technical directions for implementing a high-efficiency crystalline silicon solar cell.

However, in an existing back contact solar cell, a current leakage risk between a first doped semiconductor layer and a second doped semiconductor layer that have opposite conductivity types and that are alternately distributed at an interval on a back surface is high, which is not beneficial to improving the operating performance of the back contact solar cell.

### SUMMARY

An objective of the present application is to provide a back contact solar cell and a method for manufacturing same, to mitigate a current leakage risk between a first doped semiconductor layer and a second doped semiconductor layer having opposite conductivity types in a back contact solar cell, which is beneficial to improving the operating performance of the back contact solar cell.

To achieve the foregoing objective, according to a first aspect, the present application provides a back contact solar cell. The back contact solar cell includes a semiconductor substrate, a first doped semiconductor layer, a second doped semiconductor layer, a first dielectric layer, and a second dielectric layer. First regions and second regions that are alternately distributed at intervals are provided on a back surface of the semiconductor substrate, and a spacing region is located between each of the first regions and a second region adjacent to the first region. The first doped semiconductor layer is formed on the first regions provided on the back surface. The second doped semiconductor layer is formed at least on the second regions provided on the back surface, where a conductivity type of the second doped semiconductor layer is opposite to that of the first doped semiconductor layer. The first dielectric layer and the second dielectric layer are formed at least on the spacing regions provided on the back surface. At least a portion of the first dielectric layer and at least a portion of the second dielectric layer are stacked between the first doped semiconductor layer and the second doped semiconductor layer in a direction in which the first regions and the second regions are arranged. At least a portion of the first dielectric layer is in contact with the first doped semiconductor layer. At least a portion of the second dielectric layer is in contact with the second doped semiconductor layer. A material of the first dielectric layer is different from that of the second dielectric layer. A structure formed by the first dielectric layer and the second dielectric layer is configured for electrically isolating at least some regions of the first doped semiconductor layer from at least some regions of the second doped semiconductor layer.

In a case that the foregoing technical solution is used, in the back contact solar cell provided in the present application, both the first doped semiconductor layer and the second doped semiconductor layer having opposite conductivity types are located on the back surface of the semiconductor substrate. A corresponding region between the first doped semiconductor layer and the second doped semiconductor layer on the back surface of the semiconductor substrate is the spacing region, and with the presence of the spacing region, the first doped semiconductor layer and the second doped semiconductor layer can be spatially separated in a direction parallel to the back surface. In addition, the back contact solar cell provided in the present application further includes the first dielectric layer and the second dielectric layer that are formed at least on the spacing regions provided on the back surface. At least a portion of the first dielectric layer and at least a portion of the second dielectric layer are stacked between the first doped semiconductor layer and the second doped semiconductor layer in the direction in which the first regions and the second regions are arranged. It can be learned that, in the direction in which the first regions and the second regions are arranged, the two dielectric layers, namely, the first dielectric layer and the second dielectric layer, provided between at least a portion of the first doped semiconductor layer and at least a portion of the second doped semiconductor layer are used for electrical isolation. Compared with that a first doped semiconductor layer is isolated from a second doped semiconductor layer by only a single dielectric layer (for example, a surface passivation layer) with poor insulation in an existing back contact solar cell, the structure formed by the first dielectric layer and the second dielectric layer in the present application has better electrical isolation, thereby mitigating a current leakage risk between at least some regions of the first doped semiconductor layer and at least some regions of the second doped semiconductor layer, which is beneficial to improving the operating performance of the back contact solar cell.

In addition, at least a portion of the first dielectric layer is in contact with the first doped semiconductor layer, and at least a portion of the second dielectric layer is in contact with the second doped semiconductor layer. In addition, materials of the first dielectric layer and the second dielectric layer are different, thereby facilitating separate determination of the materials of the first dielectric layer and the second dielectric layer based on different distribution positions and different contact objects of the first dielectric layer and the second dielectric layer and according to different actual requirements, which is beneficial to improving the applicability of the back contact solar cell provided in the present application to different application scenarios.

In a possible implementation, the material of the first dielectric layer includes an oxygen element.

In a case that the foregoing technical solution is used, the dielectric layer made of the material including the oxygen element has a high dielectricity such that the electrical isolation of the first dielectric layer can be improved, thereby further mitigating a current leakage risk between at least some regions of the first doped semiconductor layer and at least some regions of the second doped semiconductor layer.

In a possible implementation, the material of the first dielectric layer includes a silicon element.

In a case that the foregoing technical solution is used, a silicon element is abundant in nature, and various types of dielectric materials such as silicon dioxide, silicon nitride, silicon oxynitride, or silicon carbonitride include a silicon element, thereby facilitating the selection of an appropriate type according to different actual requirements, which is beneficial to improving the applicability of the back contact solar cell provided in the present application to different application scenarios.

In a possible implementation, the first dielectric layer includes a tunnel oxide layer.

In a case that the foregoing technical solution is used, in addition to being an insulating dielectric layer having a large thickness, the first dielectric layer may alternatively include a tunnel oxide layer having a small thickness, thereby providing another optional solution for the structure of the first dielectric layer. In addition, a manufacturing process of the tunnel oxide layer is mature. Therefore, when the first dielectric layer includes the tunnel oxide layer, the compatibility between manufacturing processes of the back contact solar cell provided in the present application and an existing back contact solar cell can be improved, thereby reducing the manufacturing difficulty of the first dielectric layer.

In a possible implementation, the material of the first dielectric layer includes at least one of silicon dioxide, silicon oxynitride, hafnium oxide, aluminum oxide, and zinc oxide.

In a case that the foregoing technical solution is used, various optional materials are provided for the first dielectric layer, thereby facilitating the selection of an appropriate type according to different actual requirements, which is beneficial to improving the applicability of the back contact solar cell provided in the present application to different application scenarios. In addition, silicon dioxide, silicon oxynitride, hafnium oxide, aluminum oxide, and zinc oxide each have a good electrical isolation characteristic, thereby further mitigating a current leakage risk between at least some regions of the first doped semiconductor layer and at least some regions of the second doped semiconductor layer.

In a possible implementation, the second dielectric layer includes a crystalline silicon layer, and a doping type of the crystalline silicon layer includes at least one of an intrinsic type and a lightly-doped type.

In a case that the foregoing technical solution is used, the second dielectric layer may include the crystalline silicon layer, and the doping type of the crystalline silicon layer includes at least one of the intrinsic type and the lightly-doped type. The crystalline silicon material of the intrinsic type has poor conductivity. Therefore, when the doping type of the crystalline silicon layer is the intrinsic type, the second dielectric layer has good electrical isolation, thereby ensuring that a current leakage risk between at least some regions of the first doped semiconductor layer and at least some regions of the second doped semiconductor layer can be mitigated by using the structure formed by the first dielectric layer and the second dielectric layer. In an actual manufacturing procedure, when at least the second doped semiconductor layer is doped with a dopant, the dopant in the second doped semiconductor layer may enter, through diffusion or the like, a portion of the second dielectric layer that is in contact with the second doped semiconductor layer such that a doping type of the at least a portion of the second dielectric layer turns into the lightly-doped type. Based on this, when the doping type of the crystalline silicon layer includes the lightly-doped type, it is not necessary to strictly control manufacturing conditions to ensure that the conductivity type of the crystalline silicon layer is the intrinsic type, which helps reduce the manufacturing difficulty of the back contact solar cell.

In a possible implementation, in a case that the doping type of the crystalline silicon layer includes the lightly-doped type, a doping concentration of a dopant in the crystalline silicon layer is greater than or equal to 1×10¹⁵ cm⁻³ and less than or equal to 5×10²¹ cm⁻³.

In a case that the foregoing technical solution is used, it may be understood that, within a particular range, when the doping concentration of the dopant in the crystalline silicon layer is larger, the electrical conduction performance of the crystalline silicon layer is better. Based on this, in a case that the doping type of the crystalline silicon layer includes the lightly-doped type and the doping concentration of the dopant in the crystalline silicon layer is within the foregoing range, the second dielectric layer can be kept from having low dielectricity due to the doping concentration of the dopant in the crystalline silicon layer being large, and good electrical isolation between at least some regions of the first doped semiconductor layer and at least some regions of the second doped semiconductor layer can be ensured.

In a possible implementation, in a case that the doping type of the crystalline silicon layer includes the intrinsic type and the lightly-doped type, a portion of the crystalline silicon layer whose doping type is the intrinsic type and a portion of the crystalline silicon layer whose doping type is the lightly-doped type are distributed in a direction from the second dielectric layer toward the second doped semiconductor layer, and the portion of the lightly-doped type is in contact with the second doped semiconductor layer.

In a case that the foregoing technical solution is used, at least a portion of the second dielectric layer is in contact with the second doped semiconductor layer. In addition, in a case that the doping type of the crystalline silicon layer included in the second dielectric layer includes the intrinsic type and the lightly-doped type, the portion of the crystalline silicon layer whose doping type is the intrinsic type and the portion of the crystalline silicon layer whose doping type is the lightly-doped type are distributed in the direction from the second dielectric layer toward the second doped semiconductor layer, and the portion of the lightly-doped type is in contact with the second doped semiconductor layer. In the foregoing case, as described above, in an actual manufacturing procedure, when at least the second doped semiconductor layer is doped with a dopant, the dopant in the second doped semiconductor layer may enter, through diffusion or the like, a portion of the second dielectric layer that is in contact with the second doped semiconductor layer such that a doping type of the at least a portion of the second dielectric layer turns into the lightly-doped type to manufacture the foregoing crystalline silicon layer, and it is not necessary to additionally perform other doping to form the foregoing crystalline silicon layer, thereby helping simplify the manufacturing procedure and the manufacturing difficulty of the second dielectric layer.

In a possible implementation, the first dielectric layer is an amorphous dielectric layer, and the second dielectric layer includes at least one of a microcrystalline dielectric layer, a nanocrystalline dielectric layer, a polycrystalline dielectric layer, or a monocrystalline dielectric layer.

In a case that the foregoing technical solution is used, that the materials of the first dielectric layer and the second dielectric layer are different may alternatively mean that the crystalline phases of the first dielectric layer and the second dielectric layer are different, which provides a selection direction for the selection of the materials of the first dielectric layer and the second dielectric layer. In addition, various optional crystalline phases are provided for the second dielectric layer, and second dielectric layers of different crystalline phases may have different physical characteristics, thereby improving the applicability of the back contact solar cell provided in the present application to different application scenarios.

In a possible implementation, in the direction in which the first regions and the second regions are arranged, a width of a portion of the first dielectric layer that corresponds to the spacing region is greater than or equal to 1 nm and less than or equal to 3 nm.

In a case that the foregoing technical solution is used, the width of the portion of the first dielectric layer that corresponds to the spacing region is within the foregoing range such that poor dielectricity of the first dielectric layer in the direction in which the first regions and the second regions are arranged due to the width of the portion of the first dielectric layer that corresponds to the spacing region being small can be prevented, thereby ensuring that at least a portion of the first doped semiconductor layer can be electrically isolated from at least a portion of the second doped semiconductor layer by the structure formed by the first dielectric layer and the second dielectric layer. In addition, low carrier collection efficiency of the first doped semiconductor layer and/or the second doped semiconductor layer caused by a width of the spacing region located between the first doped semiconductor layer and the second doped semiconductor layer being large due to the width of the portion of the first dielectric layer that corresponds to the spacing region being large can be further prevented. Moreover, when the first dielectric layer is integrally continuous with a second passivation layer located between the second doped semiconductor layer and the semiconductor substrate, the width of the portion of the first dielectric layer that corresponds to the spacing region is within the foregoing range such that a large carrier transport resistance corresponding to the second passivation layer caused by a large thickness of the second passivation layer due to a large width can be further prevented, thereby ensuring high operating performance of the back contact solar cell.

In a possible implementation, in the direction in which the first regions and the second regions are arranged, a width of a portion of the second dielectric layer that corresponds to the spacing region is greater than or equal to 80 nm and less than or equal to 300 nm.

In a case that the foregoing technical solution is used, the width of the portion of the second dielectric layer that corresponds to the spacing region is within the foregoing range such that low carrier collection efficiency of the first doped semiconductor layer and/or the second doped semiconductor layer caused by a width of the spacing region located between the first doped semiconductor layer and the second doped semiconductor layer being large due to the width of the portion of the second dielectric layer that corresponds to the spacing region being large can be further prevented. Next, a high consumption of materials for manufacturing the second dielectric layer due to the width of the portion of the second dielectric layer that corresponds to the spacing region being large can be further prevented, which is beneficial to controlling the manufacturing costs of the back contact solar cell. In addition, when the second dielectric layer and the second doped semiconductor layer are integrally continuous, the width of the portion of the second dielectric layer that corresponds to the spacing region is within the foregoing range such that low carrier collection efficiency of the second doped semiconductor layer caused by a small thickness of the second doped semiconductor layer due to the width of the portion of the second dielectric layer that corresponds to the spacing region being small can be further prevented, thereby ensuring high operating performance of the back contact solar cell.

In a possible implementation, the first dielectric layer includes a first dielectric portion and a second dielectric portion that are integrally continuous. The first dielectric portion is located between the second dielectric layer and the first doped semiconductor layer in the direction in which the first regions and the second regions are arranged. The second dielectric portion is located between the second dielectric layer and the semiconductor substrate.

In a case that the foregoing technical solution is used, the first dielectric layer is located on a side of the second dielectric layer that is close to the first doped semiconductor layer, and is also located on a side of the second dielectric layer that is close to the semiconductor substrate. Based on this, in an actual manufacturing procedure, after the material layer that is disposed on the entire back surface and that is used for manufacturing the first dielectric layer is formed through deposition, it is not necessary to perform an additional etching operation before the second dielectric layer is formed to remove a portion of the material layer that is located between the second dielectric layer and the semiconductor substrate, which helps simplify the manufacturing procedure of the first dielectric layer.

In a possible implementation, the first dielectric layer includes the first dielectric portion and a third dielectric portion that are integrally continuous. The first dielectric portion is located between the second dielectric layer and the first doped semiconductor layer in the direction in which the first regions and the second regions are arranged. The third dielectric portion is located on a side of the first doped semiconductor layer that faces away from the semiconductor substrate, and an extended-through first conductive window is provided in the third dielectric portion.

In a case that the foregoing technical solution is used, the first dielectric layer is located between the second dielectric layer and the first doped semiconductor layer in the direction in which the first regions and the second regions are arranged, and is also located on the side of the first doped semiconductor layer that faces away from the semiconductor substrate such that a formation range of the first dielectric layer can be expanded, and a selective etching range of the material layer that is disposed on the entire back surface, that is used for manufacturing the first dielectric layer, and that is formed through deposition can be reduced in an actual manufacturing procedure, thereby helping improve the efficiency and production capacity of etching. Next, with the presence of the third dielectric portion, a surface of the side of the first doped semiconductor layer that faces away from the semiconductor substrate can be passivated, which is beneficial to reducing a quantity of defects on the side of the first doped semiconductor layer that faces away from the semiconductor substrate. In addition, the extended-through first conductive window is provided in the second dielectric portion, which is beneficial to the direct contact between the first doped semiconductor layer and a corresponding electrode to reduce the contact resistance between the first doped semiconductor layer and the corresponding electrode, thereby ensuring high operating performance of the back contact solar cell.

In a possible implementation, the second dielectric layer extends onto the third dielectric portion included in the first dielectric layer, and the first conductive window extends through a portion of the second dielectric layer that corresponds to the first region. In this case, it is beneficial to expanding a formation range of the second dielectric layer can be expanded, and a selective etching range of the material layer that is disposed on the entire back surface, that is used for manufacturing the second dielectric layer, and that is formed through deposition can be reduced in an actual manufacturing procedure, thereby helping improve the efficiency and production capacity of etching. In addition, the first conductive window extends through the portion of the second dielectric layer that corresponds to the first region, which is beneficial to the direct contact between the first doped semiconductor layer and a corresponding electrode, thereby reducing the contact resistance between the first doped semiconductor layer and the corresponding electrode.

In a possible implementation, the second doped semiconductor layer includes a first doped portion and a second doped portion that are electrically connected to each other. The first doped portion is located on the second regions. The second doped portion is located on a side of the second dielectric layer that faces away from the first dielectric layer, and a doping concentration of a dopant in the second doped portion is less than a doping concentration of a dopant in the first doped portion. In this case, it is beneficial to expanding a formation range of the second doped semiconductor layer, and a selective etching range of an intrinsic semiconductor layer that is disposed on the entire back surface, that is used for manufacturing the second doped semiconductor layer, and that is formed through deposition or another process can be reduced in an actual manufacturing procedure, thereby helping improve the etching efficiency and production capacity. In addition, the doping concentration of the dopant in the second doped portion is less than the doping concentration of the dopant in the first doped portion, to help prevent a short circuit caused by electrical conduction between the first doped semiconductor layer and the first doped portion through the second doped portion, thereby ensuring high electrical reliability of the back contact solar cell.

In a possible implementation, the second doped semiconductor layer includes a first doped portion and a second doped portion that are electrically connected to each other. The first doped portion is located on the second regions. The second doped portion is disposed in the spacing region and extends to the first region, a portion of the second doped portion that corresponds to the spacing region is located on a side of the second dielectric layer that faces away from the first dielectric layer, and a portion of the second doped portion that corresponds to the first region is located on an upper portion of the third dielectric portion that faces away from the first doped semiconductor layer. A doping concentration of a dopant in the second doped portion is less than a doping concentration of a dopant in the first doped portion.

In a case that the foregoing technical solution is used, the second doped portion can be located in the spacing region, and can also extend to the first region such that a formation range of the second doped semiconductor layer can be further increased, thereby further improving the etching efficiency and the etching production capacity of selectively etching the second doped semiconductor layer.

In a possible implementation, in a case that the second doped semiconductor layer includes a first doped portion and a second doped portion that are electrically connected to each other, the second dielectric layer extends onto the third dielectric portion included in the first dielectric layer, and the portion of the second doped portion that corresponds to the first region is located on a portion of the second dielectric layer that corresponds to the first region. The first conductive window extends through the second dielectric layer and the portion of the second doped portion that corresponds to the first region.

In a case that the foregoing technical solution is used, when the second doped portion included in the second doped semiconductor layer is located in the spacing region and also extends to the first region, the second dielectric layer also extends onto the third dielectric portion included in the first dielectric layer. In this case, both the third dielectric portion and the portion of the second dielectric layer that corresponds to the first region are provided between the second doped portion and the first doped semiconductor layer having opposite conductivity types, to ensure high electrical isolation between the portion of the second doped portion that corresponds to the first region and the first doped semiconductor layer.

In a possible implementation, in a case that the second doped semiconductor layer includes a first doped portion and a second doped portion that are electrically connected to each other, the back contact solar cell further includes a third dielectric layer located between the third dielectric portion and the first doped semiconductor layer. The first conductive window extends through the third dielectric layer. In this case, both the third dielectric portion and the third dielectric layer are provided between the second doped portion and the first doped semiconductor layer having opposite conductivity types, to ensure high electrical isolation between the portion of the second doped portion that corresponds to the first region and the first doped semiconductor layer.

In a possible implementation, a thickness of the second doped portion is greater than or equal to 40 nm and less than or equal to 150 nm.

In a case that the foregoing technical solution is used, the thickness of the second doped portion is within the foregoing range such that high precision in controlling doping conditions in a manufacturing procedure due to the thickness of the second doped portion being small can be prevented, thereby reducing the manufacturing difficulty of the second doped portion. In addition, when the second dielectric layer and the second doped semiconductor layer are integrally continuous and the thickness of the second doped portion is within the foregoing range, a low degree of mitigating a current leakage risk of at least some regions of the first doped semiconductor layer and at least some regions of the second doped semiconductor layer through the first dielectric layer and the second dielectric layer caused by a small thickness of the second dielectric layer due to the thickness of the second doped portion being large can be further prevented, thereby ensuring high operating performance of the back contact solar cell.

In a possible implementation, the doping concentration of the dopant in the second doped portion is greater than 0 and less than or equal to 1×10²⁰ cm⁻³.

In a case that the foregoing technical solution is used, the doping concentration of the dopant in the second doped portion is within the foregoing range such that a low degree of mitigating a current leakage risk of at least some regions of the first doped semiconductor layer and at least some regions of the second doped semiconductor layer through the first dielectric layer and the second dielectric layer caused by high electrical conduction performance of the second doped portion due to the doping concentration of the dopant in the second doped portion being large can be further prevented, thereby ensuring high operating performance of the back contact solar cell.

In a possible implementation, in a case that the second doped semiconductor layer includes a first doped portion and a second doped portion that are electrically connected to each other, in the direction in which the first regions and the second regions are arranged, the width of the portion of the second dielectric layer that corresponds to the spacing region is greater than or equal to 40 nm and less than or equal to 150 nm.

In a case that the foregoing technical solution is used, the width of the portion of the second dielectric layer that corresponds to the spacing region is within the foregoing range such that poor dielectricity of the second dielectric layer in the direction in which the first regions and the second regions are arranged due to the width of the portion of the second dielectric layer that corresponds to the spacing region being small can be prevented, thereby ensuring that at least a portion of the first doped semiconductor layer can be electrically isolated from at least a portion of the second doped semiconductor layer by the structure formed by the first dielectric layer and the second dielectric layer. Next, low carrier collection efficiency of the first doped semiconductor layer and/or the second doped semiconductor layer caused by a width of the spacing region located between the first doped semiconductor layer and the second doped semiconductor layer being large due to the width of the portion of the second dielectric layer that corresponds to the spacing region being large can be prevented. In addition, when the second dielectric layer and the second doped semiconductor layer are integrally continuous, the width of the portion of the second dielectric layer that corresponds to the spacing region is within the foregoing range such that low carrier collection efficiency of the second doped semiconductor layer caused by a small thickness of the second doped semiconductor layer due to the width of the portion of the second dielectric layer that corresponds to the spacing region being small can be further prevented, thereby ensuring high operating performance of the back contact solar cell.

In a possible implementation, in a case that the first dielectric layer includes the first dielectric portion and a third dielectric portion that are integrally continuous, the back contact solar cell further includes a third dielectric layer located between the third dielectric portion and the first doped semiconductor layer. The first conductive window extends through the third dielectric layer.

In a case that the foregoing technical solution is used, in an actual manufacturing procedure, after the first doped semiconductor layer is formed on the entire back surface, it is necessary to selectively etch the first doped semiconductor layer at least under a mask of a portion of the third dielectric layer that corresponds to the first region. Based on this, if the first dielectric layer includes the third dielectric portion located on the side of the first doped semiconductor layer that faces away from the semiconductor substrate, after the material used for manufacturing the second dielectric layer is selectively etched, etching may stop at the third dielectric portion without affecting the third dielectric layer located below. In this case, when the back contact solar cell includes the third dielectric layer located above the first region, it indicates that the portion of the third dielectric layer that corresponds to the first region is not removed after the first doped semiconductor layer is selectively etched such that manufacturing steps of the back contact solar cell can be reduced, thereby improving the manufacturing efficiency.

In a possible implementation, in the direction in which the first regions and the second regions are arranged, widths of portions of the third dielectric layer that are located on two sides of the first conductive window are equal. In this case, it is beneficial to making the structure of the back contact solar cell regular. In addition, the widths of the portions of the third dielectric layer that are located on two sides of the first conductive window are equal, which further helps make distances between at least two sides of a corresponding electrode formed in the first conductive window in a width direction and a film layer or an electrode having a conductivity type opposite to that of the corresponding electrode equal to each other, thereby suppressing current leakage.

In a possible implementation, in the direction in which the first regions and the second regions are arranged, a width of a portion of the third dielectric layer that is located on at least one side of the first conductive window is greater than or equal to 40 µm and less than or equal to 220 µm.

In a case that the foregoing technical solution is used, the width of the portion of the third dielectric layer that is located on the at least one side of the first conductive window is within the foregoing range such that a small distance between a side of a corresponding electrode located in the first conductive window in the width direction and the film layer or the electrode having the opposite conductivity type due to the width of the portion of the third dielectric layer that is located on the at least one side of the first conductive window being small can be prevented, thereby suppressing current leakage. A small range of the spacing region and/or the second region that is located on the back surface together with the first region caused by a large range of the third dielectric layer that corresponds to the first region due to the width of the portion of the third dielectric layer that is located on at least one side of the first conductive window being large can be further prevented, thereby ensuring that at least some regions of the first doped semiconductor layer can be electrically isolated from at least some regions of the second doped semiconductor layer by at least the first dielectric layer and the second dielectric layer that are formed on the spacing regions, ensuring that the second doped semiconductor layer formed on the second regions has a suitable formation range, and further ensuring that the second doped semiconductor layer has high carrier collection efficiency.

In a possible implementation, a material of the first doped semiconductor layer includes a silicon element, and the third dielectric layer includes a doped silicon glass layer. In this case, a diffusion process may be used to implement the doping of the first doped semiconductor layer. After the diffusion, the doped silicon glass layer may be formed on the side of the first doped semiconductor layer that faces away from the semiconductor substrate. Based on this, in a case that the material of the first doped semiconductor layer includes the silicon element and the third dielectric layer includes the doped silicon glass layer, it is not necessary to additionally add a corresponding deposition step to form the third dielectric layer, thereby simplifying the manufacturing procedure of the back contact solar cell.

In a possible implementation, the second doped semiconductor layer includes a first doped portion and a third doped portion that are electrically connected to each other. The first doped portion is located on the second regions, and the third doped portion is located on the spacing regions. A doping concentration of a dopant in the third doped portion is less than a doping concentration of a dopant in the first doped portion.

In a case that the foregoing technical solution is used, in an actual manufacturing procedure, a width of the spacing region located between the first region and the adjacent second region is large due to equipment precision and/or for preventing current leakage. Based on this, the second doped semiconductor layer includes the first doped portion located on the second regions and further includes the third doped portion located on some spacing regions. **In** this case, when the back contact solar cell is in operation, the second doped semiconductor layer can collect and extract in time electrons or holes corresponding to the second regions, and can also collect and extract in time electrons or holes corresponding to the some spacing regions. Therefore, when at least some regions of the first doped semiconductor layer is electrically isolated from at least some regions of the second doped semiconductor layer by the structure formed by the first dielectric layer and the second dielectric layer, the carrier recombination rate at the spacing regions having large widths can also be reduced, thereby further improving the photoelectric conversion efficiency of the back contact solar cell. In addition, because the third doped portion is located between the first doped portion and the first doped semiconductor layer, when a doping concentration of the dopant in the third doped portion located on some spacing regions is less than a doping concentration of the dopant in the first doped portion located on the second region, the electrical conductivity of the third doped portion can be reduced, the risk of electrical breakdown penetrating the first dielectric layer and the second dielectric layer can be reduced, and the diffusion of the dopant in the third doped portion to the second dielectric layer can be suppressed or even eliminated, thereby ensuring that the structure formed by the first dielectric layer and the second dielectric layer has good electrical isolation, and ensuring that the back contact solar cell has good electrical performance.

In a possible implementation, the doping concentration of the dopant in the third doped portion is greater than or equal to 1×10¹⁵ cm⁻³ and less than or equal to 5×10²¹ cm⁻³.

In a case that the foregoing technical solution is used, the doping concentration of the dopant in the third doped portion is within the foregoing range such that a poor carrier collection capability of the third doped portion caused by the doping concentration of the dopant in the third doped portion being small can be prevented, thereby further improving the degree of reducing the carrier recombination rate at the spacing regions by using the third doped portion. In addition, easy diffusion of carriers in the third doped portion into an intrinsic semiconductor layer caused by the doping concentration of the dopant in the third doped portion being large can be further prevented, thereby ensuring that the intrinsic semiconductor layer has good electrical isolation.

In a possible implementation, in a direction from the second region to the first region, the doping concentration of the dopant in the third doped portion gradually decreases. In this case, while the dopant in the third doped portion has a particular doping concentration such that the third doped portion has a particular lateral carrier collection capability, a portion having the lowest doping concentration of the dopant in the third doped portion may further be in contact with the second dielectric layer such that a carrier concentration gradient at a position where the portion is in contact with the second dielectric layer is reduced, and the diffusion of the dopant in the third doped portion into the second dielectric layer is further suppressed or even eliminated, thereby ensuring that the structure formed by the first dielectric layer and the second dielectric layer has good electrical isolation.

In a possible implementation, in the direction in which the first regions and the second regions are arranged, a width ratio of the third doped portion to the first doped portion is greater than or equal to 1:20000 and less than or equal to 2:700.

In a case that the foregoing technical solution is used, when the width ratio of the third doped portion to the first doped portion is within the foregoing range, the width of the first doped portion is far greater than the width of the third doped portion such that a poor carrier collection capability of the first doped portion caused by the width of the first doped portion being small can be prevented, and the small widths of the spacing region and the first region that are located on the back surface together with the second region caused by the width of the first doped portion being large can be further prevented, thereby ensuring that at least some regions of the first doped semiconductor layer can be electrically isolated from at least some regions of the second doped semiconductor layer by at least the first dielectric layer and the second dielectric layer that are formed on the spacing regions, ensuring that the first doped semiconductor layer formed on the first regions has a suitable formation range, and further ensuring that the first doped semiconductor layer has high carrier collection efficiency.

In a possible implementation, the back contact solar cell further includes a first electrode and a second electrode. The first electrode is formed on the first doped semiconductor layer, and is in ohmic contact with the first doped semiconductor layer. The second electrode is formed on the first doped portion, and is in ohmic contact with the first doped portion. In the direction in which the first regions and the second regions are arranged, a spacing between a geometric center of a portion of the second electrode that is adjacent to the third doped portion and the third doped portion is greater than or equal to 110 µm and less than or equal to 380 µm.

In a case that the foregoing technical solution is used, the second electrode is formed on the first doped portion, and is in ohmic contact with the first doped portion. In this case, the spacing between the geometric center of the portion of the second electrode that is adjacent to the third doped portion included in the second doped semiconductor layer and the third doped portion affects the width of the first doped portion in the direction in which the first regions and the second regions are arranged, and further affects the carrier collection efficiency of the first doped portion. Based on this, if the spacing between the geometric center of the portion of the second electrode that is adjacent to the third doped portion and the third doped portion is within the foregoing range, low carrier collection efficiency of the first doped portion caused by the spacing between the geometric center of the portion of the second electrode that is adjacent to the third doped portion and the third doped portion being small can be prevented. In addition, a width of the spacing region and/or the first region that is located on the back surface together with the second region caused by the width of the first doped portion being large due to the large spacing can be further prevented. For the beneficial effects of preventing the small widths of the spacing region and/or the first region, reference may be made to the foregoing descriptions. Details are not described herein again.

In a possible implementation, a groove structure is provided on the back surface of the semiconductor substrate. Both the second regions and the spacing regions are located in the groove structure.

In a case that the foregoing technical solution is used, both the second region and the spacing region are located in the groove structure such that both the surface of the second region and the surface of the spacing region can be staggered with respect to the surface of the first region in a thickness direction of the semiconductor substrate, which helps make the first doped semiconductor layer and the second doped semiconductor layer that are located together on the back surface and that have opposite conductivity types at least partially staggered in the thickness direction of the semiconductor substrate, to further mitigate a current leakage risk on the back surface, thereby improving the operating performance of the back contact solar cell.

In a possible implementation, a portion of a bottom surface of the groove structure that corresponds to the spacing region is flush with a portion of the bottom surface of the groove structure that corresponds to the second region.

In a case that the foregoing technical solution is used, in an actual manufacturing procedure, after the first doped semiconductor layer is formed on the entire back surface and the first doped semiconductor layer is selectively etched, portions of the semiconductor substrate that correspond to the spacing regions and the second regions may be simultaneously etched to form the groove structure. In this case, the portions of the groove structure have the same depth. Based on this, when the portion of the bottom surface of the groove structure that corresponds to the spacing region is flush with the portion of the bottom surface of the groove structure that corresponds to the second region, the depth of the portion of the groove structure that corresponds to the spacing region is the same as the depth of the portion of the groove structure that corresponds to the second region. In this case, it is not necessary to selectively etch the spacing region or the second region after the first doped semiconductor layer is selectively etched such that while the manufacturing procedure of the back contact solar cell is simplified, the thickness of the selected material of the semiconductor substrate can be further reduced, thereby facilitating the implementation of thin-film production.

In a possible implementation, in a direction from a light-receiving surface to the back surface of the semiconductor substrate, a portion of a bottom surface of the groove structure that corresponds to the spacing region is lower than a portion of the bottom surface of the groove structure that corresponds to the second region. **In** this case, a difference between the depths of the groove structure that correspond to the first doped semiconductor layer and the second doped semiconductor layer is larger. However, at least a portion of the first dielectric layer and at least a portion of the second dielectric layer are formed on the spacing region, and the structure formed by the first dielectric layer and the second dielectric layer has electrical isolation. Therefore, in this case, a current leakage risk between the first doped semiconductor layer and the second doped semiconductor layer can be further mitigated.

**In** a possible implementation, a depth of the groove structure is greater than or equal to 0.3 µm and less than or equal to 3 µm.

In a case that the foregoing technical solution is used, the depth of the groove structure is within the foregoing range such that a small degree to which the first doped semiconductor layer and the second doped semiconductor layer that are located together on the back surface of the silicon substrate and that have opposite conductivity types are staggered in a thickness direction of the semiconductor substrate caused by the depth of the groove structure being small can be prevented, thereby further mitigating a current leakage risk on the back surface. In addition, a requirement for use of a semiconductor substrate with a large thickness due to the depth of the groove structure being large can be further prevented, thereby helping implement the thin-film production of the back contact solar cell while reducing the manufacturing costs of the back contact solar cell.

In a possible implementation, the back contact solar cell further includes a first passivation layer located between the first doped semiconductor layer and the semiconductor substrate.

In a case that the foregoing technical solution is used, the first passivation layer and the first doped semiconductor layer may form a selective contact structure to implement chemical passivation on a corresponding region on the back surface of the semiconductor substrate and selectively collect carriers of a corresponding conductivity type, thereby reducing a carrier recombination rate on the back surface and helping improve the photoelectric conversion efficiency of the back contact solar cell.

In a possible implementation, the back contact solar cell further includes a second passivation layer located between the second doped semiconductor layer and the semiconductor substrate.

In a case that the foregoing technical solution is used, the second passivation layer and the second doped semiconductor layer may form a selective contact structure to implement chemical passivation on a corresponding region on the back surface of the semiconductor substrate and selectively collect carriers of a corresponding conductivity type, thereby reducing a carrier recombination rate on the back surface and helping improve the photoelectric conversion efficiency of the back contact solar cell.

In a possible implementation, in a case that the back contact solar cell further includes the second passivation layer, the first dielectric layer and the second passivation layer are integrally continuous; and/or, a porosity of the first dielectric layer is less than that of the second passivation layer.

In a case that the foregoing technical solution is used, when the first dielectric layer and the second passivation layer are integrally continuous, the first dielectric layer and the second passivation layer may be simultaneously formed based on a same material in a same manufacturing step, thereby reducing the manufacturing costs of the back contact solar cell while simplifying the manufacturing procedure of the back contact solar cell and improving the manufacturing efficiency of the back contact solar cell. In addition, compared with other dielectric materials, air has a lower dielectric constant. Based on this, when the porosity of the first dielectric layer is less than the porosity of the second passivation layer, it is beneficial to make the dielectric constant of the first dielectric layer greater than the dielectric constant of the second passivation layer, thereby helping improve the dielectricity of the first dielectric layer, and ensuring that at least some regions of the first doped semiconductor layer can be electrically isolated from at least some regions of the second doped semiconductor layer by the structure formed by the first dielectric layer and the second dielectric layer. Next, high transport resistance in the second passivation layer can be further prevented, thereby further improving the operating performance of the back contact solar cell.

In a possible implementation, the second dielectric layer and the second doped semiconductor layer are integrally continuous. For the beneficial effects in this case, reference may be made to the foregoing analysis of the beneficial effects of the first dielectric layer and the second passivation layer being integrally continuous. Details are not described herein again.

In a possible implementation, the back contact solar cell further includes a surface passivation layer. The surface passivation layer covers the second doped semiconductor layer, and extends above the first doped semiconductor layer in the direction in which the first regions and the second regions are arranged. An extended-through first conductive window is provided in a portion of the surface passivation layer that corresponds to the first region, and at least a portion of the first doped semiconductor layer is exposed at a bottom of the first conductive window. An extended-through second conductive window is provided in a portion of the surface passivation layer that corresponds to the second region, and at least a portion of the second doped semiconductor layer is exposed at a bottom of the second conductive window.

In a possible implementation, the back contact solar cell further includes a first electrode and a second electrode. The first electrode is formed on the first doped semiconductor layer, and is in ohmic contact with the first doped semiconductor layer. The second electrode is formed on the second doped semiconductor layer, and is in ohmic contact with the second doped semiconductor layer. Each of the first electrode and the second electrode includes a plurality of fingers and a plurality of busbars. Both the fingers included in the first electrode and the fingers included in the second electrode extend in a first direction and are alternately distributed at intervals in a second direction. The first direction is different from the second direction. Both the busbars included in the first electrode and the busbars included in the second electrode extend in the second direction and are alternately distributed at intervals in the first direction. Each of the busbars is electrically connected to fingers having a same polarity as that of the busbar, and is insulated from fingers having a polarity opposite to that of the busbar. In the foregoing case, a width, in a width direction of the spacing region, of a portion of the structure formed by the first dielectric layer and the second dielectric layer that is between two adjacent fingers having opposite polarities is approximately the same as a thickness of the second doped semiconductor layer; and/or, a length, in an extension direction of the spacing region, of a portion of the structure formed by the first dielectric layer and the second dielectric layer that is between two adjacent fingers having opposite polarities is greater than or equal to 300 µm and less than or equal to 3000 µm; and/or, a width, in a width direction of the spacing region, of a portion of the structure formed by the first dielectric layer and the second dielectric layer that is between a finger and a busbar that have opposite polarities and that are adjacent to each other is approximately the same as a thickness of the second doped semiconductor layer; and/or, a length, in an extension direction of the spacing region, of a portion of the structure formed by the first dielectric layer and the second dielectric layer that is between a finger and a busbar that have opposite polarities and that are adjacent to each other is greater than or equal to 200 µm and less than or equal to 700 µm; and/or, a spacing between two adjacent fingers having opposite polarities is greater than or equal to 200 µm and less than or equal to 700 µm; and/or, a width of each of the fingers is greater than or equal to 15 µm and less than or equal to 60 µm.

In a case that the foregoing technical solution is used, the second doped semiconductor layer has particular carrier collection efficiency, and needs to have a corresponding thickness. Based on this, when the width, in the width direction of the spacing region, of the part of the structure formed by the first dielectric layer and the second dielectric layer that is between two adjacent fingers having opposite polarities is approximately the same as the thickness of the second doped semiconductor layer, the poor electrical isolation of the structure formed by the first dielectric layer and the second dielectric layer caused by the width of the structure being small can be prevented. Next, the first dielectric layer or the second dielectric layer may be formed based on the same manufacturing process and manufacturing materials during the manufacturing of the second doped semiconductor layer, thereby simplifying the manufacturing procedure of the back contact solar cell. The beneficial effects of the width, in the width direction of the spacing region, of the portion of the structure formed by the first dielectric layer and the second dielectric layer that is between the finger and the busbar that have opposite polarities and that are adjacent to each other being approximately the same as the thickness of the second doped semiconductor layer is similar to the beneficial effects of the width, in the width direction of the spacing region, of the part of the structure formed by the first dielectric layer and the second dielectric layer that is between two adjacent fingers having opposite polarities being approximately the same as the thickness of the second doped semiconductor layer. Details are not described herein again.

In addition, when the length, in the extension direction of the spacing region, of the portion of the structure formed by the first dielectric layer and the second dielectric layer that is between two adjacent fingers having opposite polarities is greater than or equal to 300 µm and less than or equal to 3000 µm, the small region in which the first doped semiconductor layer is electrically isolated from the second doped semiconductor layer by the structure formed by the first dielectric layer and the second dielectric layer caused by the length being small can be prevented, thereby ensuring a low leakage current in the back contact solar cell during normal operation. For the beneficial effects of the length, in the extension direction of the spacing region, of the portion of the structure formed by the first dielectric layer and the second dielectric layer that is between the finger and the busbar that have opposite polarities and that are adjacent to each other being greater than or equal to 200 µm and less than or equal to 700 µm, reference may be made to the analysis of the beneficial effects of the length, in the extension direction of the spacing region, of the portion of the structure formed by the first dielectric layer and the second dielectric layer that is between two adjacent fingers having opposite polarities being greater than or equal to 300 µm and less than or equal to 3000 µm.

In addition, when the spacing between two adjacent fingers having opposite polarities is greater than or equal to 200 µm and less than or equal to 700 µm, a small mitigation degree of a current leakage risk of two adjacent fingers having opposite polarities caused by the spacing being small can be prevented. A high carrier recombination rate of a portion of the back contact solar cell that corresponds to the spacing region caused by a width of the spacing region being large due to the spacing between two adjacent fingers having opposite polarities being large can be further prevented, thereby ensuring high operating performance of the back contact solar cell.

Moreover, when the width of each of the fingers is greater than or equal to 15 µm and less than or equal to 60 µm, a large contact resistance between the finger and the corresponding doped semiconductor layer caused by the width of the finger being small can be prevented, thereby improving the contact performance between the finger and the corresponding doped semiconductor layer. In addition, high metal composite content corresponding to the finger caused by a large width of the finger can be further prevented, to reduce a metal composite loss, thereby achieving a balance between the contact performance corresponding to the finger and the metal composite loss.

In a possible implementation, corresponding portions of the first dielectric layer and the second dielectric layer that are between the first doped semiconductor layer and the second doped semiconductor layer are located on all regions of the spacing region in an extension direction of the spacing region, and are configured for electrically isolating the first doped semiconductor layer from the second doped semiconductor layer. Alternatively, corresponding portions of the first dielectric layer and the second dielectric layer that are between the first doped semiconductor layer and the second doped semiconductor layer have a discontinuity in an extension direction of the spacing region. The back contact solar cell further includes a conductive structure located at least within the discontinuity. A conductivity type of the conductive structure is opposite to that of one of the first doped semiconductor layer and the second doped semiconductor layer, and only some regions of the first doped semiconductor layer and only some regions of the second doped semiconductor layer are respectively electrically connected to the conductive structure.

In a case that the foregoing technical solution is used, when the corresponding portions of the first dielectric layer and the second dielectric layer that are between the first doped semiconductor layer and the second doped semiconductor layer are located on all regions of the spacing region in the extension direction of the spacing region, some regions of the first doped semiconductor layer can be electrically isolated from the second doped semiconductor layer by the structure formed by the first dielectric layer and the second dielectric layer, thereby minimizing a current leakage risk between the first doped semiconductor layer and the second doped semiconductor layer. In a case that the corresponding portions of the first dielectric layer and the second dielectric layer that are between the first doped semiconductor layer and the second doped semiconductor layer have a discontinuity in the extension direction of the spacing region and the back contact solar cell further includes a conductive structure located at least within the discontinuity, the first doped semiconductor layer and the second doped semiconductor layer may be electrically connected by manufacturing a partial leakage site to form a built-in diode having a low reverse breakdown voltage, thereby helping provide the back contact solar cell with a low reverse breakdown voltage when being shaded. Next, only some regions of the first doped semiconductor layer and only some regions of the second doped semiconductor layer are respectively electrically connected to the conductive structure, in other words, some regions of the first doped semiconductor layer and corresponding some regions of the second doped semiconductor layer are respectively electrically connected to the at least one conductive structure, and the remaining regions of the first doped semiconductor layer are still electrically isolated from corresponding regions of the second doped semiconductor layer by the structure formed by the first dielectric layer and the second dielectric layer. Low working efficiency of the back contact solar cell caused by a large leakage current during normal operation of the back contact solar cell due to conductive structures disposed in all the regions of the first doped semiconductor layer and the second doped semiconductor layer can be prevented, thereby ensuring that a photovoltaic module including the back contact solar cell provided in the present application has high photoelectric conversion efficiency in a forward voltage region.

In a possible implementation, in a case that the back contact solar cell further includes the conductive structure, at least a portion of the conductive structure is integrally continuous with the second doped semiconductor layer. The beneficial effects in this case are similar to the beneficial effects of the first dielectric layer and the second passivation layer being integrally continuous. Details are not described herein again.

In a possible implementation, in a case that the back contact solar cell further includes the conductive structure, the structure formed by the first dielectric layer and the second dielectric layer is integrally continuous with the conductive structure. The beneficial effects in this case are similar to the beneficial effects of the first dielectric layer and the second passivation layer being integrally continuous. Details are not described herein again.

In a possible implementation, a non-pyramid structure is formed on a surface of the first region, and a one-dimensional size of a base of the non-pyramid structure on the surface of the first region is greater than or equal to 0.5 µm and less than or equal to 20 µm. The base of the non-pyramid structure is closer to the semiconductor substrate than a top of the non-pyramid structure.

In a case that the foregoing technical solution is used, a non-pyramid textured surface has a light trapping function. Therefore, when the non-pyramid structure is formed on the surface of the first region, more light is transmitted from the back surface through the surface of the first region to the semiconductor substrate and is used by the semiconductor substrate. In addition, when the non-pyramid structure is formed on the surface of the first region, the surface of the first region has a concave-convex topographic feature. Based on this, the first doped semiconductor layer is formed on the first regions. In this case, it is beneficial to also providing a side of the first doped semiconductor layer that faces away from the first regions with the corresponding fluctuating features, which is beneficial to increasing a contact area between the first doped semiconductor layer and a corresponding electrode, increasing the connection strength between the first doped semiconductor layer and the corresponding electrode, and reducing the contact resistance between the first doped semiconductor layer and the corresponding electrode. Moreover, the one-dimensional size of the base of the non-pyramid structure on the surface of the first region is within the foregoing range such that a poor light trapping effect of the first region and a small contact area between the first doped semiconductor layer and the corresponding electrode that are caused by small fluctuations on the surface of the first region due to the one-dimensional size being small can be prevented. Next, a large thinning amount of the semiconductor substrate during the formation of the non-pyramid structure provided on the surface of the first region caused by the one-dimensional size being large can be further prevented, thereby helping implement the thin-film production of the back contact solar cell.

In a possible implementation, a non-pyramid structure is formed on a surface of the second region, and a one-dimensional size of a base of the non-pyramid structure on the surface of the second region is greater than or equal to 10 µm and less than or equal to 50 µm. The base of the non-pyramid structure is closer to the semiconductor substrate than a top of the non-pyramid structure. The beneficial effects in this case are similar to the beneficial effects of the non-pyramid structure being formed on the surface of the first region, and the one-dimensional size of the base of the non-pyramid structure on the surface of the first region being greater than or equal to 0.5 µm and less than or equal to 20 µm. Details are not described herein again.

In a possible implementation, a non-pyramid structure is formed on a surface of the spacing region, and a one-dimensional size of a base of the non-pyramid structure on the surface of the spacing region is greater than or equal to 10 µm and less than or equal to 50 µm. The base of the non-pyramid structure is closer to the semiconductor substrate than a top of the non-pyramid structure.

In a case that the foregoing technical solution is used, a non-pyramid textured surface has a light trapping function. Therefore, when the non-pyramid structure is formed on the surface of the spacing region, more light is transmitted from the back surface through the surface of the spacing region to the semiconductor substrate and is used by the semiconductor substrate. In addition, the one-dimensional size of the base of the non-pyramid structure on the surface of the spacing region is within the foregoing range such that a poor light trapping effect of the spacing region caused by small fluctuations on the surface of the spacing region due to the one-dimensional size being small can be prevented. Next, a large thinning amount of the semiconductor substrate during the formation of the non-pyramid structure provided on the surface of the spacing region caused by the one-dimensional size being large can be further prevented, thereby helping implement the thin-film production of the back contact solar cell.

According to a second aspect, the present application provides a method for manufacturing a back contact solar cell. The method for manufacturing a back contact solar cell includes the following steps: first, providing a semiconductor substrate, where first regions and second regions that are alternately distributed at intervals and a spacing region that is located between each of the first regions and a second region adjacent to the first region are provided on a back surface of the semiconductor substrate; next, forming a first doped semiconductor layer on the first regions provided on the back surface; next, forming a second doped semiconductor layer at least on the second regions provided on the back surface, where a conductivity type of the second doped semiconductor layer is opposite to that of the first doped semiconductor layer; and next, forming a first dielectric layer and a second dielectric layer at least on the spacing regions provided on the back surface, where at least a portion of the first dielectric layer and at least a portion of the second dielectric layer are stacked between the first doped semiconductor layer and the second doped semiconductor layer in a direction in which the first regions and the second regions are arranged, at least a portion of the first dielectric layer is in contact with the first doped semiconductor layer, at least a portion of the second dielectric layer is in contact with the second doped semiconductor layer, and a material of the first dielectric layer is different from that of the second dielectric layer.

In a possible implementation, the forming a first doped semiconductor layer on the first regions provided on the back surface includes: forming the first doped semiconductor layer on the entire back surface and a third dielectric layer that is located on a portion of the first doped semiconductor layer that corresponds to the first region; or form the first doped semiconductor layer and a third dielectric layer on the entire back surface, performing heat treatment on portions of the third dielectric layer that correspond to the second region and the spacing region by a laser irradiation process, and forming a mask on a portion of the third dielectric layer that corresponds to the first region after the heat treatment; and next, under a mask of the portion of the third dielectric layer that corresponds to the first region, removing portions of the first doped semiconductor layer that correspond to the second region and the spacing region.

In a possible implementation, after the providing a semiconductor substrate, and before the forming a second doped semiconductor layer at least on the second regions provided on the back surface, the method for manufacturing a back contact solar cell includes: forming, on the first regions, a first passivation layer and the first doped semiconductor layer on a side of the first passivation layer that faces away from the semiconductor substrate.

In a possible implementation, after the forming a first doped semiconductor layer on the first regions provided on the back surface, and before the forming a second doped semiconductor layer at least on the second regions provided on the back surface, the method for manufacturing a back contact solar cell further includes: forming a second passivation layer at least on the second regions provided on the back surface.

In a possible implementation, the forming a second doped semiconductor layer, a second passivation layer, a first dielectric layer, and a second dielectric layer includes: sequentially forming, in a thickness direction of the semiconductor substrate, a passivation material layer and an intrinsic semiconductor layer that are stacked over the first doped semiconductor layer, the spacing regions, and the second regions; and next, selectively doping a portion of the intrinsic semiconductor layer that corresponds to the second region, where after the selective doping, the second doped semiconductor layer is formed in the portion of the intrinsic semiconductor layer that corresponds to at least the second region, the second dielectric layer is formed in portions of the intrinsic semiconductor layer that correspond to at least some spacing regions, the second passivation layer is formed in a portion of the passivation material layer that is located between the second doped semiconductor layer and the semiconductor substrate, and the first dielectric layer is formed in a portion of the passivation material layer that corresponds to at least some spacing regions.

In a possible implementation, after the selectively doping a portion of the intrinsic semiconductor layer that corresponds to the second region, the method for manufacturing a back contact solar cell includes: reserving a portion of the passivation material layer that corresponds to the first region and a portion of the intrinsic semiconductor layer that corresponds to the first region; and next, forming, above the first regions, a first conductive window extending through the third dielectric layer, the passivation material layer, and the intrinsic semiconductor layer.

In a possible implementation, after the selectively doping a portion of the intrinsic semiconductor layer that corresponds to the second region, the method for manufacturing a back contact solar cell includes: selectively removing a portion of the intrinsic semiconductor layer that corresponds to the first region, and reserving a portion of the passivation material layer that corresponds to the first region; and next, forming, above the first regions, a first conductive window extending through the third dielectric layer and the passivation material layer.

In a possible implementation, after the sequentially forming, in a thickness direction of the semiconductor substrate, a passivation material layer and an intrinsic semiconductor layer that are stacked over the first doped semiconductor layer, the spacing regions, and the second regions, and before the selectively doping a portion of the intrinsic semiconductor layer that corresponds to the second region, the method for manufacturing a back contact solar cell further includes: lightly doping a side of the intrinsic semiconductor layer that faces away from the semiconductor substrate.

In a possible implementation, after the selectively doping a portion of the intrinsic semiconductor layer that corresponds to the second region, the method for manufacturing a back contact solar cell includes: reserving a portion of the passivation material layer that corresponds to the first region and a portion of the intrinsic semiconductor layer that corresponds to the first region after the light doping; and next, forming, above the first regions, a first conductive window extending through the third dielectric layer, the passivation material layer, and the intrinsic semiconductor layer after the light doping.

In a possible implementation, after the selectively doping a portion of the intrinsic semiconductor layer that corresponds to the second region, the method for manufacturing a back contact solar cell further includes: selectively removing portions of the intrinsic semiconductor layer and the passivation material layer that correspond to the first region; and next, removing the portion of the third dielectric layer that corresponds to the first region.

In a possible implementation, after the forming a first doped semiconductor layer on the first regions provided on the back surface, and before the forming a second doped semiconductor layer at least on the second regions provided on the back surface, the method for manufacturing a back contact solar cell further includes: selectively etching the back surface of the semiconductor substrate to form a groove structure on the back surface, where both the second regions and the spacing regions are located in the groove structure.

In a possible implementation, after the forming a first dielectric layer and a second dielectric layer at least on the spacing regions provided on the back surface, the method for manufacturing a back contact solar cell further includes: forming a surface passivation layer on the back surface, where the surface passivation layer covers the second doped semiconductor layer, and extends above the first doped semiconductor layer in the direction in which the first regions and the second regions are arranged; and next, opening an extended-through first conductive window in a portion of the surface passivation layer that corresponds to the first region, and opening an extended-through second conductive window in a portion of the surface passivation layer that corresponds to the second region, where at least a portion of the first doped semiconductor layer is exposed at a bottom of the first conductive window, and at least a portion of the second doped semiconductor layer is exposed at a bottom of the second conductive window.

For beneficial effects of the second aspect and various implementations of the second aspect in the present application, reference may be made to the analysis of the beneficial effects of the first aspect and various implementations of the first aspect. Details are not described herein.

### BRIEF DESCRIPTION OF THE DRAWINGS

The accompanying drawings described herein are used to provide a further understanding of the present application, and form portion of the present application. Exemplary embodiments of the present application and descriptions thereof are used to explain the present application, and do not constitute any inappropriate limitation to the present application. In the accompanying drawings:
FIG. 1 is a schematic longitudinal cross-sectional view 1 of a structure of a back contact solar cell according to an embodiment of the present application;
FIG. 2 is a schematic longitudinal cross-sectional view 2 of a structure of a back contact solar cell according to an embodiment of the present application;
FIG. 3 is a schematic longitudinal cross-sectional view 3 of a structure of a back contact solar cell according to an embodiment of the present application;
FIG. 4 is a schematic longitudinal cross-sectional view 4 of a structure of a back contact solar cell according to an embodiment of the present application;
FIG. 5 is a schematic longitudinal cross-sectional view 5 of a structure of a back contact solar cell according to an embodiment of the present application;
FIG. 6 is a schematic longitudinal cross-sectional view 6 of a structure of a back contact solar cell according to an embodiment of the present application;
FIG. 7 is a schematic longitudinal cross-sectional view 7 of a structure of a back contact solar cell according to an embodiment of the present application;
FIG. 8 is a schematic longitudinal cross-sectional view 8 of a structure of a back contact solar cell according to an embodiment of the present application;
FIG. 9 is a schematic longitudinal cross-sectional view 9 of a structure of a back contact solar cell according to an embodiment of the present application;
FIG. 10 is a schematic longitudinal cross-sectional view 10 of a structure of a back contact solar cell according to an embodiment of the present application;
FIG. 11 is a schematic longitudinal cross-sectional view 11 of a structure of a back contact solar cell according to an embodiment of the present application;
FIG. 12 is a schematic longitudinal cross-sectional view 1 of a structure of a back contact solar cell in a manufacturing procedure according to an embodiment of the present application;
FIG. 13 is a schematic longitudinal cross-sectional view 2 of a structure of a back contact solar cell in a manufacturing procedure according to an embodiment of the present application;
FIG. 14 is a schematic longitudinal cross-sectional view 3 of a structure of a back contact solar cell in a manufacturing procedure according to an embodiment of the present application;
FIG. 15 is a schematic longitudinal cross-sectional view 4 of a structure of a back contact solar cell in a manufacturing procedure according to an embodiment of the present application;
FIG. 16 is a schematic longitudinal cross-sectional view 5 of a structure of a back contact solar cell in a manufacturing procedure according to an embodiment of the present application;
FIG. 17 is a schematic longitudinal cross-sectional view 6 of a structure of a back contact solar cell in a manufacturing procedure according to an embodiment of the present application;
FIG. 18 is a schematic longitudinal cross-sectional view 7 of a structure of a back contact solar cell in a manufacturing procedure according to an embodiment of the present application;
FIG. 19 is a schematic longitudinal cross-sectional view 8 of a structure of a back contact solar cell in a manufacturing procedure according to an embodiment of the present application;
FIG. 20 is a schematic longitudinal cross-sectional view 9 of a structure of a back contact solar cell in a manufacturing procedure according to an embodiment of the present application;
FIG. 21 is a schematic longitudinal cross-sectional view 10 of a structure of a back contact solar cell in a manufacturing procedure according to an embodiment of the present application;
FIG. 22 is a schematic longitudinal cross-sectional view 11 of a structure of a back contact solar cell in a manufacturing procedure according to an embodiment of the present application;
FIG. 23 is a schematic longitudinal cross-sectional view 12 of a structure of a back contact solar cell in a manufacturing procedure according to an embodiment of the present application;
FIG. 24 is a schematic longitudinal cross-sectional view 13 of a structure of a back contact solar cell in a manufacturing procedure according to an embodiment of the present application;
FIG. 25 is a schematic longitudinal cross-sectional view 14 of a structure of a back contact solar cell in a manufacturing procedure according to an embodiment of the present application;
FIG. 26 is a schematic longitudinal cross-sectional view 15 of a structure of a back contact solar cell in a manufacturing procedure according to an embodiment of the present application;
FIG. 27 is a schematic longitudinal cross-sectional view 16 of a structure of a back contact solar cell in a manufacturing procedure according to an embodiment of the present application;
FIG. 28 is a schematic longitudinal cross-sectional view 17 of a structure of a back contact solar cell in a manufacturing procedure according to an embodiment of the present application;
FIG. 29 is a schematic longitudinal cross-sectional view 18 of a structure of a back contact solar cell in a manufacturing procedure according to an embodiment of the present application;
FIG. 30 is a schematic longitudinal cross-sectional view 19 of a structure of a back contact solar cell in a manufacturing procedure according to an embodiment of the present application;
FIG. 31 is a schematic longitudinal cross-sectional view 20 of a structure of a back contact solar cell in a manufacturing procedure according to an embodiment of the present application;
FIG. 32 is a schematic longitudinal cross-sectional view 21 of a structure of a back contact solar cell in a manufacturing procedure according to an embodiment of the present application;
FIG. 33 is a schematic longitudinal cross-sectional view 22 of a structure of a back contact solar cell in a manufacturing procedure according to an embodiment of the present application;
FIG. 34 is a schematic longitudinal cross-sectional view 23 of a structure of a back contact solar cell in a manufacturing procedure according to an embodiment of the present application;
FIG. 35 is a schematic longitudinal cross-sectional view 24 of a structure of a back contact solar cell in a manufacturing procedure according to an embodiment of the present application; and
FIG. 36 is a schematic longitudinal cross-sectional view 25 of a structure of a back contact solar cell in a manufacturing procedure according to an embodiment of the present application.

11-semiconductor substrate, 12-first region, 13-second region, 14-spacing region, 15-first doped semiconductor layer, 16-second doped semiconductor layer, 17-first dielectric layer, 18-second dielectric layer, 19-first dielectric portion, 20-second dielectric portion, 21-third dielectric portion, 22-first conductive window, 23-first doped portion, 24-second doped portion, 25-third dielectric layer, 26-third doped portion, 27-first electrode, 28-second electrode, 29-first passivation layer, 30-second passivation layer, 31-surface passivation layer, 32-second conductive window, 33-conductive structure, 34-passivation material layer, and 35-intrinsic semiconductor layer.

### DETAILED DESCRIPTION

The embodiments of the present disclosure are described below in detail with reference to the accompanying drawings. However, it should be understood that, these descriptions are merely exemplary, and are not intended to limit the scope of the present disclosure. In addition, in the following descriptions, descriptions of well-known structures and technologies are omitted, to avoid unnecessarily confusing the concepts of the present disclosure.

The accompanying drawings show various schematic structural diagrams according to the embodiments of the present disclosure. The accompanying drawings are not drawn to scale, some details are enlarged for the purpose of clarity, and some details may be omitted. Shapes of various regions and layers shown in the drawings and relative dimensions and positional relationships between the various regions and layers are merely exemplary, and may deviate in practice due to manufacturing tolerances or technical limitations, and a person skilled in the art may additionally design regions/layers with different shapes, dimensions, and relative positions according to actual requirements.

In the context of the present disclosure, when one layer/element is referred to as being located "on" another layer/element, the layer/element may be directly located on the another layer/element, or an intermediate layer/element may exist between the layer/element and the another layer/element. In addition, if one layer/element is located "above" another layer/element in an orientation, when the orientation is inverted, the layer/element may be located "below" the another layer/element. To make the technical problems to be resolved in the present application, the technical solutions, and beneficial effects more comprehensible, the following further describes the present application in detail with reference to the accompanying drawings and embodiments. It should be understood that the specific embodiments described herein are merely used to explain the present application but are not intended to limit the present application.

In addition, terms "first" and "second" are used merely for the purpose of description, and shall not be construed as indicating or implying relative importance or implying a quantity of indicated technical features. Therefore, a feature limited by "first" or "second" may explicitly or implicitly include one or more of the features. In the descriptions of the present application, "a plurality of" means two or more, unless otherwise definitely and specifically limited. Unless otherwise explicitly and specifically limited, "several" means one or more than one.

In the descriptions of the present application, it should be noted that, unless otherwise explicitly specified or limited, the terms such as "install", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediate medium, internal communication between two components, or an interaction relationship between two components. A person of ordinary skill in the art may understand the specific meanings of the foregoing terms in the present application according to specific situations.

At present, solar cells are increasingly widely used as a new energy alternative solution. A photovoltaic solar cell is an apparatus converting sun's light energy into electric energy. Specifically, the solar cell generates carriers by using the photovoltaic principle, and leads the carriers out by using electrodes, thereby facilitating the effective use of the electric energy.

When both a positive electrode and a negative electrode included in the solar cell are located on a back surface of the solar cell, the solar cell is a back contact solar cell. The most significant feature of the back contact solar cell is that a front surface is not blocked by any metal electrode such that a short-circuit current Isc higher, making the back contact solar cell one of existing technical directions for realizing efficient crystalline silicon solar cells.

Specifically, the back contact solar cell usually includes a semiconductor substrate, a first doped semiconductor layer, and a second doped semiconductor layer. In a direction parallel to a surface of the semiconductor substrate, the first doped semiconductor layer and the second doped semiconductor layer are alternately formed on a same side of the semiconductor substrate. In addition, a conductivity type of the second doped semiconductor layer is opposite to that of the first doped semiconductor layer. In a direction in which the first doped semiconductor layer and the second doped semiconductor layer are arranged, the first doped semiconductor layer is isolated from the second doped semiconductor layer by a single dielectric layer (for example, a surface passivation layer) having poor insulation. As a result, in an existing back contact solar cell, a current leakage risk between a first doped semiconductor layer and a second doped semiconductor layer that have opposite conductivity types and that are alternately distributed at an interval on a back surface is high, which is not beneficial to improving the operating performance of the back contact solar cell.

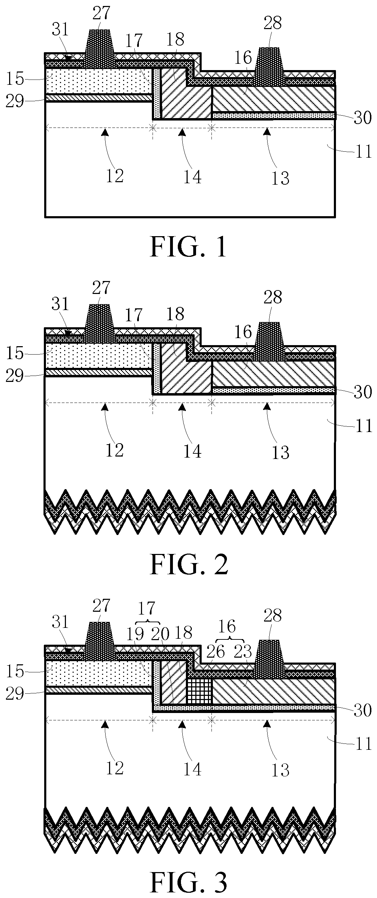

To resolve the foregoing technical problems, according to a first aspect, an embodiment of the present application provides a back contact solar cell. As shown in FIG. 1, the back contact solar cell includes a semiconductor substrate 11, a first doped semiconductor layer 15, a second doped semiconductor layer 16, a first dielectric layer 17, and a second dielectric layer 18. First regions 12 and second regions 13 that are alternately distributed at intervals are provided on a back surface of the semiconductor substrate 11, and a spacing region 14 is located between each of the first regions 12 and a second region 13 adjacent to the first region 12. The first doped semiconductor layer 15 is formed on the first regions 12 provided on the back surface. The second doped semiconductor layer 16 is formed at least on the second regions 13 provided on the back surface, where a conductivity type of the second doped semiconductor layer 16 is opposite to that of the first doped semiconductor layer 15. The first dielectric layer 17 and the second dielectric layer 18 are formed at least on the spacing regions 14 provided on the back surface. At least a portion of the first dielectric layer 17 and at least a portion of the second dielectric layer 18 are stacked between the first doped semiconductor layer 15 and the second doped semiconductor layer 16 in a direction in which the first regions 12 and the second regions 13 are arranged, at least a portion of the first dielectric layer 17 is in contact with the first doped semiconductor layer 15, and at least a portion of the second dielectric layer 18 is in contact with the second doped semiconductor layer 16. A material of the first dielectric layer 17 is different from that of the second dielectric layer 18. A structure formed by the first dielectric layer 17 and the second dielectric layer 18 is configured for electrically isolating at least some regions of the first doped semiconductor layer 15 from at least some regions of the second doped semiconductor layer 16.

In a case that the foregoing technical solution is used, as shown in FIG. 1, in the back contact solar cell provided in this embodiment of the present application, both the first doped semiconductor layer 15 and the second doped semiconductor layer 16 having opposite conductivity types are located on the back surface of the semiconductor substrate 11. In addition, a corresponding region between the first doped semiconductor layer 15 and the second doped semiconductor layer 16 on the back surface of the semiconductor substrate 11 is the spacing region 14, and with the presence of the spacing region 14, the first doped semiconductor layer 15 and the second doped semiconductor layer 16 can be spatially separated in a direction parallel to the back surface. In addition, the back contact solar cell provided in this embodiment of the present application further includes the first dielectric layer 17 and the second dielectric layer 18 that are formed at least on the spacing regions 14 provided on the back surface. At least a portion of the first dielectric layer 17 and at least a portion of the second dielectric layer 18 are stacked between the first doped semiconductor layer 15 and the second doped semiconductor layer 16 in the direction in which the first regions 12 and the second regions 13 are arranged. It can be learned that, in the direction in which the first regions 12 and the second regions 13 are arranged, the two dielectric layers, namely, the first dielectric layer 17 and the second dielectric layer 18, provided between at least a portion of the first doped semiconductor layer 15 and at least a portion of the second doped semiconductor layer 16 are used for electrical isolation. Compared with that the first doped semiconductor layer 15 is isolated from the second doped semiconductor layer by only a single dielectric layer (for example, a surface passivation layer) with poor insulation in an existing back contact solar cell, the structure formed by the first dielectric layer 17 and the second dielectric layer 18 in the embodiment of the present application has better electrical isolation, thereby mitigating a current leakage risk between at least some regions of the first doped semiconductor layer 15 and at least some regions of the second doped semiconductor layer 16, which is beneficial to improving the operating performance of the back contact solar cell. In addition, at least a portion of the first dielectric layer 17 is in contact with the first doped semiconductor layer 15, and at least a portion of the second dielectric layer 18 is in contact with the second doped semiconductor layer 16. In addition, materials of the first dielectric layer 17 and the second dielectric layer 18 are different, thereby facilitating separate determination of the materials of the first dielectric layer 17 and the second dielectric layer 18 based on different distribution positions and different contact objects of the first dielectric layer 17 and the second dielectric layer 18 and according to different actual requirements, which is beneficial to improving the applicability of the back contact solar cell provided in this embodiment of the present application to different application scenarios.

In an actual application procedure, in terms of materials, the semiconductor substrate may be a silicon substrate, a silicon germanium substrate, a germanium substrate, or another substrate of a semiconductor material.

In terms of conductivity types, the semiconductor substrate may be an N-type semiconductor substrate or a P-type semiconductor substrate.

In terms of structures, as shown in FIG. 1, a light-receiving surface of the semiconductor substrate 11 may be a polished surface, i.e., a relatively flat surface. Alternatively, as shown in FIG. 2, the light-receiving surface of the semiconductor substrate 11 may be a textured surface. In this case, the light-receiving surface of the semiconductor substrate 11 has a particular light trapping effect, so that an index of refraction of light being transmitted from the light-receiving surface to the semiconductor substrate 11 can be increased, thereby further improving the photoelectric conversion efficiency of the back contact solar cell.

In addition, as shown in FIG. 1, the first regions 12 and the second regions 13 that are alternately arranged at intervals are provided on the back surface of the semiconductor substrate 11, and a spacing region 14 is located between each of the first regions 12 and a second region 13 adjacent to the first region 12. It should be understood that boundaries between the first regions 12, the second regions 13, and the spacing regions 14 are virtual boundaries. In addition, because the first doped semiconductor layer 15 is formed on the first regions 12, the positions, quantity, and specifications of the first regions 12 on the back surface of the semiconductor substrate 11 affect the positions, quantity, and specifications of portions of the subsequently formed first doped semiconductor layer 15. Correspondingly, because the second doped semiconductor layer 16 is formed at least on the second regions 13, the positions, quantity, and specifications of the second regions 13 on the semiconductor substrate 11 affect the positions, quantity, and specifications of portions of the subsequently formed second doped semiconductor layer 16 that correspond to the second regions 13 of the semiconductor substrate 11. For the positions of the spacing regions 14, after the ranges of the first regions 12 and the second regions 13 are determined, a region between each first region 12 and a second region 13 adjacent to the first region 12 in the back surface is a spacing region 14. Based on this, specific positions, quantities, and specifications of the first regions 12, the second regions 13, and the spacing regions 14 on the semiconductor substrate 11 may be set according to requirements on information such as positions of corresponding portions of the first doped semiconductor layer 15 and the second doped semiconductor layer 16 in an actual application scenario. This is not specifically limited herein.

Specifically, surfaces of the first regions, the second regions, and the spacing regions in the back surface of the semiconductor substrate may be flush. Alternatively, as shown in FIG. 1, a groove structure may be provided on the back surface of the semiconductor substrate 11. In addition, both the second regions 13 and the spacing regions 14 are located in the groove structure. In this case, in the direction from the light-receiving surface to the back surface of the semiconductor substrate 11, both arrangement heights of a surface of the spacing region 14 and a surface of the second region 13 on the back surface are less than an arrangement height of a surface of the first region 12 on the back surface side. In this case, both the second region 13 and the spacing region 14 are located in the groove structure such that both the surface of the second region 13 and the surface of the spacing region 14 can be staggered with respect to the surface of the first region 12 in a thickness direction of the semiconductor substrate 11, which helps make the first doped semiconductor layer 15 and the second doped semiconductor layer 16 that are located together on the back surface and that have opposite conductivity types at least partially staggered in the thickness direction of the semiconductor substrate 11, to further mitigate a current leakage risk on the back surface, thereby improving the operating performance of the back contact solar cell.

Specifically, the depth of the groove structure may be determined according to anti-leakage requirements for the first doped semiconductor layer and the second doped semiconductor layer and a requirement for the thickness of the semiconductor substrate of an actual application scenario. This is not specifically limited herein.

For example, the depth of the groove structure may be greater than or equal to 0.3 µm and less than or equal to 3 µm. For example, the depth of the groove structure may be 0.3 µm, 0.5 µm, 0.8 µm, 1 µm, 1.5 µm, 2 µm, 2.5 µm, 3 µm, or the like. In this case, the depth of the groove structure is within the foregoing range such that a small degree to which the first doped semiconductor layer and the second doped semiconductor layer that are located together on the back surface of the silicon substrate and that have opposite conductivity types are staggered in a thickness direction of the semiconductor substrate caused by the depth of the groove structure being small can be prevented, thereby further mitigating a current leakage risk on the back surface. In addition, a requirement for use of a semiconductor substrate with a large thickness due to the depth of the groove structure being large can be further prevented, thereby helping implement the thin-film production of the back contact solar cell while reducing the manufacturing costs of the back contact solar cell.

In addition, as shown in FIG. 1, a portion of a bottom surface of the groove structure that corresponds to the spacing region 14 may be flush with a portion of the bottom surface of the groove structure that corresponds to the second region 13. Alternatively, the portion of the bottom surface of the groove structure that corresponds to the spacing region 14 may be lower than or higher than the portion of the bottom surface of the groove structure that corresponds to the second region 13. In this case, a height difference between the surface of the spacing region and the surface of the second region is not specifically limited in this embodiment of the present application.

It should be noted that, in an actual manufacturing procedure, after the first doped semiconductor layer is formed on the entire back surface and the first doped semiconductor layer is selectively etched, portions of the semiconductor substrate that correspond to the spacing regions and the second regions may be simultaneously etched to form the groove structure. In this case, the portions of the groove structure have the same depth. Based on this, when the portion of the bottom surface of the groove structure that corresponds to the spacing region is flush with the portion of the bottom surface of the groove structure that corresponds to the second region, the depth of the portion of the groove structure that corresponds to the spacing region is the same as the depth of the portion of the groove structure that corresponds to the second region. In this case, it is not necessary to selectively etch the spacing region or the second region after the first doped semiconductor layer is selectively etched such that while the manufacturing procedure of the back contact solar cell is simplified, the thickness of the selected material of the semiconductor substrate can be further reduced, thereby facilitating the implementation of thin-film production.

In addition, when the portion of the bottom surface of the groove structure that corresponds to the spacing region is lower than the portion of the bottom surface of the groove structure that corresponds to the second region, a difference between the depths of the groove structure that correspond to the first doped semiconductor layer and the second doped semiconductor layer is larger. However, at least a portion of the first dielectric layer and at least a portion of the second dielectric layer are formed on the spacing region, and the structure formed by the first dielectric layer and the second dielectric layer has electrical isolation. Therefore, in this case, a current leakage risk between the first doped semiconductor layer and the second doped semiconductor layer can be further mitigated.

Specifically, in an actual manufacturing procedure, after the first doped semiconductor layer is formed on the first regions, at least the spacing regions and the second regions on the back surface may be selectively etched simultaneously for the first time. In addition, after the second doped semiconductor layer is formed, the spacing regions on the back surface is selectively etched for the second time such that the portion of the bottom surface of the groove structure that corresponds to the spacing region is lower than the portion of the bottom surface of the groove structure that corresponds to the second region. Alternatively, after the first time of selective etching, the spacing regions are first selectively etched for the second time, and then the second doped semiconductor layer is formed. Alternatively, the second regions and the spacing regions may be separately selectively etched after the first doped semiconductor layer is formed on the first regions.

The surface topographies of the first regions, the second regions, and the spacing regions provided in the back surface of the semiconductor substrate may be set according to an actual requirement. As shown in FIG. 1, all the surfaces of the first regions 12, the second regions 13, and the spacing regions 14 may be planes. Alternatively, a texture structure may be formed on the surface of at least one of the first regions 12, the second regions 13, and the spacing regions 14, thereby improving the light trapping effect of the surface of the corresponding regions.

Specifically, when the texture structure is formed on the surface of at least one of the first regions, the second regions, and the spacing regions, the type of the texture structure and the one-dimensional size of the texture structure are not specifically limited in this embodiment of the present application. The texture structure may be a textured surface structure, for example, a pyramid structure or an inverted pyramid structure, or may be a non-pyramid structure or a polished structure.

For example, the non-pyramid structure may be formed on the surface of the first region, and the one-dimensional size of the base of the non-pyramid structure on the surface of the first region is greater than or equal to 0.5 µm and less than or equal to 20 µm. The base of the non-pyramid structure is closer to the semiconductor substrate than a top of the non-pyramid structure.

The non-pyramid structure may be a hole structure, a V-groove structure, a boss structure, or the like. Specifically, the surface of the first region having the boss structure may be a pyramid textured surface after polishing. In this case, the non-pyramid structure provided on the surface of the first region is a pyramid base structure after polishing.

The one-dimensional size of the base of the non-pyramid structure may be a length, a width, a diagonal length, a diameter, a height, or the like of the base of the non-pyramid structure. The one-dimensional size being specifically which size of the base of the non-pyramid structure may be determined based on the topography of the non-pyramid structure. For example, when the non-pyramid structure is a pyramid base structure after polishing, the one-dimensional size of the base of the non-pyramid structure may be a side length, a diagonal length, or a height of the pyramid base structure after polishing. In addition, the one-dimensional size of the base of the non-pyramid structure on the surface of the first region may be any value greater than or equal to 0.5 µm and less than or equal to 20 µm. For example, the one-dimensional size of the base of the non-pyramid structure provided on the surface of the first region may be 0.5 µm, 1 µm, 3 µm, 8 µm, 12 µm, 15 µm, 20 µm, or the like. Certainly, the one-dimensional size of the base of the non-pyramid structure provided on the surface of the first region is set to another suitable value less than 0.5 µm or greater than 20 µm according to an actual application scenario requirement.

In a case that the foregoing technical solution is used, the non-pyramid structure has a light trapping function. Therefore, when the non-pyramid structure is formed on the surface of the first region, more light is transmitted from the back surface through the surface of the first region to the semiconductor substrate and is used by the semiconductor substrate. In addition, when the non-pyramid structure is formed on the surface of the first region, the surface of the first region has a concave-convex topographic feature. Based on this, the first doped semiconductor layer is formed on the first regions. In this case, it is beneficial to also providing a side of the first doped semiconductor layer that faces away from the first regions with the corresponding fluctuating features, which is beneficial to increasing a contact area between the first doped semiconductor layer and a corresponding electrode, increasing the connection strength between the first doped semiconductor layer and the corresponding electrode, and reducing the contact resistance between the first doped semiconductor layer and the corresponding electrode. Moreover, the one-dimensional size of the base of the non-pyramid structure on the surface of the first region is within the foregoing range such that a poor light trapping effect of the first region and a small contact area between the first doped semiconductor layer and the corresponding electrode that are caused by small fluctuations on the surface of the first region due to the one-dimensional size being small can be prevented. Next, a large thinning amount of the semiconductor substrate during the formation of the non-pyramid structure provided on the surface of the first region caused by the one-dimensional size being large can be further prevented, thereby helping implement the thin-film production of the back contact solar cell.

For example, the non-pyramid structure may be formed on the surface of the second region, and the one-dimensional size of the base of the non-pyramid structure on the surface of the second region is greater than or equal to 10 µm and less than or equal to 50 µm. In addition, the base of the non-pyramid structure is closer to the semiconductor substrate than a top of the non-pyramid structure. In the foregoing case, when the non-pyramid structure is formed on the surface of the second region, for the meanings of the type of the non-pyramid structure, the topography of the non-pyramid structure, and the one-dimensional size at the base of the non-pyramid structure, reference may be made to the meanings of the type of the non-pyramid structure, the topography of the non-pyramid structure, and the one-dimensional size at the base of the non-pyramid structure when the non-pyramid structure is formed on the surface of the first region above. In addition, the beneficial effects in this case are similar to the beneficial effects of the non-pyramid structure being formed on the surface of the first region, and the one-dimensional size of the base of the non-pyramid structure on the surface of the first region being greater than or equal to 0.5 µm and less than or equal to 20 µm. Details are not described herein again.

In addition, in this case, the one-dimensional size of the base of the non-pyramid structure on the surface of the second region may be any value greater than or equal to 10 µm and less than or equal to 50 µm. For example, the one-dimensional size of the base of the non-pyramid structure provided on the surface of the second region may be 10 µm, 20 µm, 30 µm, 40 µm, 50 µm, or the like. Certainly, the one-dimensional size of the base of the non-pyramid structure provided on the surface of the second region is set to another suitable value less than 10 µm or greater than 50 µm according to an actual application scenario requirement.

In addition, when non-pyramid structures are formed on surfaces of both the first region and the second region, the types of the non-pyramid structures formed on the surfaces of the first region and the second region may be the same or may be different. Next, when the types of the non-pyramid structures corresponding to the surfaces of the first region and the second region are the same, the one-dimensional sizes of the bases of the non-pyramid structures formed on the surfaces of the first region and the second region may be equal or may not be equal. In a case that the non-pyramid structures are formed on the surfaces of both the first region and the second region, when the types of the non-pyramid structures and/or the one-dimensional sizes of the bases of the non-pyramid structures corresponding to the surfaces of the first region and the second region are different, it is beneficial to making the surface topographies of the first region and the second region different. The first doped semiconductor layer is formed on the first region, and a surface of a side of the first doped semiconductor layer that faces away from the semiconductor substrate has a surface fluctuation topography corresponding to the first region. Similarly, a surface of a side of at least a portion of the second doped semiconductor layer formed on the second region that faces away from the semiconductor substrate has a surface fluctuation topography corresponding to the second region. Therefore, when the surface topography of the first region is different from that of the second region, it is beneficial to making the first doped semiconductor layer and the side of the at least a portion of the second doped semiconductor layer that faces away from the semiconductor substrate have different surface topographies, thereby distinguishing between positions of the first doped semiconductor layer and the portion of the second doped semiconductor layer that is located on the second region on the back surface. This is beneficial to preventing a current leakage risk from increasing caused by deviations of formation positions of a first electrode in ohmic contact with the first doped semiconductor layer and a second electrode in ohmic contact with a portion of the second doped semiconductor layer that is located on the second region from target positions due to a failure to distinguish between positions of the two doped semiconductor layers when the two doped semiconductor layers are formed, thereby ensuring high electrical reliability of the back contact solar cell.

For example, the non-pyramid structure may be formed on the surface of the spacing region, and the one-dimensional size of the base of the non-pyramid structure on the surface of the spacing region is greater than or equal to 10 µm and less than or equal to 50 µm. The base of the non-pyramid structure is closer to the semiconductor substrate than a top of the non-pyramid structure. In this case, a non-pyramid textured surface has a light trapping function. Therefore, when the non-pyramid structure is formed on the surface of the spacing region, more light is transmitted from the back surface through the surface of the spacing region to the semiconductor substrate and is used by the semiconductor substrate. In addition, the one-dimensional size of the base of the non-pyramid structure on the surface of the spacing region is within the foregoing range such that a poor light trapping effect of the spacing region caused by small fluctuations on the surface of the spacing region due to the one-dimensional size being small can be prevented. Next, a large thinning amount of the semiconductor substrate during the formation of the non-pyramid structure provided on the surface of the spacing region caused by the one-dimensional size being large can be further prevented, thereby helping implement the thin-film production of the back contact solar cell.

Specifically, when the non-pyramid structure is formed on the surface of the spacing region, for the meanings of the type of the non-pyramid structure, the topography of the non-pyramid structure, and the one-dimensional size at the base of the non-pyramid structure, reference may be made to the meanings of the type of the non-pyramid structure, the topography of the non-pyramid structure, and the one-dimensional size at the base of the non-pyramid structure when the non-pyramid structure is formed on the surface of the first region above. In addition, in this case, the one-dimensional size of the base of the non-pyramid structure on the surface of the spacing region may be any value greater than or equal to 10 µm and less than or equal to 50 µm. For example, the one-dimensional size of the base of the non-pyramid structure provided on the surface of the spacing region may be 10 µm, 20 µm, 30 µm, 40 µm, 50 µm, or the like. Certainly, the one-dimensional size of the base of the non-pyramid structure provided on the surface of the spacing region is set to another suitable value less than 10 µm or greater than 50 µm according to an actual application scenario requirement.

In addition, when non-pyramid structures are formed on surfaces of both the spacing region and the second region, the types of the non-pyramid structures formed on the surfaces of the spacing region and the second region may be the same or may be different. Next, when the types of the non-pyramid structures corresponding to the surfaces of the spacing region and the second region are the same, the one-dimensional sizes of the bases of the non-pyramid structures formed on the surfaces of the spacing region and the second region may be equal or may not be equal. In a case that the non-pyramid structures are formed on the surfaces of both the spacing region and the second region, when the types of the non-pyramid structures and the one-dimensional sizes of the bases of the non-pyramid structures corresponding to the surfaces of the spacing region and the second region are both the same, it is not necessary to separately perform corresponding texturing on the spacing region and the second region after the first doped semiconductor layer is selectively etched such that while the manufacturing procedure of the back contact solar cell is simplified, the thickness of the selected material of the semiconductor substrate can be further reduced, thereby facilitating the implementation of thin-film production.

For the first dielectric layer and the second dielectric layer, in terms of materials, that the materials of the first dielectric layer and the second dielectric layer are different may be that at least some element types of the materials of the first dielectric layer and the second dielectric layer are different; or may be that ratios of atomic weights of at least some elements in the materials of the first dielectric layer and the second dielectric layer are different; or may be that crystalline phases of the materials of the first dielectric layer and the second dielectric layer are different.

The material of at least one of the first dielectric layer and the second dielectric layer may include any insulating material having a dielectric characteristic. Alternatively, the material of at least one of the first dielectric layer and the second dielectric layer may include a semiconductor material. Specific material types of the first dielectric layer and the second dielectric layer may be determined according to an actual requirement and an actual manufacturing procedure. This is not specifically limited herein.

For example, the material of the first dielectric layer may include an oxygen element. In this case, the dielectric layer (for example, a silicon dioxide layer or a silicon oxynitride layer) made of the material including the oxygen element has a high dielectricity such that the electrical isolation of the first dielectric layer can be improved, thereby further mitigating a current leakage risk between at least some regions of the first doped semiconductor layer and at least some regions of the second doped semiconductor layer.

For example, the material of the first dielectric layer may include a silicon element. In this case, a silicon element is abundant in nature, and various types of dielectric materials such as silicon dioxide, silicon nitride, silicon oxynitride, or silicon carbonitride include a silicon element, thereby facilitating the selection of an appropriate type according to different actual requirements, which is beneficial to improving the applicability of the back contact solar cell provided in this embodiment of the present application to different application scenarios.

For example, the first dielectric layer may include a tunnel oxide layer. In this case, in addition to being an insulating dielectric layer having a large thickness, the first dielectric layer may alternatively include a tunnel oxide layer having a small thickness, thereby providing another optional solution for the structure of the first dielectric layer. In addition, a manufacturing process of the tunnel oxide layer is mature. Therefore, when the first dielectric layer includes the tunnel oxide layer, the compatibility between manufacturing processes of the back contact solar cell provided in this embodiment of the present application and an existing back contact solar cell can be improved, thereby reducing the manufacturing difficulty of the first dielectric layer. A material of the tunnel oxide layer is not specifically limited in this embodiment of the present application.

For example, the material of the first dielectric layer may include at least one of silicon dioxide, silicon oxynitride, hafnium oxide, aluminum oxide, and zinc oxide. For example, the material of the first dielectric layer may include only any one of silicon dioxide, silicon oxynitride, hafnium oxide, aluminum oxide, and zinc oxide. For another example, the material of the first dielectric layer may include a combination of any two of silicon dioxide, silicon oxynitride, hafnium oxide, aluminum oxide, and zinc oxide. For yet another example, the material of the first dielectric layer may include a combination of any two of at least one of silicon dioxide, silicon oxynitride, hafnium oxide, aluminum oxide, and zinc oxide. When the material of the first dielectric layer includes at least two types, the distribution of different types of materials in the first dielectric layer is not specifically limited in this embodiment of the present application. In the foregoing case, various optional materials are provided for the first dielectric layer, thereby facilitating the selection of an appropriate type according to different actual requirements, which is beneficial to improving the applicability of the back contact solar cell provided in this embodiment of the present application to different application scenarios. In addition, silicon dioxide, silicon oxynitride, hafnium oxide, aluminum oxide, and zinc oxide each have a good electrical isolation characteristic, thereby further mitigating a current leakage risk between at least some regions of the first doped semiconductor layer and at least some regions of the second doped semiconductor layer.

For the foregoing second dielectric layer, the second dielectric layer may include a crystalline silicon layer. In addition, a doping type of the crystalline silicon layer includes at least one of an intrinsic type and a lightly-doped type. Specifically, the doping type of the crystalline silicon layer may be only an intrinsic type, or may be only a lightly-doped type, or a doping type of some regions of the crystalline silicon layer may be an intrinsic type and a doping type of some other regions of the crystalline silicon layer may be a lightly-doped type. In this case, the crystalline silicon material of the intrinsic type has poor electrical conductivity. Therefore, when the doping type of the crystalline silicon layer is the intrinsic type, the second dielectric layer has good electrical isolation, thereby ensuring that a current leakage risk between at least some regions of the first doped semiconductor layer and at least some regions of the second doped semiconductor layer can be mitigated by using the structure formed by the first dielectric layer and the second dielectric layer. In an actual manufacturing procedure, when at least the second doped semiconductor layer is doped with a dopant, the dopant in the second doped semiconductor layer may enter, through diffusion or the like, a portion of the second dielectric layer that is in contact with the second doped semiconductor layer such that a doping type of the at least a portion of the second dielectric layer turns into the lightly-doped type. Based on this, when the doping type of the crystalline silicon layer includes the lightly-doped type, it is not necessary to strictly control manufacturing conditions to ensure that the conductivity type of the crystalline silicon layer is the intrinsic type, which helps reduce the manufacturing difficulty of the back contact solar cell.

Specifically, in a case that the doping type of the crystalline silicon layer includes a lightly-doped type, the doping concentration of the dopant in the crystalline silicon layer is not specifically limited in this embodiment of the present application, provided that the structure formed by the first dielectric layer and the second dielectric layer can electrically isolate at least some regions of the first doped semiconductor layer from at least some regions of the second doped semiconductor layer.

For example, in a case that the doping type of the crystalline silicon layer includes the lightly-doped type, a doping concentration of a dopant in the crystalline silicon layer is greater than 0 and less than or equal to 5×10²¹ cm⁻³. In a case that the doping type of the crystalline silicon layer includes the lightly-doped type, a doping concentration of a dopant in the crystalline silicon layer may be greater than or equal to 1×10¹⁵ cm⁻³ and less than or equal to 5×10²¹ cm⁻³. For example, the doping concentration of the dopant in the crystalline silicon layer may be 1×10¹⁵ cm⁻³ , 5×10¹⁵ cm⁻³, 1×10¹⁶ cm⁻³ , 5×10¹⁶ cm⁻³, 1×10¹⁷ cm⁻³ , 5×10¹⁷ cm⁻³, 1×10¹⁸ cm⁻³, 5×10¹⁸ cm⁻³, 5×10²¹ cm⁻³, or the like. In this case, it may be understood that, within a particular range, when the doping concentration of the dopant in the crystalline silicon layer is larger, the electrical conduction performance of the crystalline silicon layer is better. Based on this, in a case that the doping type of the crystalline silicon layer includes the lightly-doped type and the doping concentration of the dopant in the crystalline silicon layer is within the foregoing range, the second dielectric layer can be kept from having low dielectricity due to the doping concentration of the dopant in the crystalline silicon layer being large, and good electrical isolation between at least some regions of the first doped semiconductor layer and at least some regions of the second doped semiconductor layer can be ensured.

In addition, in a case that the doping type of the crystalline silicon layer includes the intrinsic type and the lightly-doped type, the distribution of the portion of the crystalline silicon layer whose doping type is the intrinsic type and the portion of the crystalline silicon layer whose doping type is the lightly-doped type may be determined according to an actual application scenario. For example, the portion of the crystalline silicon layer whose doping type is the lightly-doped type and the portion of the crystalline silicon layer whose doping type is the intrinsic type are distributed in the direction from the second dielectric layer toward the second doped semiconductor layer, and the portion of the intrinsic type is in contact with the second doped semiconductor layer.

Alternatively, the portion of the crystalline silicon layer whose doping type is the intrinsic type and the portion of the crystalline silicon layer whose doping type is the lightly-doped type may be distributed in the direction toward the second doped semiconductor layer along the second dielectric layer, and the portion of the lightly-doped type is in contact with the second doped semiconductor layer. In this case, as shown in FIG. 1, at least a portion of the second dielectric layer 18 is in contact with the second doped semiconductor layer 16. In addition, the portion of the crystalline silicon layer whose doping type is the lightly-doped type and the portion of the crystalline silicon layer whose doping type is the intrinsic type are distributed in the direction from the second dielectric layer 18 toward the second doped semiconductor layer 16, and the portion of the lightly-doped type is in contact with the second doped semiconductor layer. Based on this, in an actual manufacturing procedure, when at least the second doped semiconductor layer 16 is doped with a dopant, the dopant in the second doped semiconductor layer 16 may enter, through diffusion or the like, a portion of the second dielectric layer 18 that is in contact with the second doped semiconductor layer 16 such that a doping type of the at least a portion of the second dielectric layer 18 turns into the lightly-doped type to manufacture the foregoing crystalline silicon layer, and it is not necessary to additionally perform other doping to form the foregoing crystalline silicon layer, thereby helping simplify the manufacturing procedure and the manufacturing difficulty of the second dielectric layer 18.

In terms of crystalline phases, the first dielectric layer may be an amorphous dielectric layer, and the second dielectric layer may include at least one of a microcrystalline dielectric layer, a nanocrystalline dielectric layer, a polycrystalline dielectric layer, or a monocrystalline dielectric layer. In this case, that the materials of the first dielectric layer and the second dielectric layer are different may alternatively mean that the crystalline phases of the first dielectric layer and the second dielectric layer are different, which provides a selection direction for the selection of the materials of the first dielectric layer and the second dielectric layer. In addition, various optional crystalline phases are provided for the second dielectric layer, and second dielectric layers of different crystalline phases may have different physical characteristics, thereby improving the applicability of the back contact solar cell provided in this embodiment of the present application to different application scenarios.

Specifically, when the crystalline phase of the first dielectric layer is an amorphous dielectric layer, the material of the first dielectric layer a silicon dioxide layer, an amorphous silicon layer, or the like. In addition, the crystalline phase of the second dielectric layer may be only one of a microcrystalline dielectric layer, a nanocrystalline dielectric layer, a polycrystalline dielectric layer, or a monocrystalline dielectric layer. For example, the second dielectric layer is a microcrystalline silicon layer, a nanocrystalline silicon layer, a polycrystalline silicon layer, or a monocrystalline silicon layer. Alternatively, the crystalline phase of the second dielectric layer may include at least two of a microcrystalline dielectric layer, a nanocrystalline dielectric layer, a polycrystalline dielectric layer, or a monocrystalline dielectric layer. For example, the second dielectric layer is a mixed layer of a microcrystalline silicon layer and a nanocrystalline silicon layer.

In terms of dielectric characteristics, both the first dielectric layer and the second dielectric layer may be non-conductive dielectric layers. For example, the first dielectric layer is a non-conductive dielectric layer made of an insulating material, and the second dielectric layer is a non-conductive dielectric layer made of an intrinsic semiconductor material.

Alternatively, one of the first dielectric layer and the second dielectric layer may be a dielectric layer having a specific conductivity. For example, the first dielectric layer is a tunnel passivation layer, and the second dielectric layer is a non-conductive dielectric layer made of an intrinsic semiconductor material. For another example, the first dielectric layer is a non-conductive dielectric layer made of an insulating material, and the second dielectric layer is a conductive dielectric layer made of a lightly-doped semiconductor material.

Specifically, the dielectric characteristics of the first dielectric layer and the second dielectric layer are not specifically limited in this embodiment of the present application, provided that the structure formed by the first dielectric layer and the second dielectric layer can electrically isolate at least some regions of the first doped semiconductor layer from at least some regions of the second doped semiconductor layer.

In terms of formation ranges, as shown in FIG. 1 and FIG. 2, the first dielectric layer 17 may be located only on the spacing regions 14.

Alternatively, as shown in FIG. 3, the first dielectric layer 17 may include a first dielectric portion 19 and a second dielectric portion 20 that are integrally continuous. The first dielectric portion 19 is located between the second dielectric layer 18 and the first doped semiconductor layer 15 in the direction in which the first regions 12 and the second regions 13 are arranged. The second dielectric portion 20 is located between the second dielectric layer 18 and the semiconductor substrate 11. In this case, as shown in FIG. 3, the first dielectric layer 17 is located on a side of the second dielectric layer 18 that is close to the first doped semiconductor layer 15, and is also located on a side of the second dielectric layer 18 that is close to the semiconductor substrate 11. Based on this, in an actual manufacturing procedure, after the material layer that is disposed on the entire back surface and that is used for manufacturing the first dielectric layer 17 is formed through deposition, it is not necessary to perform an additional etching operation before the second dielectric layer 18 is formed to remove a portion of the material layer that is located between the second dielectric layer 18 and the semiconductor substrate 11, which helps simplify the manufacturing procedure of the first dielectric layer 17.

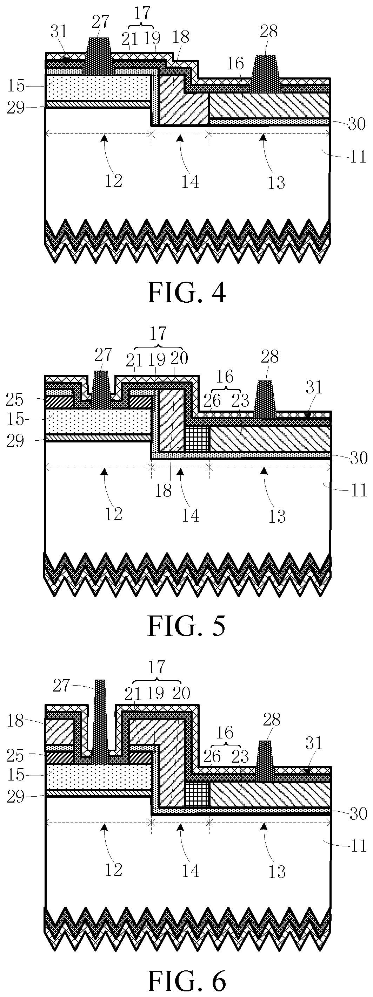

Further alternatively, as shown in FIG. 4, the first dielectric layer 17 may include the first dielectric portion 19 and a third dielectric portion 21 that are integrally continuous. The first dielectric portion 19 is located between the second dielectric layer 18 and the first doped semiconductor layer 15 in the direction in which the first regions 12 and the second regions 13 are arranged. The third dielectric portion 21 is located on a side of the first doped semiconductor layer 15 that faces away from the semiconductor substrate 11, and an extended-through first conductive window is provided in the third dielectric portion 21. In this case, the first dielectric layer 17 is located between the second dielectric layer 18 and the first doped semiconductor layer 15 in the direction in which the first regions 12 and the second regions 13 are arranged, and is also located on the side of the first doped semiconductor layer 15 that faces away from the semiconductor substrate 11 such that a formation range of the first dielectric layer 17 can be expanded, and a selective etching range of the material layer that is disposed on the entire back surface, that is used for manufacturing the first dielectric layer 17, and that is formed through deposition can be reduced in an actual manufacturing procedure, thereby helping improve the efficiency and production capacity of etching. Next, with the presence of the third dielectric portion 21, a surface of the side of the first doped semiconductor layer 15 that faces away from the semiconductor substrate 11 can be passivated, which is beneficial to reducing a quantity of defects on the side of the first doped semiconductor layer 15 that faces away from the semiconductor substrate 11. In addition, the extended-through first conductive window is provided in the second dielectric portion 20, which is beneficial to the direct contact between the first doped semiconductor layer 15 and a corresponding electrode to reduce the contact resistance between the first doped semiconductor layer 15 and the corresponding electrode, thereby ensuring high operating performance of the back contact solar cell.

Yet alternatively, as shown in FIG. 5, the first dielectric layer 17 may include the first dielectric portion 19, the second dielectric portion 20, and the third dielectric portion 21. For the beneficial effects in this case, reference may be made to the foregoing text. Details are not described herein again.

In addition, in an actual application procedure, as shown in FIG. 4, in a case that the first dielectric layer 17 includes the first dielectric portion 19 and the third dielectric portion 21 that are integrally continuous, the third dielectric portion 21 may be directly formed on the side of the first doped semiconductor layer 15 that faces away from the semiconductor substrate 11.

Alternatively, as shown in FIG. 5, in a case that the first dielectric layer 17 includes the first dielectric portion 19 and the third dielectric portion 21 that are integrally continuous, the back contact solar cell may further include a third dielectric layer 25 located between the third dielectric portion 21 and the first doped semiconductor layer 15. The first conductive window also extends through the third dielectric layer 25 (i.e., the first conductive window extends through at least the third dielectric layer 25 and the third dielectric portion 21). In this case, in an actual manufacturing procedure, after the first doped semiconductor layer 15 is formed on the entire back surface, it is necessary to selectively etch the first doped semiconductor layer 15 at least under a mask of a portion of the third dielectric layer 25 that corresponds to the first region 12. Based on this, if the first dielectric layer 17 includes the third dielectric portion 21 located on the side of the first doped semiconductor layer 15 that faces away from the semiconductor substrate 11, after the material used for manufacturing the second dielectric layer 18 is selectively etched, etching may stop at the third dielectric portion 21 without affecting the third dielectric layer 25 located below. In this case, when the back contact solar cell includes the third dielectric layer 25 located above the first region 12, it indicates that the portion of the third dielectric layer 25 that corresponds to the first region 12 is not removed after the first doped semiconductor layer 15 is selectively etched such that manufacturing steps of the back contact solar cell can be reduced, thereby improving the manufacturing efficiency.

Specifically, the material of the third dielectric layer may be any dielectric material having a masking function. The material of the third dielectric layer may be determined based on the material of the first doped semiconductor layer, an actual manufacturing procedure, and an actual application scenario.

For example, the third dielectric layer may include a silicon nitride layer.

For example, in a case that the material of the first doped semiconductor layer includes a silicon element, the third dielectric layer may include a doped silicon glass layer. In this case, a diffusion process may be used to implement the doping of the first doped semiconductor layer. After the diffusion, the doped silicon glass layer may be formed on the side of the first doped semiconductor layer that faces away from the semiconductor substrate. Based on this, in a case that the material of the first doped semiconductor layer includes the silicon element and the third dielectric layer includes the doped silicon glass layer, it is not necessary to additionally add a corresponding deposition step to form the third dielectric layer, thereby simplifying the manufacturing procedure of the back contact solar cell.

For the specifications of the third dielectric layer, the thickness of the third dielectric layer is not specifically limited in this embodiment of the present application. Next, as shown in FIG. 5, the first conductive window extends through the third dielectric layer 25. In addition, a corresponding electrode needs to extend through the third dielectric layer 25 and the third dielectric portion 21 through the first conductive window and to be in ohmic contact with the first doped semiconductor layer 15. Based on this, it may be understood that, in the direction in which the first regions 12 and the second regions 13 are arranged, the widths of the portions of the third dielectric layer 25 that are located on two sides of the first conductive window affect distances between at least two sides of a corresponding electrode formed in the first conductive window in a width direction and a film layer or an electrode having a conductivity type opposite to that of the corresponding electrode, and further affect a current leakage risk of the corresponding electrode formed in the first conductive window. Based on this, the width of the portion of the third dielectric layer 25 that is located on each side of the first conductive window may be determined according to anti-leakage requirements for the electrode in the first conductive window in an actual application scenario.

For example, in the direction in which the first regions and the second regions are arranged, a width of a portion of the third dielectric layer that is located on at least one side of the first conductive window may be greater than or equal to 40 µm and less than or equal to 220 µm. For example, the width of the portion of the third dielectric layer that is located on at least one side of the first conductive window may be 40 µm, 60 µm, 80 µm, 120 µm, 160 µm, 180 µm, 220 µm, or the like. In this case, the width of the portion of the third dielectric layer that is located on the at least one side of the first conductive window is within the foregoing range such that a small distance between a side of a corresponding electrode located in the first conductive window in the width direction and the film layer or the electrode having the opposite conductivity type due to the width of the portion of the third dielectric layer that is located on the at least one side of the first conductive window being small can be prevented, thereby suppressing current leakage. A small range of the spacing region and/or the second region that is located on the back surface together with the first region caused by a large range of the third dielectric layer that corresponds to the first region due to the width of the portion of the third dielectric layer that is located on at least one side of the first conductive window being large can be further prevented, thereby ensuring that at least some regions of the first doped semiconductor layer can be electrically isolated from at least some regions of the second doped semiconductor layer by at least the first dielectric layer and the second dielectric layer that are formed on the spacing regions, ensuring that the second doped semiconductor layer formed on the second regions has a suitable formation range, and further ensuring that the second doped semiconductor layer has high carrier collection efficiency.

Specifically, in the direction in which the first regions and the second regions are arranged, the widths of the portions of the third dielectric layer that are located on two sides of the first conductive window may be equal or may not be equal. When the widths of the portions of the third dielectric layer that are located on two sides of the first conductive window are equal, it is beneficial to making the structure of the back contact solar cell regular. In addition, the widths of the portions of the third dielectric layer that are located on two sides of the first conductive window are equal, which further helps make distances between at least two sides of a corresponding electrode formed in the first conductive window in a width direction and a film layer or an electrode having a conductivity type opposite to that of the corresponding electrode equal to each other, thereby suppressing current leakage.

For the second dielectric layer, as shown in FIG. 1, the second dielectric layer 18 may be located only on the spacing regions 14.

Alternatively, the second dielectric layer may extend above the first region. In this case, when the second dielectric layer is a non-conductive dielectric layer, the portion of the second dielectric layer that extends above the first region may be directly disposed on the side of the first doped semiconductor layer that faces away from the semiconductor substrate. In this case, the extended-through first conductive window is disposed in the portion of the second dielectric layer that corresponds to the first region. Alternatively, as shown in FIG. 6, when the first dielectric layer 17 includes the third dielectric portion 21, the second dielectric layer 18 may also extend onto the third dielectric portion 21 included in the first dielectric layer 17 and the first conductive window also extends through the portion of the second dielectric layer 18 that corresponds to the first region 12 (i.e., the first conductive window extends through at least the portion of the second dielectric layer 18 that corresponds to the first region 12 and the third dielectric portion 21). In this case, the second dielectric layer 18 may be a non-conductive dielectric layer, or may be a dielectric layer having a specific conductivity, provided that the structure formed by the first dielectric layer 17 and the second dielectric layer 18 can electrically isolate at least some regions of the first doped semiconductor layer 15 from at least some regions of the second doped semiconductor layer 16.

When the second dielectric layer extends onto the third dielectric portion included in the first dielectric layer, the back contact solar cell may include the third dielectric layer located between the third dielectric portion and the semiconductor substrate. For the material of the third dielectric layer, reference may be made to the foregoing description. Details are not described herein again. In addition, in this case, the first conductive window extends through the portion of the second dielectric layer that corresponds to the first region, the third dielectric portion, and the third dielectric layer.

It should be noted that, when the second dielectric layer further extends above the first region, it is beneficial to expanding a formation range of the second dielectric layer can be expanded, and a selective etching range of the material layer that is disposed on the entire back surface, that is used for manufacturing the second dielectric layer, and that is formed through deposition can be reduced in an actual manufacturing procedure, thereby helping improve the efficiency and production capacity of etching. In addition, the first conductive window extends through the portion of the second dielectric layer that corresponds to the first region, which is beneficial to the direct contact between the first doped semiconductor layer and a corresponding electrode, thereby reducing the contact resistance between the first doped semiconductor layer and the corresponding electrode.

In addition, in terms of the distribution in the extension direction of the spacing regions, corresponding portions of the first dielectric layer and the second dielectric layer that are between the first doped semiconductor layer and the second doped semiconductor layer may be located on all regions of the spacing region in an extension direction of the spacing region, and are configured for electrically isolating the first doped semiconductor layer from the second doped semiconductor layer. In other words, in this case, some regions of the first doped semiconductor layer can be electrically isolated from the second doped semiconductor layer by the structure formed by the first dielectric layer and the second dielectric layer, thereby minimizing a current leakage risk between the first doped semiconductor layer and the second doped semiconductor layer.

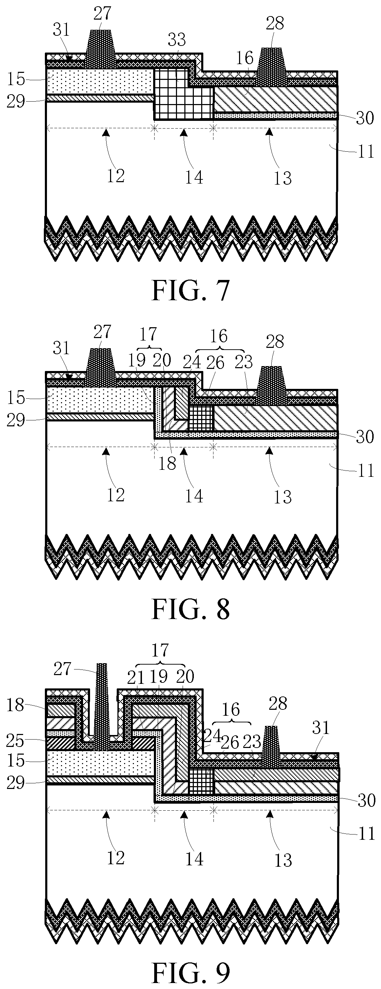

Alternatively, corresponding portions of the first dielectric layer and the second dielectric layer that are between the first doped semiconductor layer and the second doped semiconductor layer have a discontinuity in an extension direction of the spacing region. As shown in FIG. 7, the back contact solar cell may further include a conductive structure 33 located at least within the discontinuity. A conductivity type of the conductive structure 33 is opposite to that of one of the first doped semiconductor layer 15 and the second doped semiconductor layer 16, and only some regions of the first doped semiconductor layer 15 and only some regions of the second doped semiconductor layer 16 are respectively electrically connected to the conductive structure 33. In this case, the first doped semiconductor layer 15 and the second doped semiconductor layer 16 may be electrically connected by manufacturing a partial leakage site to form a built-in diode having a low reverse breakdown voltage, thereby helping provide the back contact solar cell with a low reverse breakdown voltage when being shaded. Next, only some regions of the first doped semiconductor layer 15 and only some regions of the second doped semiconductor layer 16 are respectively electrically connected to the conductive structure 33, in other words, some regions of the first doped semiconductor layer 15 and corresponding some regions of the second doped semiconductor layer 16 are respectively electrically connected to the at least one conductive structure 33, and the remaining regions of the first doped semiconductor layer 15 are still electrically isolated from corresponding regions of the second doped semiconductor layer 16 by the structure formed by the first dielectric layer 17 and the second dielectric layer 18. Low working efficiency of the back contact solar cell caused by a large leakage current during normal operation of the back contact solar cell due to the conductive structures 33 disposed in all the regions of the first doped semiconductor layer 15 and the second doped semiconductor layer 16 can be prevented, thereby ensuring that a photovoltaic module including the back contact solar cell provided in this embodiment of the present application has high photoelectric conversion efficiency in a forward voltage region.

Specifically, as described above, the arrangement of the conductive structure can implement local electrical leakage between the first doped semiconductor layer and the second doped semiconductor layer, thereby reducing a reverse breakdown voltage of the back contact solar cell. In an actual application procedure, after the arrangement proportion of the conductive structure in the extension direction of the spacing regions is increased to a particular range, the reverse breakdown voltage of the back contact solar cell no longer decreases, but current leakage of the back contact solar cell in normal operation is large. Based on this, the arrangement proportion of the conductive structure in the spacing regions may be determined according to requirements for the reverse breakdown voltage and the leakage current of the back contact solar cell in an actual application scenario.

The material and the conductivity type of the conductive structure may be determined according to an actual requirement and an actual manufacturing procedure.

For example, in a case that the back contact solar cell further includes the conductive structure, at least a portion of the conductive structure may be integrally continuous with the second doped semiconductor layer. In this case, the material and the conductivity type of at least a portion of the conductive structure may be the same as the material and the conductivity type of the second doped semiconductor layer. Next, the beneficial effects in this case are similar to the beneficial effects of the first dielectric layer and the second passivation layer being integrally continuous. Details are not described herein again.

For example, in a case that the back contact solar cell further includes the conductive structure, the structure formed by the first dielectric layer and the second dielectric layer is integrally continuous with the conductive structure. The beneficial effects in this case are similar to the beneficial effects of the first dielectric layer and the second passivation layer being integrally continuous. Details are not described herein again. It should be noted that, in this case, the method for selectively doping the portion of the material layer used for manufacturing the first dielectric layer, the second dielectric layer, and the conductive structure that corresponds to the position of the discontinuity may be performed to provide the portion of the material layer that corresponds to the position of the discontinuity with a conductive characteristic, and the first dielectric layer and the second dielectric layer corresponding to the material layer have an electrical isolation characteristic.

Next, in a case that the back contact solar cell further includes the conductive structure, at least a portion of the conductive structure, the second dielectric layer, and the second doped semiconductor layer may be integrally continuous.

In addition, the conductive structure may alternatively be formed at least in the discontinuity separately from the first dielectric layer, the second dielectric layer, and the second doped semiconductor layer. In this case, the conductivity type of the conductive structure may be opposite to that of the first doped semiconductor layer, and may also be opposite to that of the second doped semiconductor layer. The material of the conductive structure may include only a doped semiconductor material, may include a doped semiconductor material and a tunnel passivation material, and may include a doped semiconductor material and an intrinsic amorphous semiconductor material, or the like.

In terms of specifications, at least a portion of the first dielectric layer and at least a portion of the second dielectric layer are distributed on the spacing regions in the direction in which the first regions and the second regions are arranged. Based on this, it may be understood that, in the direction in which the first regions and the second regions are arranged, the width of the portion of the first dielectric layer that corresponds to the spacing region and the width of the portion of the second dielectric layer that corresponds to the spacing region affect the electrical isolation of a structure formed by the first dielectric layer and the second dielectric layer and affect the width of the spacing region. In addition, when formation manners of the first dielectric layer and the second dielectric layer are different, the widths of the first dielectric layer and the second dielectric layer in the spacing region may also be affected. Therefore, in the direction in which the first regions and the second regions are arranged, the width of the portion of the first dielectric layer that corresponds to the spacing region and the width of the portion of the second dielectric layer that corresponds to the spacing region may be determined according to requirements for the electrical isolation of the structure formed by the first dielectric layer and the second dielectric layer, the width of the spacing region, and the formation manners of the first dielectric layer and the second dielectric layer in an actual application scenario. This is not specifically limited herein.

For the first doped semiconductor layer and the second doped semiconductor layer, in terms of the conductivity type, the conductivity type of the first doped semiconductor layer may be an N type, and in this case, the conductivity type of the second doped semiconductor layer is a P type. Alternatively, the conductivity type of the first doped semiconductor layer may be a P type, and in this case, the conductivity type of the second doped semiconductor layer is an N type.

In terms of materials, the materials of the first doped semiconductor layer and the second doped semiconductor layer may include any semiconductor material, provided that the first doped semiconductor layer and the second doped semiconductor layer can be used in the back contact solar cell provided in this embodiment of the present application.

For example, the first doped semiconductor layer and/or the second doped semiconductor layer may be a doped amorphous silicon layer, or may be a doped crystalline silicon layer. When the first doped semiconductor layer and/or the second doped semiconductor layer is a doped crystalline silicon layer, the material of the doped crystalline silicon layer may include microcrystalline silicon, nanocrystalline silicon, polycrystalline silicon, monocrystalline silicon, and the like.

It should be noted that, compared with the doped amorphous silicon layer, the doped crystalline silicon layer has a higher lateral carrier transport characteristic. Therefore, when the first doped semiconductor layer and/or the second doped semiconductor layer is a doped crystalline silicon layer, the first doped semiconductor layer and/or the second doped semiconductor layer may have a higher carrier collection characteristic, thereby reducing the carrier recombination efficiency in the first region and/or the second region.

In terms of a formation position, the first doped semiconductor layer may be directly formed on the first regions provided on the back surface. Alternatively, as shown in FIG. 1, the back contact solar cell further may include a first passivation layer 29 located between the first doped semiconductor layer 15 and the semiconductor substrate 11. In this case, the first passivation layer 29 and the first doped semiconductor layer 15 may form a selective contact structure to implement chemical passivation on a corresponding region on the back surface of the semiconductor substrate 11 and selectively collect carriers of a corresponding conductivity type, thereby reducing a carrier recombination rate on the back surface and helping improve the photoelectric conversion efficiency of the back contact solar cell.

Specifically, a material of the first passivation layer may be determined according to a type requirement of the selective contact structure formed by the first passivation layer and the first doped semiconductor layer in an actual application scenario. This is not specifically limited herein. For example, when it is required that the selective contact structure formed by the first passivation layer and the first doped semiconductor layer be a tunnel passive contact structure in an actual application scenario, the first passivation layer is a tunnel passivation layer (the material of the tunnel passivation layer may be silicon oxide, titanium oxide, aluminum oxide, among others), and the first doped semiconductor layer is a doped polycrystalline silicon layer. For another example, when it is required that the selective contact structure formed by the first passivation layer and the first doped semiconductor layer be a heterogeneous contact structure in an actual application scenario, the material of the first passivation layer includes intrinsic amorphous silicon and/or an intrinsic microcrystalline silicon, and the material of the first doped semiconductor layer is doped amorphous silicon and/or doped microcrystalline silicon. In addition, the thickness of the first passivation layer is not specifically limited in this embodiment of the present application.

For the second doped semiconductor layer, the portion of the second doped semiconductor layer that corresponds to the second region may be directly formed on the second regions provided on the back surface. Alternatively, as shown in FIG. 1, the back contact solar cell further may include a second passivation layer 30 located between the second doped semiconductor layer 16 and the semiconductor substrate 11. In this case, the second passivation layer 30 and the second doped semiconductor layer 16 may form the selective contact structure to implement chemical passivation on a corresponding region on the back surface of the semiconductor substrate 11 and selectively collect carriers of a corresponding conductivity type, thereby reducing a carrier recombination rate on the back surface and helping improve the photoelectric conversion efficiency of the back contact solar cell.

Specifically, the material of the second passivation layer may be determined according to a type requirement of the selective contact structure formed by the second passivation layer and the second doped semiconductor layer in an actual application scenario. This is not specifically limited herein. For example, when it is required that the selective contact structure formed by the second passivation layer and the second doped semiconductor layer be a tunnel passive contact structure in an actual application scenario, the second passivation layer is a tunnel passivation layer, and the second doped semiconductor layer is a doped polycrystalline silicon layer. For another example, when it is required that the selective contact structure formed by the second passivation layer and the second doped semiconductor layer be a heterogeneous contact structure in an actual application scenario, the material of the second passivation layer includes intrinsic amorphous silicon and/or an intrinsic microcrystalline silicon, and the material of the second doped semiconductor layer is doped amorphous silicon and/or doped microcrystalline silicon.

In an actual application procedure, in a case that the back contact solar cell further includes the second passivation layer, the first dielectric layer and the second passivation layer may be integrally continuous. In this case, when the first dielectric layer and the second passivation layer are integrally continuous, the first dielectric layer and the second passivation layer may be simultaneously formed based on a same material in a same manufacturing step, thereby reducing the manufacturing costs of the back contact solar cell while simplifying the manufacturing procedure of the back contact solar cell and improving the manufacturing efficiency of the back contact solar cell. Certainly, in an actual manufacturing procedure, the first dielectric layer and the second passivation layer may alternatively be respectively formed in different manufacturing steps.

In addition, a porosity of the first dielectric layer may be less than that of the second passivation layer. In this case, compared with other dielectric materials, air has a lower dielectric constant. Based on this, when the porosity of the first dielectric layer is less than the porosity of the second passivation layer, it is beneficial to make the dielectric constant of the first dielectric layer greater than the dielectric constant of the second passivation layer, thereby helping improve the dielectricity of the first dielectric layer, and ensuring that at least some regions of the first doped semiconductor layer can be electrically isolated from at least some regions of the second doped semiconductor layer by the structure formed by the first dielectric layer and the second dielectric layer. Next, high transport resistance in the second passivation layer can be further prevented, thereby further improving the operating performance of the back contact solar cell. Certainly, a porosity of the first dielectric layer may be equal to that of the second passivation layer.

For the second dielectric layer, the second dielectric layer and the second doped semiconductor layer may be integrally continuous. For the beneficial effects in this case, reference may be made to the foregoing analysis of the beneficial effects of the first dielectric layer and the second passivation layer being integrally continuous. Details are not described herein again. Certainly, in an actual manufacturing procedure, the second dielectric layer and the second doped semiconductor layer may alternatively be respectively formed in different manufacturing steps.

In terms of formation ranges, as shown in FIG. 1 and FIG. 2, the first doped semiconductor layer 15 is located on the first regions 12.

For the second doped semiconductor layer, as shown in FIG. 1 and FIG. 2, the second doped semiconductor layer 16 may be located only on the second regions 13.

Alternatively, as shown in FIG. 8 and FIG. 9, the second doped semiconductor layer 16 may include a first doped portion 23 and a second doped portion 24 that are electrically connected to each other. The first doped portion 23 is located on the second regions 13. The second doped portion 24 is located on a side of the second dielectric layer 18 that faces away from the first dielectric layer 17, and a doping concentration of a dopant in the second doped portion 24 is less than a doping concentration of a dopant in the first doped portion 23. In this case, it is beneficial to expanding a formation range of the second doped semiconductor layer 16, and a selective etching range of an intrinsic semiconductor layer that is disposed on the entire back surface, that is used for manufacturing the second doped semiconductor layer 16, and that is formed through deposition or another process can be reduced in an actual manufacturing procedure, thereby helping improve the etching efficiency and production capacity. In addition, the doping concentration of the dopant in the second doped portion 24 is less than the doping concentration of the dopant in the first doped portion 23, to help prevent a short circuit caused by electrical conduction between the first doped semiconductor layer 15 and the first doped portion 23 through the second doped portion 24, thereby ensuring high electrical reliability of the back contact solar cell.

Specifically, as shown in FIG. 8, the second doped portion 24 may be located only in the spacing regions 14, and the second doped portion 24 is located, in the direction in which the first regions 12 and the second regions 13 are arranged, on a side of the second dielectric layer 18 that faces away from the first dielectric layer 17.

Alternatively, when the first dielectric layer includes the first dielectric portion and the third dielectric portion, the second doped portion may be disposed in the spacing region and extends to the first region. In this case, a portion of the second doped portion that corresponds to the spacing region is located on a side of the second dielectric layer that faces away from the first dielectric layer, and a portion of the second doped portion that corresponds to the first region is located on an upper portion of the third dielectric portion that faces away from the first doped semiconductor layer. In addition, the first conductive window at least extends through the portion of the second doped portion that corresponds to the first region and the third dielectric portion. In this case, the second doped portion can be located in the spacing region, and can also extend to the first region such that a formation range of the second doped semiconductor layer can be further increased, thereby further improving the etching efficiency and the etching production capacity of selectively etching the second doped semiconductor layer.

Further alternatively, when the second dielectric layer extends above the first region, the second doped portion may be disposed in the spacing region and extends to the first region. In addition, the portion of the second doped portion that corresponds to the first region is located on the portion of the second dielectric layer that corresponds to the first region. The first conductive window extends at least through the second dielectric layer and the portion of the second doped portion that corresponds to the first region. Specifically, when the first dielectric layer includes only the first dielectric portion and the second dielectric portion, the first conductive window may extend only through the second dielectric layer and the portion of the second doped portion that corresponds to the first region. As shown in FIG. 9, when the first dielectric layer 17 further includes the first dielectric portion 19 and the third dielectric portion 21, the second dielectric layer 18 extends onto the third dielectric portion 21 included in the first dielectric layer 17, and the first conductive window needs to extend through the third dielectric portion 21, the second dielectric layer 18, and the portion of the second doped portion 24 that corresponds to the first region 12.

It should be noted that, as shown in FIG. 9, when the second doped portion 24 included in the second doped semiconductor layer 16 is located in the spacing region 14 and also extends to the first region 12, the second dielectric layer 18 also extends onto the third dielectric portion 21 included in the first dielectric layer 17. In this case, the first conductive window needs to extend through the second doped portion 24, the portion of the second dielectric layer 18 that corresponds to the first region 12, and the third dielectric portion 21. Both the third dielectric portion 21 and the portion of the second dielectric layer 18 that corresponds to the first region 12 are provided between the second doped portion 24 and the first doped semiconductor layer 15 having opposite conductivity types, to ensure high electrical isolation between the portion of the second doped portion 24 that corresponds to the first region 12 and the first doped semiconductor layer 15.

In an example, in a case that the second doped portion extends onto the first region and the first dielectric layer includes the third dielectric portion, the back contact solar cell may further include a third dielectric layer located between the third dielectric portion and the first doped semiconductor layer. The first conductive window further extends through the third dielectric layer. In this case, as shown in FIG. 9, both the third dielectric portion 21 and the third dielectric layer 25 are provided between the second doped portion 24 and the first doped semiconductor layer 15 having opposite conductivity types, to ensure high electrical isolation between the portion of the second doped portion 24 that corresponds to the first region 12 and the first doped semiconductor layer 15.

For the thickness of the second doped portion, because in an actual application procedure, the second dielectric layer and the second doped semiconductor layer are integrally formed, the thickness of the second doped portion is inversely proportional to the thickness of the second dielectric layer. The thickness of the second dielectric layer in turn affects the dielectric characteristic of the structure formed by the first dielectric layer and the second dielectric layer. Based on this, the thickness of the second doped portion may be determined based on a formation manner of the second dielectric layer, a dielectric characteristic of the structure formed by the first dielectric layer and the second dielectric layer, and actual manufacturing precision in an actual application scenario. This is not specifically limited herein.

For example, the thickness of the second doped portion may be greater than or equal to 40 nm and less than or equal to 150 nm. For example, the thickness of the second doped portion may be 40 nm, 60 nm, 80 nm, 100 nm, 120 nm, 150 nm, or the like. In this case, the thickness of the second doped portion is within the foregoing range such that high precision in controlling doping conditions in a manufacturing procedure due to the thickness of the second doped portion being small can be prevented, thereby reducing the manufacturing difficulty of the second doped portion. In addition, when the second dielectric layer and the second doped semiconductor layer are integrally continuous and the thickness of the second doped portion is within the foregoing range, a low degree of mitigating a current leakage risk of at least some regions of the first doped semiconductor layer and at least some regions of the second doped semiconductor layer through the first dielectric layer and the second dielectric layer caused by a small thickness of the second dielectric layer due to the thickness of the second doped portion being large can be further prevented, thereby ensuring high operating performance of the back contact solar cell.

The doping concentration of the dopant in the first doped portion may be determined according to an actual application scenario. This is not specifically limited herein. The doping concentration of the dopant in the second doped portion may be any value less than the doping concentration of the dopant in the first doped portion. This is not specifically limited herein.

For example, the doping concentration of the dopant in the second doped portion may be greater than 0 and less than or equal to 1×10²⁰ cm⁻³. For example, the doping concentration of the dopant in the second doped portion may be 1×10¹⁵ cm⁻³, 6×10¹⁵ cm⁻³, 1×10¹⁶ cm⁻³, 5×10¹⁶ cm⁻³, 1×10¹⁷ cm⁻³, 5×10¹⁷ cm⁻³, 1×10¹⁸ cm⁻³, 1×10¹⁹ cm⁻³, 1×10²⁰ cm⁻³ , or the like. In this case, the doping concentration of the dopant in the second doped portion is within the foregoing range such that a low degree of mitigating a current leakage risk of at least some regions of the first doped semiconductor layer and at least some regions of the second doped semiconductor layer through the first dielectric layer and the second dielectric layer caused by high electrical conduction performance of the second doped portion due to the doping concentration of the dopant in the second doped portion being large can be further prevented, thereby ensuring high operating performance of the back contact solar cell.

Further alternatively, as shown in FIG. 3, FIG. 10, and FIG. 11, the second doped semiconductor layer 16 may include a first doped portion 23 and a third doped portion 26 that are electrically connected to each other. The first doped portion 23 is located on the second regions 13, and the third doped portion 26 is located on the spacing regions 14. A doping concentration of a dopant in the third doped portion 26 is less than a doping concentration of a dopant in the first doped portion. In this case, in an actual manufacturing procedure, a width of the spacing region 14 located between the first region 12 and the adjacent second region 13 is large due to equipment precision and/or for preventing current leakage. Based on this, the second doped semiconductor layer 16 includes the first doped portion 23 located on the second regions 13 and further includes the third doped portion 26 located on some spacing regions. In this case, when the back contact solar cell is in operation, the second doped semiconductor layer 16 can collect and extract in time electrons or holes corresponding to the second regions 13, and can also collect and extract in time electrons or holes corresponding to the some spacing regions 14. Therefore, when at least some regions of the first doped semiconductor layer 15 is electrically isolated from at least some regions of the second doped semiconductor layer 16 by the structure formed by the first dielectric layer 17 and the second dielectric layer 18, the carrier recombination rate at the spacing regions 14 having large widths can also be reduced, thereby further improving the photoelectric conversion efficiency of the back contact solar cell. In addition, because the third doped portion 26 is located between the first doped portion 23 and the first doped semiconductor layer 15, when a doping concentration of the dopant in the third doped portion 26 located on some spacing regions 14 is less than a doping concentration of the dopant in the first doped portion 23 located on the second region 13, the electrical conductivity of the third doped portion 26 can be reduced, the risk of electrical breakdown penetrating the first dielectric layer 17 and the second dielectric layer 18 can be reduced, and the diffusion of the dopant in the third doped portion 26 to the second dielectric layer 18 can be suppressed or even eliminated, thereby ensuring that the structure formed by the first dielectric layer 17 and the second dielectric layer 18 has good electrical isolation, and ensuring that the back contact solar cell has good electrical performance.

Specifically, in terms of doping concentrations of dopants, specific doping concentrations of the dopant in the first doped portion and the dopant in the third doped portion may be determined according to an actual application scenario, provided that the doping concentration of the dopant in the third doped portion is less than the doping concentration of the dopant in the first doped portion.

For example, the doping concentration of the dopant in the third doped portion may be greater than or equal to 1×10¹⁵ cm⁻³ and less than or equal to 5×10²¹ cm⁻³. For example, the doping concentration of the dopant in the third doped portion may be 1×10¹⁵ cm⁻³, 5×10¹⁵ cm⁻³, 1×10¹⁶ m⁻³, 5×10¹⁶ cm⁻³, 1×10¹⁷ cm⁻³, 5×10¹⁷ cm⁻³, 1×10¹⁸ cm⁻³, 5×10¹⁸ cm⁻³, 1×10¹⁹ cm⁻³, 1×10²⁰ cm⁻³, 1×10²¹ cm⁻³, 5×10²¹ cm⁻³, or the like. In this case, the doping concentration of the dopant in the third doped portion is within the foregoing range such that a poor carrier collection capability of the third doped portion caused by the doping concentration of the dopant in the third doped portion being small can be prevented, thereby further improving the degree of reducing the carrier recombination rate at the spacing regions by using the third doped portion. In addition, easy diffusion of carriers in the third doped portion into an intrinsic semiconductor layer caused by the doping concentration of the dopant in the third doped portion being large can be further prevented, thereby ensuring that the intrinsic semiconductor layer has good electrical isolation.

For example, in a direction from the second region to the first region, the doping concentration of the dopant in the third doped portion may gradually decrease. In this case, while the dopant in the third doped portion has a particular doping concentration such that the third doped portion has a particular lateral carrier collection capability, a portion having the lowest doping concentration of the dopant in the third doped portion may further be in contact with the second dielectric layer such that a carrier concentration gradient at a position where the portion is in contact with the second dielectric layer is reduced, and the diffusion of the dopant in the third doped portion into the second dielectric layer is further suppressed or even eliminated, thereby ensuring that the structure formed by the first dielectric layer and the second dielectric layer has good electrical isolation.

In the direction from the second region to the first region, a rate at which the doping concentration of the dopant in the third doped portion gradually decreases may be determined according to an actual application scenario. This is not specifically limited herein.

In terms of sizes, because the third doped portion, at least a portion of the first dielectric layer, and at least a portion of the second dielectric layer are located on the spacing regions together, and in the direction from the first region to the second region, the width of the structure formed by the first dielectric layer and the second dielectric layer affects the isolation of the structure, the width of the spacing region and the width of the third doped portion may be determined according to a requirement for electrical isolation of the structure formed by the first dielectric layer and the second dielectric layer in an actual application scenario. In this embodiment of the present application, the width of the spacing region, the width of the third doped portion, and a width ratio of the third doped portion to the first doped portion are not specifically limited.

For example, the width of the spacing region may be greater than or equal to 30 µm and less than or equal to 200 µm. For example, the width of the spacing region may be 30 µm, 50 µm, 80 µm, 100 µm, 150 µm, 200 µm, or the like. In this case, the width of the spacing region is within the foregoing range such that the difficulty in arranging, within a small width range, the third doped portion, at least a portion of the first dielectric layer, and at least a portion of the second dielectric layer that have suitable widths due to a small range of the spacing region can be prevented, thereby ensuring that a structure formed by the third doped portion, the first dielectric layer, and the second dielectric layer has the function described above. In addition, the small widths of the first doped semiconductor layer and/or the second doped semiconductor layer caused by the small widths of the first region and/or the second region that is located on the back surface together due to the large with of the spacing region can be further prevented, thereby ensuring that the first doped semiconductor layer and the second doped semiconductor layer can collect and extract carriers corresponding to the first region and the second region in time, and further reducing a carrier recombination rate on the back surface.

For example, in the direction in which the first regions and the second regions are arranged, a width ratio of the third doped portion to the first doped portion may be greater than or equal to 1:20000 and less than or equal to 2:700. For example, in the direction in which the first regions and the second regions are arranged, the width ratio of the third doped portion to the first doped portion may be 1:20000, 1:15000, 1:12000, 1:10000, 1:5000, 1:1000, 2:700, or the like. In this case, when the width ratio of the third doped portion to the first doped portion is within the foregoing range, the width of the first doped portion is far greater than the width of the third doped portion such that a poor carrier collection capability of the first doped portion caused by the width of the first doped portion being small can be prevented, and the small widths of the spacing region and the first region that are located on the back surface together with the second region caused by the width of the first doped portion being large can be further prevented, thereby ensuring that at least some regions of the first doped semiconductor layer can be electrically isolated from at least some regions of the second doped semiconductor layer by at least the first dielectric layer and the second dielectric layer that are formed on the spacing regions, ensuring that the first doped semiconductor layer formed on the first regions has a suitable formation range, and further ensuring that the first doped semiconductor layer has high carrier collection efficiency.

It should be noted that, as shown in FIG. 9, the second doped semiconductor layer 16 may include the first doped portion 23, the second doped portion 24, and the third doped portion 26.

It may be understood that, as shown in FIG. 8 and FIG. 9, when the second doped semiconductor layer 16 includes the second doped portion 24 and/or the third doped portion 26, if the second dielectric layer 18 and the second doped semiconductor layer 16 are integrally continuous, the presence of the second doped portion 24 and/or the third doped portion 26 affects the width of the second dielectric layer 18 in the direction in which the first regions 12 and the second regions 13 are arranged. When the second dielectric layer 18 is formed on the spacing region 14 alone, the thickness of the second dielectric layer 18 is related to the width of the spacing region 14. For the first dielectric layer 17, when the first dielectric layer 17 and the second passivation layer 30 are integrally continuous, the thickness of the first dielectric layer 17 is equal to the thickness of the second passivation layer 30. When the first dielectric layer 17 is formed on the spacing region 14 alone, the thickness of the first dielectric layer 17 is related to the width of the spacing region 14. In the foregoing case, the thicknesses of the first dielectric layer 17 and the second dielectric layer 18 may be determined based on formation manners of the first dielectric layer 17 and the second dielectric layer 18, the width of the spacing region 14, and the structure of the second doped semiconductor layer 16. This is not specifically limited herein.

For example, in the direction in which the first regions and the second regions are arranged, a width of a portion of the first dielectric layer that corresponds to the spacing region may be greater than or equal to 1 nm and less than or equal to 3 nm. For example, the width of the portion of the first dielectric layer that corresponds to the spacing region may be 1 nm, 1.2 nm, 1.5 nm, 2 nm, 2.2 nm, 2.5 nm, 3 nm, or the like. In this case, the width of the portion of the first dielectric layer that corresponds to the spacing region is within the foregoing range such that poor dielectricity of the first dielectric layer in the direction in which the first regions and the second regions are arranged due to the width of the portion of the first dielectric layer that corresponds to the spacing region being small can be prevented, thereby ensuring that at least a portion of the first doped semiconductor layer can be electrically isolated from at least a portion of the second doped semiconductor layer by the structure formed by the first dielectric layer and the second dielectric layer. In addition, low carrier collection efficiency of the first doped semiconductor layer and/or the second doped semiconductor layer caused by a width of the spacing region located between the first doped semiconductor layer and the second doped semiconductor layer being large due to the width of the portion of the first dielectric layer that corresponds to the spacing region being large can be further prevented. Moreover, when the first dielectric layer is integrally continuous with a second passivation layer located between the second doped semiconductor layer and the semiconductor substrate, the width of the portion of the first dielectric layer that corresponds to the spacing region is within the foregoing range such that a large carrier transport resistance corresponding to the second passivation layer caused by a large thickness of the second passivation layer due to a large width can be further prevented, thereby ensuring high operating performance of the back contact solar cell.

Certainly, the width of the portion of the first dielectric layer that corresponds to the spacing region may be another suitable value less than 1 nm or greater than 3 nm.

For example, in the direction in which the first regions and the second regions are arranged, a width of a portion of the second dielectric layer that corresponds to the spacing region may be greater than or equal to 80 nm and less than or equal to 300 nm. For example, the width of the portion of the second dielectric layer that corresponds to the spacing region may be 80 nm, 100 nm, 150 nm, 180 nm, 200 nm, 250 nm, 280 nm, 300 nm, or the like. In this case, the width of the portion of the second dielectric layer that corresponds to the spacing region is within the foregoing range such that low carrier collection efficiency of the first doped semiconductor layer and/or the second doped semiconductor layer caused by a width of the spacing region located between the first doped semiconductor layer and the second doped semiconductor layer being large due to the width of the portion of the second dielectric layer that corresponds to the spacing region being large can be further prevented. Next, a high consumption of materials for manufacturing the second dielectric layer due to the width of the portion of the second dielectric layer that corresponds to the spacing region being large can be further prevented, which is beneficial to controlling the manufacturing costs of the back contact solar cell. In addition, when the second dielectric layer and the second doped semiconductor layer are integrally continuous, the width of the portion of the second dielectric layer that corresponds to the spacing region is within the foregoing range such that low carrier collection efficiency of the second doped semiconductor layer caused by a small thickness of the second doped semiconductor layer due to the width of the portion of the second dielectric layer that corresponds to the spacing region being small can be further prevented, thereby ensuring high operating performance of the back contact solar cell.

For example, in a case that the second doped semiconductor layer includes a first doped portion and a second doped portion that are electrically connected to each other, in the direction in which the first regions and the second regions are arranged, the width of the portion of the second dielectric layer that corresponds to the spacing region may be greater than or equal to 40 nm and less than or equal to 150 nm. For example, the width of the portion of the second dielectric layer that corresponds to the spacing region may be 40 nm, 60 nm, 80 nm, 100 nm, 120 nm, 150 nm, or the like. In this case, the width of the portion of the second dielectric layer that corresponds to the spacing region is within the foregoing range such that poor dielectricity of the second dielectric layer in the direction in which the first regions and the second regions are arranged due to the width of the portion of the second dielectric layer that corresponds to the spacing region being small can be prevented, thereby ensuring that at least a portion of the first doped semiconductor layer can be electrically isolated from at least a portion of the second doped semiconductor layer by the structure formed by the first dielectric layer and the second dielectric layer. Next, low carrier collection efficiency of the first doped semiconductor layer and/or the second doped semiconductor layer caused by a width of the spacing region located between the first doped semiconductor layer and the second doped semiconductor layer being large due to the width of the portion of the second dielectric layer that corresponds to the spacing region being large can be prevented. In addition, when the second dielectric layer and the second doped semiconductor layer are integrally continuous, the width of the portion of the second dielectric layer that corresponds to the spacing region is within the foregoing range such that low carrier collection efficiency of the second doped semiconductor layer caused by a small thickness of the second doped semiconductor layer due to the width of the portion of the second dielectric layer that corresponds to the spacing region being small can be further prevented, thereby ensuring high operating performance of the back contact solar cell.

In an actual application procedure, carriers collected by the first doped semiconductor layer and the second doped semiconductor layer need to be extracted via a corresponding electrode, to form a photocurrent. After the pattern of the back contact solar cell is determined, distances between a corresponding electrode that is in ohmic contact with the second doped semiconductor layer and the boundaries of the second region and the spacing region are determined. Based on this, a width of a portion of the second region and a width of a portion of the first doped portion may be indirectly determined by using a spacing between a geometric center of a portion of a corresponding electrode that is adjacent to the third doped portion and the third doped portion.

For example, as shown in FIG. 3, FIG. 5, and FIG. 6, the back contact solar cell may further include a first electrode 27 and a second electrode 28. The first electrode 27 is formed on the first doped semiconductor layer 15, and is in ohmic contact with the first doped semiconductor layer 15. The second electrode 28 is formed on the first doped portion 23, and is in ohmic contact with the first doped portion 23. In the foregoing case, in the direction in which the first regions 12 and the second regions 13 are arranged, a spacing between a geometric center of a portion of the second electrode 28 that is adjacent to the third doped portion 26 and the third doped portion 26 may be greater than or equal to 110 µm and less than or equal to 380 µm. For example, the spacing between the geometric center of the portion of the second electrode 28 that is adjacent to the third doped portion 26 and the third doped portion 26 may be 110 µm, 150 µm, 180 µm, 200 µm, 240 µm, 260 µm, 300 µm, 340 µm, 380 µm, or the like. In this case, the second electrode 28 is formed on the first doped portion 23, and is in ohmic contact with the first doped portion 23. In this case, the spacing between the geometric center of the portion of the second electrode 28 that is adjacent to the third doped portion 26 included in the second doped semiconductor layer 16 and the third doped portion 26 affects the width of the first doped portion 23 in the direction in which the first regions 12 and the second regions 13 are arranged, and further affects the carrier collection efficiency of the first doped portion 23. Based on this, if the spacing between the geometric center of the portion of the second electrode 28 that is adjacent to the third doped portion 26 and the third doped portion 26 is within the foregoing range, low carrier collection efficiency of the first doped portion 23 caused by the spacing between the geometric center of the portion of the second electrode 28 that is adjacent to the third doped portion 26 and the third doped portion 26 being small can be prevented. In addition, a width of the spacing region 14 and/or the first region 12 that is located on the back surface together with the second region 13 caused by the width of the first doped portion 23 being large due to the large spacing can be further prevented. For the beneficial effects of preventing the small widths of the spacing region 14 and/or the first region 12, reference may be made to the foregoing descriptions. Details are not described herein again.

In an example, as shown in FIG. 1, the back contact solar cell may further include a surface passivation layer 31. The surface passivation layer 31 covers the second doped semiconductor layer 16, and extends above the first doped semiconductor layer 15 in the direction in which the first regions 12 and the second regions 13 are arranged. An extended-through first conductive window is provided in a portion of the surface passivation layer 31 that corresponds to the first region 12, and at least a portion of the first doped semiconductor layer is exposed at a bottom of the first conductive window 15. An extended-through second conductive window is provided in a portion of the surface passivation layer 31 that corresponds to the second region 13, and at least a portion of the second doped semiconductor layer 16 is exposed at a bottom of the second conductive window.

Specifically, the materials and thicknesses of the surface passivation layer are not specifically limited in the embodiments of the present application, provided that the materials can be used in the back contact solar cell provided in the embodiments of the present application. The surface passivation layer may be a single-layer structure made of only one passivation material, or may be a laminated structure made of a plurality of passivation materials.

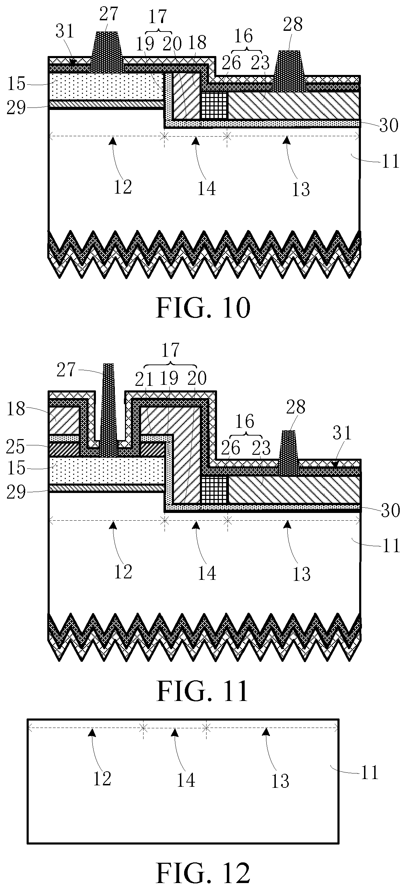

In addition, as shown in FIG. 10 and FIG. 11, the foregoing back contact solar cell may further include an interface passivation layer formed on the side of the light-receiving surface of the semiconductor substrate 11 to passivate surface defects on the side of the light-receiving surface of the semiconductor substrate 11, thereby reducing a carrier recombination rate on the side of the light-receiving surface. A material of the interface passivation layer may include silicon oxide, silicon nitride, aluminum oxide, or any other passivation material. Next, in an actual application procedure, the interface passivation layer and the foregoing surface passivation layer may be formed simultaneously. In this case, the material and the thickness of the interface passivation layer are respectively the same as the material and the thickness of the surface passivation layer. Certainly, the interface passivation layer and the surface passivation layer may alternatively be separately formed in different steps.

In an example, as shown in FIG. 1, the back contact solar cell further includes a first electrode 27 and a second electrode 28. The first electrode 27 is formed on the first doped semiconductor layer 15, and is in ohmic contact with the first doped semiconductor layer 15. The second electrode 28 is formed on the second doped semiconductor layer 16, and is in ohmic contact with the second doped semiconductor layer 16. Specific structures of the first electrode 27 and the second electrode 28 may be determined based on the type of the back contact solar cell.

For example, in a case that the back contact solar cell is a back contact solar cell without a main grid, the first electrode and the second electrode each include a plurality of fingers. In addition, both the fingers included in the first electrode and the fingers included in the second electrode extend in a first direction and are alternately distributed at intervals in a second direction. The first direction is different from the second direction. Specifically, the first direction is an extension direction of the first regions and the second regions, and the second direction is the direction in which the first regions and the second regions are arranged.

For example, in a case that the back contact solar cell is a back contact solar cell with a main grid, the first electrode and the second electrode each include a plurality of fingers and a plurality of busbars. Both the fingers included in the first electrode and the fingers included in the second electrode extend in the first direction and are alternately distributed at intervals in the second direction. The first direction is different from the second direction. Both the busbars included in the first electrode and the busbars included in the second electrode extend in the second direction and are alternately distributed at intervals in the first direction. Each of the busbars is electrically connected to fingers having a same polarity as that of the busbar, and is insulated from fingers having a polarity opposite to that of the busbar.

Specifically, a polarity of the fingers included in the first electrode is opposite to that of the fingers and the busbars included in the second electrode, and is the same as that of the busbars included in the first electrode. Similarly, a polarity of the fingers included in the second electrode is opposite to that of the fingers and the busbars included in the first electrode, and is the same as that of the busbars included in the second electrode. In addition, each busbar may be insulated from a finger having a polarity opposite to that of the busbar by an insulating adhesive or another insulating material. Alternatively, each finger may be a non-continuous finger. In this case, each busbar may be insulated from a finger having a polarity opposite to that of the busbar by a discontinuity provided in the finger.

In addition, in this embodiment of the present application, quantities and topographies of the fingers and the busbars included in the first electrode and the second electrode, a spacing between adjacent fingers, a spacing between adjacent busbars, and the like are not specifically limited, and may be determined according to an actual requirement.

For example, a spacing between two adjacent fingers having opposite polarities may be greater than or equal to 200 µm and less than or equal to 700 µm. For example, the spacing between two adjacent fingers having opposite polarities may be 200 µm, 300 µm, 400 µm, 500 µm, 600 µm, 700 µm, or the like. In this case, a small mitigation degree of a current leakage risk of two adjacent fingers having opposite polarities caused by the spacing being small can be prevented. A high carrier recombination rate of a portion of the back contact solar cell that corresponds to the spacing region caused by a width of the spacing region being large due to the spacing between two adjacent fingers having opposite polarities being large can be further prevented, thereby ensuring high operating performance of the back contact solar cell.

For example, a width of each of the fingers may be greater than or equal to 15 µm and less than or equal to 60 µm. For example, the width of the finger may be 15 µm, 20 µm, 30 µm, 40 µm, 50 µm, 60 µm, or the like. In this case, a large contact resistance between the finger and the corresponding doped semiconductor layer caused by the width of the finger being small can be prevented, thereby improving the contact performance between the finger and the corresponding doped semiconductor layer. In addition, high metal composite content corresponding to the finger caused by a large width of the finger can be further prevented, to reduce a metal composite loss, thereby achieving a balance between the contact performance corresponding to the finger and the metal composite loss.

In an actual application procedure, in a case that the first electrode and the second electrode include the plurality of fingers and the plurality of busbars, the distribution of a structure formed by the first dielectric layer and the second dielectric layer between the first electrode and the second electrode may be determined according to an actual application scenario.

For example, a width, in a width direction of the spacing region, of a part of a structure formed by the first dielectric layer and the second dielectric layer that is between two adjacent fingers having opposite polarities is approximately the same as a thickness of the second doped semiconductor layer. In this case, the second doped semiconductor layer has particular carrier collection efficiency, and needs to have a corresponding thickness. Based on this, when the width, in the width direction of the spacing region, of the part of the structure formed by the first dielectric layer and the second dielectric layer that is between two adjacent fingers having opposite polarities is approximately the same as the thickness of the second doped semiconductor layer, the poor electrical isolation of the structure formed by the first dielectric layer and the second dielectric layer caused by the width of the structure being small can be prevented. Next, the first dielectric layer or the second dielectric layer may be formed based on the same manufacturing process and manufacturing materials during the manufacturing of the second doped semiconductor layer, thereby simplifying the manufacturing procedure of the back contact solar cell.

For example, a width, in a width direction of the spacing region, of a portion of the structure formed by the first dielectric layer and the second dielectric layer that is between a finger and a busbar that have opposite polarities and that are adjacent to each other is approximately the same as a thickness of the second doped semiconductor layer. The beneficial effects in this case are similar to the beneficial effects of the width, in the width direction of the spacing region, of the part of the structure formed by the first dielectric layer and the second dielectric layer that is between two adjacent fingers having opposite polarities being approximately the same as the thickness of the second doped semiconductor layer. Details are not described herein again.

For example, a length, in an extension direction of the spacing region, of a portion of the structure formed by the first dielectric layer and the second dielectric layer that is between two adjacent fingers having opposite polarities may be greater than or equal to 300 µm and less than or equal to 3000 µm. For example, the length, in the extension direction of the spacing region, of the portion of the structure formed by the first dielectric layer and the second dielectric layer that is between two adjacent fingers having opposite polarities may be 300 µm, 500 µm, 1000 µm, 1500 µm, 2000 µm, 25000 µm, 3000 µm, or the like. In this case, the small region in which the first doped semiconductor layer is electrically isolated from the second doped semiconductor layer by the structure formed by the first dielectric layer and the second dielectric layer caused by the length being small can be prevented, thereby ensuring a low leakage current in the back contact solar cell during normal operation.

For example, a length, in an extension direction of the spacing region, of a portion of the structure formed by the first dielectric layer and the second dielectric layer that is between a finger and a busbar that have opposite polarities and that are adjacent to each other may be greater than or equal to 200 µm and less than or equal to 700 µm. For example, the length, in the extension direction of the spacing region, of the portion of the structure formed by the first dielectric layer and the second dielectric layer that is between the finger and the busbar that have opposite polarities and that are adjacent to each other may be 200 µm, 300 µm, 400 µm, 500 µm, 600 µm, 700 µm, or the like. For the beneficial effects in this case, reference may be made to the beneficial effects of the length, in the extension direction of the spacing region, of the portion of the structure formed by the first dielectric layer and the second dielectric layer that is between two adjacent fingers having opposite polarities being greater than or equal to 300 µm and less than or equal to 3000 µm.

It should be noted that, in a case that the back contact solar cell is a back contact solar cell without a main grid, for the width of the structure formed by the first dielectric layer and the second dielectric layer that is between two fingers having opposite polarities, reference may be made to a corresponding width corresponding to the foregoing back contact solar cell with a main grid. Details are not described herein again.

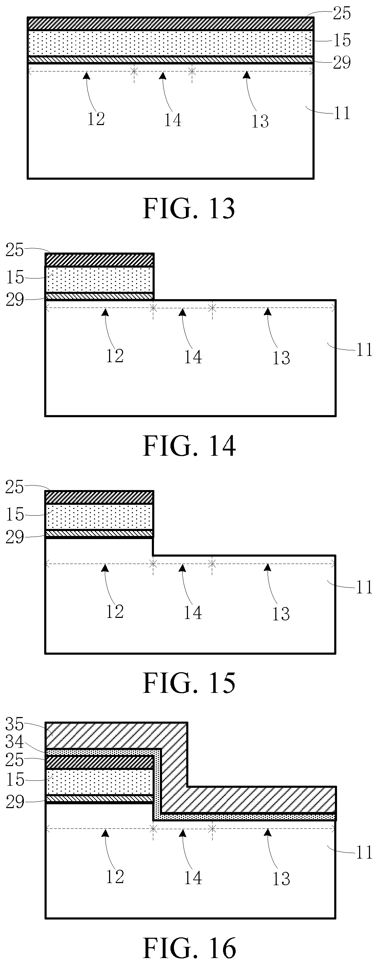

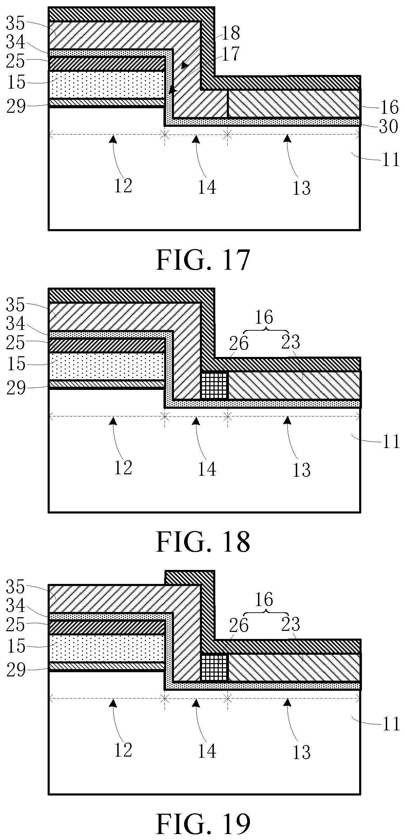

According to a second aspect, an embodiment of the present application provides a method for manufacturing a back contact solar cell. A manufacturing procedure is described below according to cross-sectional views of operations shown in FIG. 12 to FIG. 36. Specifically, the method for manufacturing a back contact solar cell includes the following steps. First, as shown in FIG. 12, a semiconductor substrate 11 is provided, where first regions 12 and second regions 13 that are alternately distributed at intervals and a spacing region 14 that is located between each of the first regions 12 and a second region 13 adjacent to the first region 12 are provided on a back surface of the semiconductor substrate 11. Next, as shown in FIG. 14, a first doped semiconductor layer 15 is formed on the first regions 12 provided on the back surface. Next, as shown in FIG. 18 to FIG. 28, a second doped semiconductor layer 16 is formed at least on the second regions 13 provided on the back surface. A conductivity type of the second doped semiconductor layer 16 is opposite to that of the first doped semiconductor layer 15. Next, as shown in FIG. 18 to FIG. 28, a first dielectric layer 17 and a second dielectric layer 18 are formed at least on the spacing regions 14 provided on the back surface. At least a portion of the first dielectric layer 17 and at least a portion of the second dielectric layer 18 are stacked between the first doped semiconductor layer 15 and the second doped semiconductor layer 16 in the direction in which the first regions 12 and the second regions 13 are arranged. At least a portion of the first dielectric layer 17 is in contact with the first doped semiconductor layer 15, and at least a portion of the second dielectric layer 18 is in contact with the second doped semiconductor layer 16. A material of the first dielectric layer 17 is different from that of the second dielectric layer 18.

Structures of back contact solar cells formed by using the manufacturing method provided in the second aspect of the embodiments of the present application are the same. Therefore, in the manufacturing method, reference may be made to the foregoing descriptions for information such as the material of the semiconductor substrate, the range and the topography of each region on the back surface of the semiconductor substrate, the materials and the formation ranges of the first doped semiconductor layer and the second doped semiconductor layer, and the materials and the formation ranges of the first dielectric layer and the second dielectric layer. Details are not described herein again.

In an actual manufacturing procedure, the forming a first doped semiconductor layer on the first regions provided on the back surface may include the steps: forming the first doped semiconductor layer on the entire back surface and a third dielectric layer that is located on a portion of the first doped semiconductor layer that corresponds to the first region; or forming the first doped semiconductor layer and a third dielectric layer on the entire back surface, performing heat treatment on portions of the third dielectric layer that correspond to the second region and the spacing region by a laser irradiation process, and forming a mask on a portion of the third dielectric layer that corresponds to the first region after the heat treatment; and next, under a mask of the portion of the third dielectric layer that corresponds to the first region, removing portions of the first doped semiconductor layer that correspond to the second region and the spacing region.

Specifically, if the first doped semiconductor layer is directly formed on the first regions provided on the back surface in the manufactured back contact solar cell, an intrinsic semiconductor layer disposed on the entire back surface may be formed by chemical vapor deposition or another process. Then, the intrinsic semiconductor layer may be doped in a manner of diffusion, ion implantation, doping source coating, or the like to enable the intrinsic semiconductor layer to form the first doped semiconductor layer. Then, the third dielectric layer is formed on the portion of the first doped semiconductor layer that corresponds to the first region. When the material of the first doped semiconductor layer includes silicon and the intrinsic semiconductor layer is doped by a diffusion process, at the same time when the first doped semiconductor layer is formed, the third dielectric layer being a doped silicon glass layer is also formed on a side of the first doped semiconductor layer that faces away from the semiconductor substrate. In this case, heat treatment may be performed on the portions of the third dielectric layer that correspond to the second region and the spacing region in a manner of laser irradiation or the like such that the portions of the third dielectric layer that correspond to the second region and the spacing region are looser than the portion of the third dielectric layer that corresponds to the first region. Therefore, after the heat treatment, the mask is formed for the portion of the third dielectric layer that corresponds to the first region, and subsequently, the portions of the third dielectric layer that correspond to the second region and the spacing region may be selectively removed by wet etching or the like. In a case that the material of the third dielectric layer is non-doped silicon glass, processes such as deposition and photolithography may be additionally used to form the third dielectric layer located only on the portion of the first doped semiconductor layer that corresponds to the first region. Next, after the third dielectric layer is formed, under a mask of the third dielectric layer, the portions of the first doped semiconductor layer that correspond to the second region and the spacing region are removed by wet etching or another process, thereby forming the first doped semiconductor layer only on the first regions provided on the back surface.

Alternatively, in an actual manufacturing procedure, the first doped semiconductor layer disposed on the entire back surface may be formed in the foregoing manner. Then, the third dielectric layer may be formed only on the portion of the first doped semiconductor layer that corresponds to the first region by chemical vapor deposition or another process under a mask of a corresponding mask layer or mask.

When the manufactured back contact solar cell includes a first passivation layer, after the providing a semiconductor substrate, and before the forming a second doped semiconductor layer at least on the second regions provided on the back surface, the method for manufacturing a back contact solar cell includes the following step. The first passivation layer and the first doped semiconductor layer on a side of the first passivation layer that faces away from the semiconductor substrate are formed on the first regions.

Specifically, the first passivation layer may be formed only on the first region through deposition, photolithography, or another process before the first doped semiconductor layer is formed. Alternatively, as shown in FIG. 13, a first passivation layer 29 disposed on the entire back surface may be formed before the first doped semiconductor layer 15 is formed. Then, the first doped semiconductor layer 15 disposed on the entire back surface and a third dielectric layer 25 on a portion of the first doped semiconductor layer 15 that corresponds to the first region 12 are formed on the first passivation layer 29 in the foregoing manner. Next, as shown in FIG. 14, under a mask of a portion of the third dielectric layer 25 that corresponds to the first region 12, the first passivation layer 29 and the first doped semiconductor layer 15 are selectively etched simultaneously, thereby simplifying the manufacturing procedure of the back contact solar cell and improving the manufacturing efficiency of the back contact solar cell.

Next, as described above, in a case that the back surface of the semiconductor substrate in the manufactured back contact solar cell has a groove structure, after the forming a first doped semiconductor layer on the first regions provided on the back surface, and before the forming a second doped semiconductor layer at least on the second regions provided on the back surface, the method for manufacturing a back contact solar cell further includes the following step. As shown in FIG. 15, the back surface of the semiconductor substrate 11 is selectively etched to form the groove structure on the back surface, where both the second regions 13 and the spacing regions 14 are located in the groove structure.

Specifically, the back surface of the semiconductor substrate may be selectively etched by dry etching, wet etching, or another process under the mask of the portion of the third dielectric layer that corresponds to the first region to form the groove structure. For the depth of the groove structure, reference may be made to the foregoing text.

It should be noted that, after the first doped semiconductor layer is formed or after the groove structure is formed, the third dielectric layer located above the first region may be kept, or before the second doped semiconductor layer is formed, the portion of the third dielectric layer that corresponds to the first region may be removed.

Next, the second doped semiconductor layer is formed at least on the second regions provided on the back surface. A formation procedure of the second doped semiconductor layer may be determined based on a formation range of the second doped semiconductor layer.

For example, when the second doped semiconductor layer is formed only on the second region, the intrinsic semiconductor layer disposed on the entire back surface may be formed on the first doped semiconductor layer, the spacing regions, and the second regions by chemical vapor deposition or another process. Then, a portion of the intrinsic semiconductor layer that corresponds to the second region is selectively doped such that the second doped semiconductor layer is formed on the portion of the intrinsic semiconductor layer that corresponds to the second region. Whether portions of the intrinsic semiconductor layer that correspond to the first region and the spacing region need to be removed may be determined based on whether the second dielectric layer and the second doped semiconductor layer are integrally continuous. When the second dielectric layer and the second doped semiconductor layer are integrally continuous, at least a portion of the intrinsic semiconductor layer that corresponds to the spacing region needs to be kept, and the second dielectric layer is formed based on at least the portion of the intrinsic semiconductor layer that corresponds to the spacing region. When the second dielectric layer and the second doped semiconductor layer are not integrally continuous, the portions of the intrinsic semiconductor layer that correspond to the first region and the spacing region need to be selectively removed.

Next, in a case that the manufactured back contact solar cell further includes a second passivation layer, after the forming a first doped semiconductor layer on the first regions provided on the back surface, and before the forming a second doped semiconductor layer at least on the second regions provided on the back surface, the method for manufacturing a back contact solar cell further includes the following step. The second passivation layer is at least formed on the second regions provided on the back surface.

Specifically, for a formation procedure of the second passivation layer, reference may be made to the foregoing formation procedure of the first passivation layer. It should be noted that, when the first dielectric layer and the second passivation layer are integrally continuous, at least a portion of a material of which the second passivation layer is made that corresponds to the spacing region needs to be kept. When the first dielectric layer and the second passivation layer are not integrally continuous, portions of the material of which the second passivation layer is made that correspond to the spacing region and the first region need to be selectively removed.

In an actual manufacturing procedure, a formation sequence and a specific formation procedure of the second doped semiconductor layer, the second passivation layer, and the first dielectric layer and the second dielectric layer that are on the back surface may be determined based on formation ranges of the first dielectric layer, the second dielectric layer, and the second doped semiconductor layer, a specific structure of the second doped semiconductor layer, and an actual application scenario described above. Formation procedures of the first dielectric layer, the second dielectric layer, and the second doped semiconductor layer (or the first dielectric layer, the second dielectric layer, the second passivation layer, and the second doped semiconductor layer) are classified into the following four types based on whether the first dielectric layer and the second dielectric layer are respectively integrally continuous with the second passivation layer and the second doped semiconductor layer.

In a first type, the first dielectric layer is not integrally continuous with the second passivation layer, and the second dielectric layer is not integrally continuous with the second doped semiconductor layer.

In a first case, if the first dielectric layer includes only a first dielectric portion, after the first doped semiconductor layer is formed, a first dielectric material layer disposed on the entire back surface may be formed on the first doped semiconductor layer, the spacing regions, and the second regions by chemical vapor deposition or another process. Then, portions of the first dielectric material layer that correspond to the first region and the second region are removed by dry etching, laser etching, or another process. Because a height of a portion of the first dielectric material layer that corresponds to the first doped semiconductor layer is large in a thickness direction of the semiconductor substrate, the portion is kept to form the first dielectric layer.

In the first case, if the first dielectric layer includes only the first dielectric portion and a second dielectric portion, or the first dielectric portion includes only the first dielectric portion and a third dielectric portion, or the first dielectric layer includes the first dielectric portion, the second dielectric portion, and the third dielectric portion, the first dielectric material layer disposed on the entire back surface may be formed on the first doped semiconductor layer, the spacing regions, and the second regions in the foregoing manner. Then, a mask layer is formed on the portion of the first dielectric material layer that is to be kept, and the portions of the first dielectric material layer that are to be removed are selectively removed under a mask of the mask layer. For example, in a case that the first dielectric layer includes only the first dielectric portion and the second dielectric portion, a mask layer needs to be formed on a portion of the first dielectric material layer that corresponds to the spacing region, and the portions of the first dielectric material layer that correspond to the first region and the second region are selectively removed under the mask of the mask layer.

In the first case, for a formation procedure of the second dielectric layer, after the first dielectric layer is formed, a second dielectric material layer disposed on the entire back surface may be formed above the side of the first doped semiconductor layer that faces away from the semiconductor substrate, on a portion of the first dielectric layer that corresponds to the spacing region, and on the second region by chemical vapor deposition or another process. Then, at least a portion of the second dielectric material layer that corresponds to the second region is selectively removed under a mask of a corresponding mask layer.

It should be noted that, when the third dielectric portion and/or the second dielectric layer included in the first dielectric layer further extends above the first region, a first conductive window at least extending through a portion of the third dielectric portion and/or the second dielectric layer that is above the first region further needs to be formed on the first region by laser etching or another process. At least a portion of the first doped semiconductor layer is exposed at a bottom of the first conductive window.

For a formation procedure of the second passivation layer and the second doped semiconductor layer in the first case, reference may be made to the foregoing descriptions.

In a second type, the first dielectric layer is integrally continuous with the second passivation layer, and the second dielectric layer is not integrally continuous with the second doped semiconductor layer.

In a second case, a second passivation material layer disposed on the entire back surface may be formed on the first doped semiconductor layer, the spacing regions, and the second regions by chemical vapor deposition or another process. A portion of the second passivation material layer that corresponds to the second region is the second passivation layer. A portion of the second passivation material layer that corresponds to the spacing region is the first dielectric portion and the second dielectric portion included in the first dielectric layer. Whether a portion of the second passivation material layer that corresponds to the first region needs to be removed needs to be determined based on whether the first dielectric layer includes the third dielectric portion. It may be understood that when the first dielectric layer includes the third dielectric portion, the portion of the second passivation material layer that corresponds to the first region needs to be kept, or otherwise needs to be removed.

For a formation procedure of the second dielectric layer in the second case, reference may be made to the formation procedure of the second dielectric layer in the foregoing first case. For a formation procedure of the second doped semiconductor layer in the second case, reference may be made to the foregoing descriptions.

It should be noted that, when the third dielectric portion and/or the second dielectric layer included in the first dielectric layer further extends above the first region, a first conductive window at least extending through a portion of the third dielectric portion and/or the second dielectric layer that is above the first region further needs to be formed on the first region by laser etching or another process. At least a portion of the first doped semiconductor layer is exposed at a bottom of the first conductive window.

In a third type, the first dielectric layer is not integrally continuous with the second passivation layer, and the second dielectric layer is integrally continuous with the second doped semiconductor layer.

For a formation procedure of the first dielectric layer in a third case, reference may be made to the formation procedure of the first dielectric layer in the foregoing first case. After the first dielectric layer is formed, the second passivation material layer may be formed on the entire back surface by chemical vapor deposition or another process. Then, under a mask of a corresponding mask layer or a mask, portions of the second passivation material layer that correspond to the first region and at least some spacing regions are selectively removed such that a remaining portion of the second passivation material layer forms the second dielectric layer.

In the third case, for a formation procedure of the second dielectric layer, after the second passivation layer is formed, an intrinsic semiconductor layer disposed on the entire back surface may be formed above the side of the first doped semiconductor layer that faces away from the semiconductor substrate, on a portion of the first dielectric layer that corresponds to the spacing region, and on the second passivation layer by chemical vapor deposition or another process. Then, the portion of the intrinsic semiconductor layer that corresponds to the second region is selectively doped. After the selective doping, a portion of the intrinsic semiconductor layer that only corresponds to the second region may form the second doped semiconductor layer, or, after the selective doping, the dopant is doped into the portion of the intrinsic semiconductor layer that corresponds to the second region, and is also doped, in a manner of diffusion, into portions of the intrinsic semiconductor layer that are located in some spacing regions such that the portions of the intrinsic semiconductor layer that correspond to the second region and some spacing regions form a first doped portion and a third doped portion included in the second doped semiconductor layer.

In a case that the second doped semiconductor layer further includes a second doped portion, after the intrinsic semiconductor layer is formed, and before the portion of the intrinsic semiconductor layer that corresponds to the second region is selectively doped, light doping needs to be performed on a side of the intrinsic semiconductor layer that faces away from the semiconductor substrate to form the second doped portion.

In the third case, in a portion of the intrinsic semiconductor layer that corresponds to the first region after the second doped semiconductor layer is formed, when the second dielectric layer in the manufactured back contact solar cell does not extend onto the first region, the portion of the intrinsic semiconductor layer that corresponds to the first region needs to be removed after the second doped semiconductor layer is formed. If the second dielectric layer extends to the first region and the second doped portion does not extend to the first region, only a portion of the intrinsic semiconductor layer that is opposite in an extension direction of the second doped portion and that is located above the first region needs to be removed after the second doped semiconductor layer is formed. If both the second dielectric layer and the second doped portion extend above the first region, a portion of the intrinsic semiconductor layer that corresponds to an upper portion of the first region needs to be kept after the second doped semiconductor layer is formed.

In a fourth type, the first dielectric layer is integrally continuous with the second passivation layer, and the second dielectric layer is integrally continuous with the second doped semiconductor layer.

In a fourth case, the forming a second doped semiconductor layer, a second passivation layer, a first dielectric layer, and a second dielectric layer may include the following step: as shown in FIG. 16, sequentially forming, in a thickness direction of the semiconductor substrate 11, a passivation material layer 34 and an intrinsic semiconductor layer 35 that are stacked over the first doped semiconductor layer 15, the spacing regions 14, and the second regions 13. Next, as shown in FIG. 17, the portion of the intrinsic semiconductor layer that corresponds to the second region 13 is selectively doped. After the selective doping, the second doped semiconductor layer 16 is formed in the portion of the intrinsic semiconductor layer that corresponds to at least the second region 13, the second dielectric layer 18 is formed in portions of the intrinsic semiconductor layer that correspond to at least some spacing regions 14, the second passivation layer 30 is formed in a portion of the passivation material layer that is located between the second doped semiconductor layer 16 and the semiconductor substrate 11, and the first dielectric layer 17 is formed in portions of the passivation material layer that correspond to at least some spacing regions 14.

In the fourth case, the passivation material layer and the intrinsic semiconductor layer may be formed by chemical vapor deposition or another process. Then, under a mask of a corresponding mask layer or mask, the portion of the intrinsic semiconductor layer that corresponds to the second region may be selectively doped by diffusion, ion implantation, doping source coating, or another process. As shown in FIG. 17, in a case that the material of the intrinsic semiconductor layer includes silicon and the selective doping is performed by a diffusion process, after the second doped semiconductor layer 16 is formed, a corresponding doped silicon glass layer is formed at least on a side of the second doped semiconductor layer 16 that faces away from the semiconductor substrate. In addition, after the selective doping is performed, the doped silicon glass layer may be removed by a process such as wet etching.

Specifically, after the selective doping is performed on the portion of the intrinsic semiconductor layer that corresponds to the second region, whether to remove portions of the intrinsic semiconductor layer and the passivation material layer that correspond to the first region needs to be determined based on formation ranges of the first dielectric layer and the second dielectric layer.

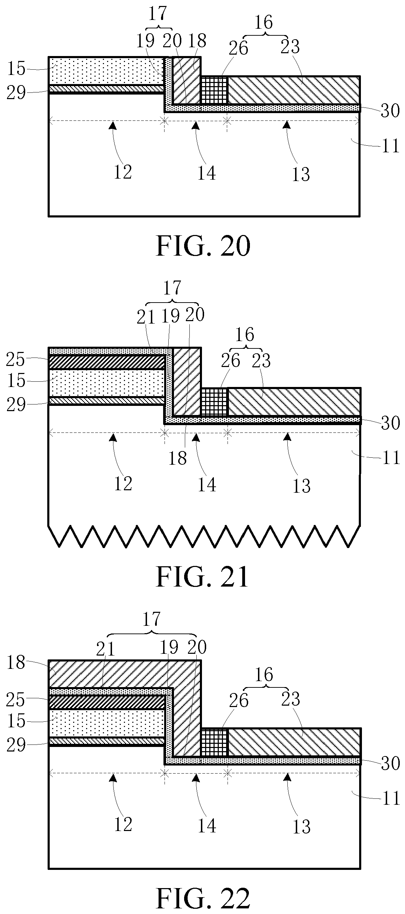

For example, when none of the first dielectric layer, the second dielectric layer, and the second doped semiconductor layer extends onto the first region, as shown in FIG. 20, after the portion of the intrinsic semiconductor layer that corresponds to the second region 13 is selectively doped, the foregoing method for manufacturing a back contact solar cell further includes the following step: selectively removing portions of the intrinsic semiconductor layer and the passivation material layer that correspond to the first region 12. Next, the portion of the third dielectric layer that corresponds to the first region is removed. The structure of the back contact solar cell manufactured in this case is simple, and difficulty in subsequently forming the first conductive window can be reduced, thereby helping improve the yield of the back contact solar cell.

For another example, in a case that the first dielectric layer includes the third dielectric portion and the second dielectric layer does not extend onto the first region, after the portion of the intrinsic semiconductor layer that corresponds to the second region is selectively doped, the portion of the intrinsic semiconductor layer that corresponds to the first region needs to be selectively removed, and a portion of the passivation material layer that corresponds to the first region is kept. Next, a first conductive window extending through the third dielectric layer and the passivation material layer is formed above the first regions.

For yet another example, in a case that the first dielectric layer includes the third dielectric portion and the second dielectric layer extends onto the third dielectric portion, after the portion of the intrinsic semiconductor layer that corresponds to the second region is selectively doped, the portion of the passivation material layer that corresponds to the first region and the portion of the intrinsic semiconductor layer that corresponds to the first region need to be kept. Next, a first conductive window extending through the third dielectric layer, the passivation material layer, and the intrinsic semiconductor layer are formed above the first regions.

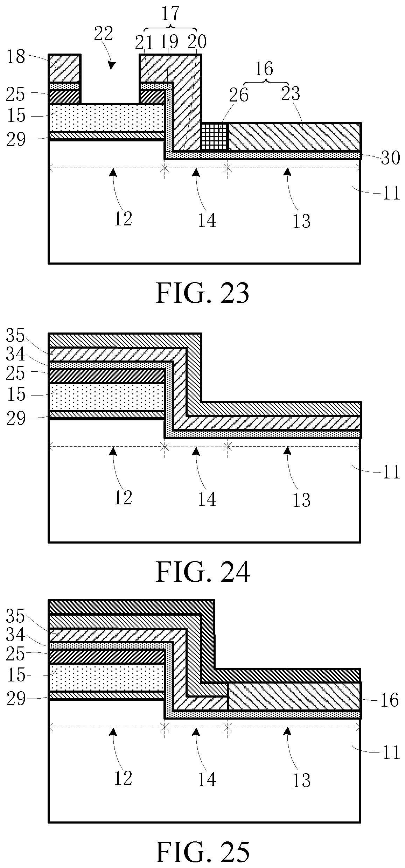

In addition, in an actual manufacturing procedure, after the sequentially forming, in a thickness direction of the semiconductor substrate, a passivation material layer and an intrinsic semiconductor layer that are stacked over the first doped semiconductor layer, the spacing regions, and the second regions, and before the selectively doping a portion of the intrinsic semiconductor layer that corresponds to the second region, the foregoing method for manufacturing a back contact solar cell may further include the following step: as shown in FIG. 24, lightly doping a side of the intrinsic semiconductor layer that faces away from the semiconductor substrate 11, to form a second doped portion 24 included in the second doped semiconductor layer 16. In this case, after the light doping and the selective doping, whether to remove portions of the intrinsic semiconductor layer and the passivation material layer that correspond to the first region needs to be determined based on formation ranges of the first dielectric layer, the second dielectric layer, and the second doped portion.

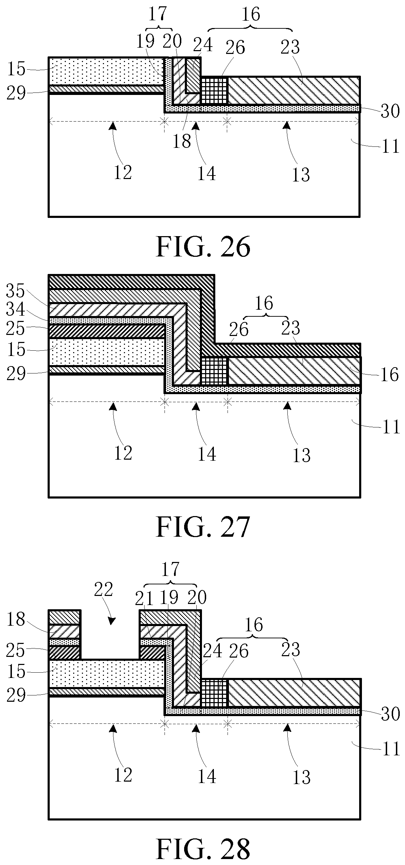

For example, when none of the first dielectric layer, the second dielectric layer, and the second doped semiconductor layer extends onto the first region, as shown in FIG. 26, after the portion of the intrinsic semiconductor layer that corresponds to the second region 13 is selectively doped, the foregoing method for manufacturing a back contact solar cell further includes the following step: selectively removing the portions of the intrinsic semiconductor layer and the passivation material layer that correspond to the first region 12. Next, the portion of the third dielectric layer that corresponds to the first region is removed.

For another example, in a case that the first dielectric layer includes the third dielectric portion and the second dielectric layer and the second doped portion sequentially extend onto the third dielectric portion, as shown in FIG. 27, after the portion of the intrinsic semiconductor layer that corresponds to the second region 13 is selectively doped, the portion of the passivation material layer that corresponds to the first region 12 and the portion of the intrinsic semiconductor layer that corresponds to the first region 12 after the light doping need to be kept. Next, as shown in FIG. 28, a first conductive window 22 extending through the third dielectric layer 25, the passivation material layer (the portion of the passivation material layer that corresponds to the first region is the third dielectric portion 21), and the intrinsic semiconductor layer after the light doping (a portion of the intrinsic semiconductor layer that corresponds to the first region after the light doping includes a portion of the second dielectric layer 18 that extends to the first region and a portion of the second doped portion 24 that extends to the first region) is formed above the first region 12.

It can be known from the foregoing manufacturing procedures of the first case to the fourth case and the structures shown in FIG. 16 to FIG. 28 that, in different cases, formation ranges of the first dielectric layer 17, the second dielectric layer 18, and the second doped semiconductor layer 16 may be different, and corresponding selective etching ranges and formation ranges and manners may be different. Therefore, a suitable manner may be selected according to requirements on the formation ranges of the first dielectric layer 17, the second dielectric layer 18, and the second doped semiconductor layer 16, selective etching ranges, and the like in actual application scenarios to manufacture the first dielectric layer 17, the second dielectric layer 18, and the second doped semiconductor layer 16.

In addition, in a case that the manufactured back contact solar cell further includes a conductive structure, at the same time when the portion of the intrinsic semiconductor layer that corresponds to the second region is selectively doped, a portion of the intrinsic semiconductor layer that is located at least at a discontinuity is also selectively doped such that the conductive structure is formed at the portion of the intrinsic semiconductor layer that is located at least at the discontinuity. Alternatively, in an actual manufacturing procedure, after the first dielectric layer and the second dielectric layer are formed, portions of the first dielectric layer and the second dielectric layer that correspond to the discontinuity may be selectively removed, and then deposition or another process is used to form the conductive structure at the discontinuity. Reference may be made to the foregoing descriptions for the material, the conductivity type, and the like of the conductive structure.

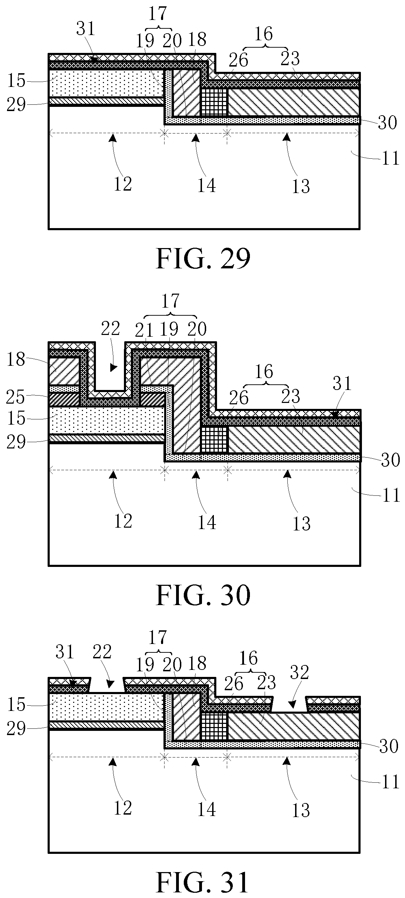

Next, in a case that the back contact solar cell further includes a surface passivation layer, after the forming a first dielectric layer and a second dielectric layer at least on the spacing regions provided on the back surface, the method for manufacturing a back contact solar cell further includes the following steps. As shown in FIG. 29 and FIG. 30, a surface passivation layer 31 is formed on the back surface, where the surface passivation layer 31 covers the second doped semiconductor layer 16, and extends above the first doped semiconductor layer 15 in the direction in which the first regions 12 and the second regions 13 are arranged. Next, as shown in FIG. 31 to FIG. 33, an extended-through first conductive window 22 is opened in a portion of the surface passivation layer 31 that corresponds to the first region 12, and an extended-through second conductive window 32 is opened in a portion of the surface passivation layer 31 that corresponds to the second region 13, where at least a portion of the first doped semiconductor layer 15 is exposed at a bottom of the first conductive window 22, and at least a portion of the second doped semiconductor layer 16 is exposed at a bottom of the second conductive window 32.

For the material and the thickness of the surface passivation layer, reference may be made to the foregoing descriptions. Details are not described herein again. In addition, the surface passivation layer disposed on the entire back surface may be formed by chemical vapor deposition or another process. Then, the extended-through first conductive window and second conductive window may be respectively at least opened in portions of the surface passivation layer that correspond to the first region and the second region by laser etching or the like.

It should be noted that, as shown in FIG. 27, when a film layer formed on the first doped semiconductor layer 15 has a large thickness, before the surface passivation layer 31 is formed, the corresponding film layer located on the first doped semiconductor layer 15 is first selectively etched by laser etching or the like to form an extended-through contact window.

In addition, when the back contact solar cell further includes an interface passivation layer on a side of a light-receiving surface, the interface passivation layer may be formed on the side of the light-receiving surface at the same time when the surface passivation layer is formed. Alternatively, before the surface passivation layer is formed, or after the surface passivation layer is formed, the interface passivation layer may be additionally formed on the side of the light-receiving surface by chemical vapor deposition or another process.

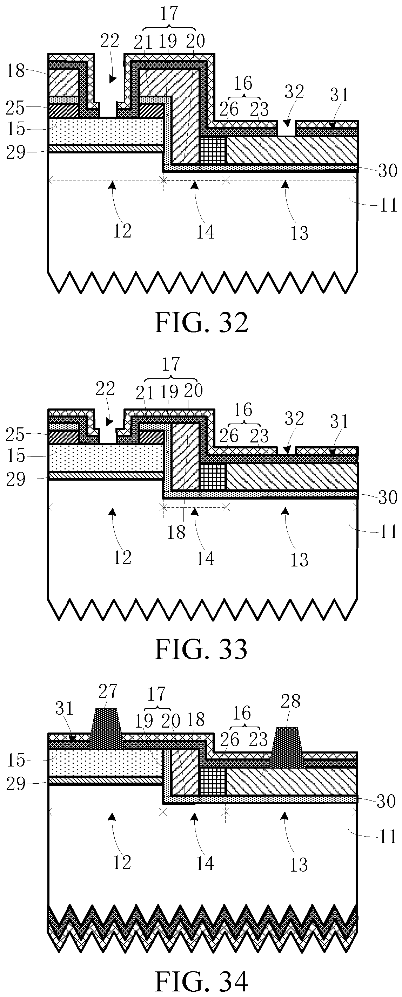

Next, as shown in FIG. 34 to FIG. 36, a first electrode 27 may be formed at least in the first conductive window and a second electrode 28 may be formed at least in the second conductive window in a manner of screen printing, electroplating, sputtering, or evaporation.

For beneficial effects of the second aspect and various implementations of the second aspect in this embodiment of the present application, reference may be made to the analysis of the beneficial effects of the first aspect and various implementations of the first aspect. Details are not described herein.

### Embodiment 1

A method for manufacturing a back contact solar cell may include the following steps.
1. Polish and clean two surfaces of an unprocessed silicon wafer. In addition, a planarized pyramid base structure is formed on a back surface, and a one-dimensional size of the planarized pyramid base structure is greater than or equal to 0.5 µm and less than or equal to 20 µm.
2. Deposit a tunnel silicon oxide layer (used for subsequently forming a first passivation layer) and an undoped polycrystalline silicon layer (used for subsequently forming a first doped semiconductor layer) on a surface of a side of the clean silicon wafer. A thickness of the tunnel silicon oxide layer is greater than or equal to 1 nm and less than or equal to 3 nm. A thickness of the undoped polycrystalline silicon layer is greater than or equal to 100 nm and less than or equal to 400 nm. A width of the undoped polycrystalline silicon layer in a direction in which first regions and second regions are arranged is greater than or equal to 200 µm and less than or equal to 700 µm.
3. As shown in FIG. 13, the undoped polycrystalline silicon layer is doped in a manner of diffusion or annealing and at the same time crystallized, to enable the undoped polycrystalline silicon layer to form a doped polycrystalline silicon layer. A doping concentration in the doped polycrystalline silicon layer is greater than or equal to 5×10¹⁸ cm⁻³ and less than or equal to 5×10²⁰ cm⁻³. A crystallinity in the doped polycrystalline silicon layer is greater than or equal to 83% and less than or equal to 100%. After the crystallization, an oxidation byproduct layer (used for subsequently forming a third dielectric layer) covers a surface of the doped polycrystalline silicon layer. A thickness of the oxidation byproduct layer is greater than or equal to 15 nm and less than or equal to 80 nm. In this case, a porosity of the tunnel silicon oxide layer is 1: 1500, and a gradient range of a doping concentration in the tunnel silicon oxide layer is between 1×10¹⁵ cm⁻³ and 5×10²⁰ cm⁻³.
4. As shown in FIG. 14, portions of the tunnel silicon oxide layer and the doped polycrystalline silicon layer that correspond to a spacing region 14 and a second region 13 are removed by using a non-mask patterning method (for example, by laser opening, a corrosive slurry printing method, or a protective slurry printing method). A remaining portion of the tunnel silicon oxide layer that is in a first region 12 forms a first passivation layer 29, and a remaining portion of the doped polycrystalline silicon layer that is in the first region 12 forms a first doped semiconductor layer 15. In addition, a planarized pyramid base structure is formed on surfaces of the spacing region 14 and the second region 13, and a one-dimensional size of the planarized pyramid base structure is greater than or equal to 10 µm and less than or equal to 50 µm.
5. As shown in FIG. 16, a tunnel oxide layer (used for subsequently forming a second passivation layer and a first dielectric layer) and an undoped polycrystalline silicon layer (used for subsequently forming a second doped semiconductor layer and a second dielectric layer) are deposited on an entire surface of a side of the silicon wafer on which the first doped semiconductor layer 15 is formed. A width of an undoped polycrystalline silicon layer covering a lateral size of the first doped semiconductor layer 15 that is close to the spacing region 14 is greater than or equal to 80 nm and less than or equal to 300 nm. A thickness of the tunnel oxide layer is greater than or equal to 1 nm and less than or equal to 3 nm, and a thickness of the undoped polycrystalline silicon layer is greater than or equal to 80 nm and less than or equal to 300 nm.
6. As shown in FIG. 17, a portion of the undoped polycrystalline silicon layer that corresponds to the second region 13 is locally doped by using a non-mask doping method (for example, by ion implantation, doped slurry printing, laser doping, or high-temperature annealing), and is at the same time crystallized. After the processing, a portion of the polycrystalline silicon layer that corresponds to the local doping forms a second doped semiconductor layer 16, and a portion of the tunnel oxide layer that is located between the second doped semiconductor layer 16 and the silicon wafer forms a second passivation layer 30. A crystallinity in the second doped semiconductor layer 16 is greater than or equal to 83% and less than or equal to 100%. In addition, the second doped semiconductor layer 16 includes a first doped portion 23 and a third doped portion 26, and a width of the third doped portion 26 is approximately between 10 nm and 2000 nm. A doping concentration of a dopant in the third doped portion 26 gradually decreases toward a second dielectric layer 18, and a gradient range in the third doped portion 26 is between 1×10¹⁵ cm⁻³ and 5×10²¹ cm⁻³. A width ratio of the third doped portion 26 to the first doped portion ranges from 1:20000 to 2:700. A porosity of the tunnel oxide layer is 1: 1000 (i.e., 1000 pores per square millimeter). After the local doping, a porosity of a portion of the tunnel oxide layer that corresponds to the second region 13 may be the same as or different from that of a portion of the tunnel oxide layer that corresponds to the spacing region 14. An oxidation byproduct layer covers an entire surface during crystallization, and a thickness of the oxidation byproduct layer is greater than or equal to 30 nm and less than or equal to 100 nm.
7. A third dielectric layer located at a top of the first doped semiconductor layer is removed by using a non-mask patterning method (for example, by laser opening, or a corrosive slurry printing method).
8. An anti-reflection textured surface is manufactured on a light-receiving surface of the silicon wafer. In addition, as shown in FIG. 20, the tunnel oxide layer and the undoped polycrystalline silicon layer at the top of the first doped semiconductor layer is removed.
9. A surface passivation layer is formed on each of the light-receiving surface and the back surface of the silicon wafer.
10. As shown in FIG. 3, metal electrodes, i.e., a first electrode 27 and a second electrode 28, are printed at a top of the first doped semiconductor layer 15 and a top of the second doped semiconductor layer 16. A distance between the first electrode 27 and the second electrode 28 ranges from 200 µm to 700 µm.

### Embodiment 2

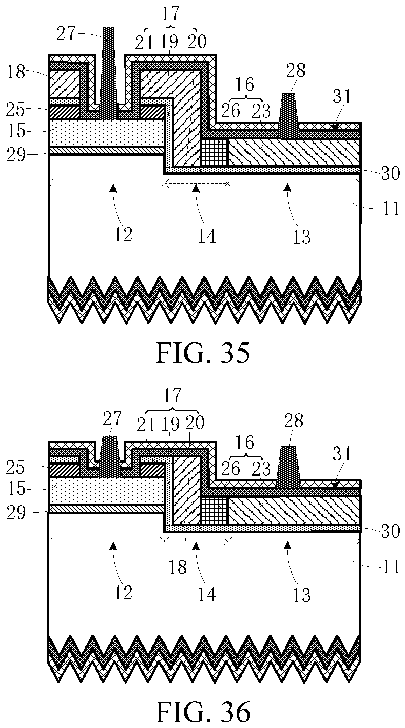

A method for manufacturing a back contact solar cell may include the following steps.
1. Polish and clean two surfaces of an unprocessed silicon wafer. In addition, a planarized pyramid base structure is formed on a back surface, and a one-dimensional size of the planarized pyramid base structure is greater than or equal to 0.5 µm and less than or equal to 20 µm.
2. Deposit a tunnel silicon oxide layer (used for subsequently forming a first passivation layer) and an undoped polycrystalline silicon layer (used for subsequently forming a first doped semiconductor layer) on a surface of a side of the clean silicon wafer. A thickness of the undoped polycrystalline silicon layer is greater than or equal to 100 nm and less than or equal to 400 nm. A width of the undoped polycrystalline silicon layer in a direction in which first regions and second regions are arranged is greater than or equal to 200 µm and less than or equal to 700 µm. A thickness of the tunnel silicon oxide layer is greater than or equal to 1 nm and less than or equal to 3 nm.
3. As shown in FIG. 13, the undoped polycrystalline silicon layer is doped in a manner of diffusion or annealing and at the same time crystallized. A doping concentration in the doped polycrystalline silicon layer is greater than or equal to 5×10¹⁸ cm⁻³ and less than or equal to 5×10²⁰ cm⁻³. A crystallinity in the doped polycrystalline silicon layer is greater than or equal to 83% and less than or equal to 100%. After the crystallization, an oxidation byproduct layer (used for subsequently forming a third dielectric layer) covers a surface of the doped polycrystalline silicon layer. A thickness of the oxidation byproduct layer is greater than or equal to 15 nm and less than or equal to 80 nm. In this case, a porosity of the tunnel silicon oxide layer is 1: 1500, and a gradient range of a doping concentration in the tunnel silicon oxide layer is between 1×10¹⁵ cm⁻³ and 5×10²⁰ cm⁻³.
4. As shown in FIG. 14, portions of the tunnel silicon oxide layer and the doped polycrystalline silicon layer that correspond to a spacing region 14 and a second region 13 are removed by using a non-mask patterning method (for example, by laser opening, a corrosive slurry printing method, or a protective slurry printing method). A remaining portion of the tunnel silicon oxide layer that is in a first region 12 forms a first passivation layer 29, and a remaining portion of the doped polycrystalline silicon layer that is in the first region 12 forms a first doped semiconductor layer 15. In addition, a planarized pyramid base structure is formed on surfaces of the spacing region 14 and the second region 13, and a one-dimensional size of the planarized pyramid base structure is greater than or equal to 10 µm and less than or equal to 50 µm.
5. As shown in FIG. 16, a tunnel oxide layer (used for subsequently forming a second passivation layer and a first dielectric layer) and an undoped polycrystalline silicon layer (used for subsequently forming a second doped semiconductor layer and a second dielectric layer) are deposited on an entire surface of a side of the silicon wafer on which the first doped semiconductor layer 15 is formed. A width of an undoped polycrystalline silicon layer covering a lateral size of the first doped semiconductor layer 15 that is close to the spacing region 14 is greater than or equal to 80 nm and less than or equal to 300 nm. A thickness of the tunnel oxide layer is greater than or equal to 1 nm and less than or equal to 3 nm, and a thickness of the undoped polycrystalline silicon layer is greater than or equal to 80 nm and less than or equal to 300 nm.
6. As shown in FIG. 17, a portion of the undoped polycrystalline silicon layer that corresponds to the second region 13 is locally doped by using a non-mask doping method (for example, by ion implantation, doped slurry printing, laser doping, or high-temperature annealing), and is at the same time crystallized. After the processing, a portion of the polycrystalline silicon layer that corresponds to the local doping forms a second doped semiconductor layer 16, and portions of the polycrystalline silicon layer that correspond to the first region and some spacing regions form a second dielectric layer 18. A portion of the tunnel oxide layer that is located between the second doped semiconductor layer 16 and the silicon wafer forms a second passivation layer 30, and portions of the tunnel oxide layer that correspond to the spacing region and the first region form a first dielectric layer 17. A crystallinity in the second doped semiconductor layer 16 is greater than or equal to 83% and less than or equal to 100%. In addition, the second doped semiconductor layer 16 includes a first doped portion 23 and a third doped portion 26, and a width of the third doped portion 26 is approximately between 10 nm and 2000 nm. A doping concentration of a dopant in the third doped portion 26 gradually decreases toward the second dielectric layer 18, and a gradient range in the third doped portion 26 is between 1×10¹⁵ cm⁻³ and 5×10²¹ cm⁻³. A width ratio of the third doped portion 26 to the first doped portion ranges from 1:20000 to 2:700. A porosity of the tunnel oxide layer is 1:1000 (i.e., 1000 pores per square millimeter). After the local doping, a porosity of a portion of the tunnel oxide layer that corresponds to the second region 13 may be the same as or different from that of a portion of the tunnel oxide layer that corresponds to the spacing region 14. An oxidation byproduct layer covers an entire surface during crystallization, and a thickness of the oxidation byproduct layer is greater than or equal to 30 nm and less than or equal to 100 nm.
7. As shown in FIG. 28, a third dielectric layer 25, the tunnel oxide layer, and the undoped polycrystalline silicon layer that are at a top of the first doped semiconductor layer 15 are locally opened by using a non-mask patterning method (for example, by laser opening, or a corrosive slurry printing method), and the third dielectric layer 25 is kept. An opening width ranges between 20 µm and 120 µm. A width of a portion of the third dielectric layer 25 that is located on at least one side of a window is greater than or equal to 40 µm and less than or equal to 220 µm, and widths of portions of the third dielectric layer 25 that are located on two sides of the window are equal. In this case, in the manufacturing method provided in Embodiment 2, the third dielectric layer 25, the tunnel oxide layer, and the undoped polycrystalline silicon layer that are at the top of the first doped semiconductor layer 15 are not removed. Instead, the third dielectric layer 25, the tunnel oxide layer, and the undoped polycrystalline silicon layer that are at the top of the first doped semiconductor layer 15 are locally opened to form an extended-through window, thereby improving the production capacity of patterning in this step and improving the manufacturing efficiency of the back contact solar cell without affecting the operating performance of the back contact solar cell.
8. An anti-reflection textured surface is manufactured on a light-receiving surface of the silicon wafer, and an exposed oxidation byproduct layer is removed during the texturing.
9. A surface passivation layer is formed on each of the light-receiving surface and the back surface of the silicon wafer.
10. As shown in FIG. 35, metal electrodes, i.e., a first electrode 27 and a second electrode 28, are printed at a top of the first doped semiconductor layer 15 and a top of the second doped semiconductor layer 16. A distance between the first electrode 27 and the second electrode 28 ranges from 200 µm to 700 µm.

### Embodiment 3

A method for manufacturing a back contact solar cell may include the following steps.
1. Polish and clean two surfaces of an unprocessed silicon wafer. In addition, a planarized pyramid base structure is formed on a side of a back surface, and a one-dimensional size of the planarized pyramid base structure is greater than or equal to 0.5 µm and less than or equal to 20 µm.
2. Deposit a tunnel silicon oxide layer (used for subsequently forming a first passivation layer) and an undoped polycrystalline silicon layer (used for subsequently forming a first doped semiconductor layer) on a surface of a side of the clean silicon wafer. A thickness of the undoped polycrystalline silicon layer is greater than or equal to 100 nm and less than or equal to 400 nm. A width of the undoped polycrystalline silicon layer in a direction in which first regions and second regions are arranged is greater than or equal to 200 µm and less than or equal to 700 µm. A thickness of the tunnel silicon oxide layer is greater than or equal to 1 nm and less than or equal to 3 nm.
3. As shown in FIG. 13, the undoped polycrystalline silicon layer is doped in a manner of diffusion or annealing and at the same time crystallized. A doping concentration in the doped polycrystalline silicon layer is greater than or equal to 5×10¹⁸ cm⁻³ and less than or equal to 5×10²⁰ cm⁻³. A crystallinity in the doped polycrystalline silicon layer is greater than or equal to 83% and less than or equal to 100%. After the crystallization, an oxidation byproduct layer (used for subsequently forming a third dielectric layer) covers a surface of the doped polycrystalline silicon layer. A thickness of the oxidation byproduct layer is greater than or equal to 15 nm and less than or equal to 80 nm. In this case, a porosity of the tunnel silicon oxide layer is 1: 1500, and a gradient range of a doping concentration in the tunnel silicon oxide layer is between 1×10¹⁵ cm⁻³ and 5×10²⁰ cm⁻³.
4. As shown in FIG. 14, portions of the tunnel silicon oxide layer and the doped polycrystalline silicon layer that correspond to a spacing region 14 and a second region 13 are removed by using a non-mask patterning method (for example, by laser opening, a corrosive slurry printing method, or a protective slurry printing method). A remaining portion of the tunnel silicon oxide layer that is in a first region 12 forms a first passivation layer 29, and a remaining portion of the doped polycrystalline silicon layer that is in the first region 12 forms a first doped semiconductor layer 15. In addition, a planarized pyramid base structure is formed on surfaces of the spacing region 14 and the second region 13, and a one-dimensional size of the planarized pyramid base structure is greater than or equal to 10 µm and less than or equal to 50 µm.
5. As shown in FIG. 16, a tunnel oxide layer (used for subsequently forming a second passivation layer and a first dielectric layer) and an undoped polycrystalline silicon layer (used for subsequently forming a second doped semiconductor layer and a second dielectric layer) are deposited on an entire surface of a side of the silicon wafer on which the first doped semiconductor layer 15 is formed. A width of an undoped polycrystalline silicon layer covering a lateral size of the first doped semiconductor layer 15 that is close to the spacing region 14 is greater than or equal to 80 nm and less than or equal to 300 nm. A thickness of the tunnel oxide layer is greater than or equal to 1 nm and less than or equal to 3 nm, and a thickness of the undoped polycrystalline silicon layer is greater than or equal to 80 nm and less than or equal to 300 nm.
6. As shown in FIG. 24 and FIG. 25, the undoped polycrystalline silicon layer is lightly doped by using a non-mask doping method (for example, by ion implantation, doped slurry printing, laser doping, or high-temperature annealing). After annealing, a doping depth is greater than or equal to 40 nm and less than or equal to 150 nm, and a doping concentration is greater than or equal to 5×10¹⁸ cm⁻³ and less than or equal to 1×10²⁰ cm⁻³. A width of the undoped polycrystalline silicon layer below the lightly doped portion is between 40 nm and 150 nm. Then, a portion of the polycrystalline silicon layer that corresponds to the second region 13 forms local heavy doping and is at the same time crystallized. After the processing, a portion of the polycrystalline silicon layer that corresponds to the local heavy doping forms a second doped semiconductor layer 16, and portions of the polycrystalline silicon layer that correspond to the first region and some spacing regions form a second dielectric layer 18. A portion of the tunnel oxide layer that is located between the second doped semiconductor layer 16 and the silicon wafer forms a second passivation layer 30, and portions of the tunnel oxide layer that correspond to the spacing region and the first region form a first dielectric layer 17. A crystallinity in the second doped semiconductor layer 16 is greater than or equal to 83% and less than or equal to 100%. In addition, the second doped semiconductor layer 16 includes a first doped portion 23, a second doped portion 24, and a third doped portion 26, and a width of the third doped portion 26 is approximately between 10 nm and 2000 nm. A doping concentration of a dopant in the third doped portion 26 gradually decreases toward the second dielectric layer 18, and a gradient range in the third doped portion 26 is between 1×10¹⁵ cm⁻³ and 5×10²¹ cm⁻³. A width ratio of the third doped portion 26 to the first doped portion ranges from 1:20000 to 2:700. A porosity of the tunnel oxide layer is 1:1000 (i.e., 1000 pores per square millimeter). After the local doping, a porosity of a portion of the tunnel oxide layer that corresponds to the second region 13 may be the same as or different from that of a portion of the tunnel oxide layer that corresponds to the spacing region 14. An oxidation byproduct layer covers an entire surface during crystallization, and a thickness of the oxidation byproduct layer is greater than or equal to 30 nm and less than or equal to 100 nm.
7. A third dielectric layer, the tunnel oxide layer, and the undoped polycrystalline silicon layer that are at a top of the first doped semiconductor layer are locally opened by using a non-mask patterning method (for example, by laser opening, or a corrosive slurry printing method), and the third dielectric layer is kept. An opening width ranges between 20 µm and 120 µm. A width of a portion of the third dielectric layer that is located on at least one side of a window is greater than or equal to 40 µm and less than or equal to 220 µm, and widths of portions of the third dielectric layer that are located on two sides of the window are equal.
8. An anti-reflection textured surface is manufactured on a light-receiving surface of the silicon wafer, and an exposed oxidation byproduct layer is removed during the texturing.
9. As shown in FIG. 30, a surface passivation layer 31 is formed on each of the light-receiving surface and the back surface of the silicon wafer.
10. As shown in FIG. 9, metal electrodes, i.e., a first electrode 27 and a second electrode 28, are printed at a top of the first doped semiconductor layer 15 and a top of the second doped semiconductor layer 16. A distance between the first electrode 27 and the second electrode 28 ranges from 200 µm to 700 µm.

It should be noted that, a difference between the foregoing Embodiment 2 and Embodiment 1 lies in the following. As shown in FIG. 20, in Embodiment 1, after the polycrystalline silicon layer for manufacturing the second doped semiconductor layer is selectively doped, the third dielectric layer, the tunnel oxide layer, and a portion of the polycrystalline silicon layer that corresponds to the first region are selectively removed. As shown in FIG. 22, in Embodiment 2, after the polycrystalline silicon layer of the second doped semiconductor layer is selectively doped, the third dielectric layer, the tunnel oxide layer, and the portion of the polycrystalline silicon layer that corresponds to the first region are kept, and a first conductive window that penetrates the third dielectric layer, the tunnel oxide layer, and the portion of the polycrystalline silicon layer that corresponds to the first region is formed.

A difference between Embodiment 3 and Embodiment 2 lies in the following. In the manufacturing method corresponding to Embodiment 2, after the polycrystalline silicon layer used for manufacturing the second doped semiconductor layer is formed, and before the portion of the polycrystalline silicon layer that corresponds to the second region is selectively doped, a side of the polycrystalline silicon layer that faces away from the semiconductor substrate is not lightly doped. In the manufacturing method corresponding to Embodiment 3, after the polycrystalline silicon layer used for manufacturing the second doped semiconductor layer is formed, and before the portion of the polycrystalline silicon layer that corresponds to the second region is selectively doped, a side of the polycrystalline silicon layer that faces away from the semiconductor substrate needs to be lightly doped.

In the foregoing description, technical details such as pattering and etching of the layers are not described in detail. However, a person skilled in the art should understand that the layer, the region, and the like of a required shape may be formed by using various technical means. In addition, to form a same structure, a person skilled in the art may design a method that is not completely the same as the method described above. In addition, although the foregoing describes the embodiments separately, it does not mean that measures in the embodiments cannot be favorably combined.

The embodiments of the present disclosure are described above. However, the embodiments are merely for illustrative purposes and are not intended to limit the scope of the present disclosure. The scope of the present disclosure is defined by the appended claims and equivalents thereof. A person skilled in the art may make various substitutes and modifications without departing from the scope of the present disclosure, and the substitutes and modifications shall fall within the scope of the present disclosure.

## Claims

1. A back contact solar cell, comprising:
a semiconductor substrate, wherein first regions and second regions that are alternately distributed at intervals are provided on a back surface of the semiconductor substrate, and a spacing region is located between each of the first regions and a second region adjacent to the first region;
a first doped semiconductor layer formed on the first regions provided on the back surface;
a second doped semiconductor layer formed at least on the second regions provided on the back surface, wherein a conductivity type of the second doped semiconductor layer is opposite to that of the first doped semiconductor layer; and
a first dielectric layer and a second dielectric layer that are formed at least on the spacing regions provided on the back surface, wherein at least a portion of the first dielectric layer and at least a portion of the second dielectric layer are stacked between the first doped semiconductor layer and the second doped semiconductor layer in a direction in which the first regions and the second regions are arranged, at least a portion of the first dielectric layer is in contact with the first doped semiconductor layer, and at least a portion of the second dielectric layer is in contact with the second doped semiconductor layer; a material of the first dielectric layer is different from that of the second dielectric layer; and a structure formed by the first dielectric layer and the second dielectric layer is configured for electrically isolating at least some regions of the first doped semiconductor layer from at least some regions of the second doped semiconductor layer.

2. The back contact solar cell according to claim 1, wherein the material of the first dielectric layer includes an oxygen element; and/or
the material of the first dielectric layer includes a silicon element.

3. The back contact solar cell according to claim 2, wherein the first dielectric layer comprises a tunnel oxide layer; and/or
the material of the first dielectric layer comprises at least one of silicon dioxide, silicon oxynitride, hafnium oxide, aluminum oxide, and zinc oxide; and/or
the second dielectric layer comprises a crystalline silicon layer, and a doping type of the crystalline silicon layer comprises at least one of an intrinsic type and a lightly-doped type.

4. The back contact solar cell according to claim 3, wherein in a case that the doping type of the crystalline silicon layer comprises the lightly-doped type, a doping concentration of the crystalline silicon layer is greater than or equal to 1×10¹⁵ cm⁻³ and less than or equal to 5×10²¹ cm⁻³; and/or
in a case that the doping type of the crystalline silicon layer comprises the intrinsic type and the lightly-doped type, a portion of the crystalline silicon layer whose doping type is the intrinsic type and a portion of the crystalline silicon layer whose doping type is the lightly-doped type are distributed in a direction from the second dielectric layer toward the second doped semiconductor layer, and the portion of the lightly-doped type is in contact with the second doped semiconductor layer.

5. The back contact solar cell according to claim 1 or 2, wherein the first dielectric layer is an amorphous dielectric layer, and the second dielectric layer comprises at least one of a microcrystalline dielectric layer, a nanocrystalline dielectric layer, a polycrystalline dielectric layer, or a monocrystalline dielectric layer.

6. The back contact solar cell according to claim 1, wherein in the direction in which the first regions and the second regions are arranged, a width of a portion of the first dielectric layer that corresponds to the spacing region is greater than or equal to 1 nm and less than or equal to 3 nm; and/or
in the direction in which the first regions and the second regions are arranged, a width of a portion of the second dielectric layer that corresponds to the spacing region is greater than or equal to 80 nm and less than or equal to 300 nm.

7. The back contact solar cell according to claim 1, wherein the first dielectric layer comprises a first dielectric portion and a second dielectric portion that are integrally continuous; the first dielectric portion is located between the second dielectric layer and the first doped semiconductor layer in the direction in which the first regions and the second regions are arranged; and the second dielectric portion is located between the second dielectric layer and the semiconductor substrate.

8. The back contact solar cell according to claim 1 or 7, wherein the first dielectric layer comprises the first dielectric portion and a third dielectric portion that are integrally continuous; the first dielectric portion is located between the second dielectric layer and the first doped semiconductor layer in the direction in which the first regions and the second regions are arranged; and the third dielectric portion is located on a side of the first doped semiconductor layer that faces away from the semiconductor substrate, and an extended-through first conductive window is provided in the third dielectric portion.

9. The back contact solar cell according to claim 8, wherein the second dielectric layer extends onto the third dielectric portion comprised in the first dielectric layer, and the first conductive window extends through a portion of the second dielectric layer that corresponds to the first region.

10. The back contact solar cell according to claim 1 or 7, wherein the second doped semiconductor layer comprises a first doped portion and a second doped portion that are electrically connected to each other; the first doped portion is located on the second regions; and the second doped portion is located on a side of the second dielectric layer that faces away from the first dielectric layer, and a doping concentration of the second doped portion is less than a doping concentration of the first doped portion.

11. The back contact solar cell according to claim 8, wherein the second doped semiconductor layer comprises a first doped portion and a second doped portion that are electrically connected to each other; the first doped portion is located on the second regions; the second doped portion is disposed in the spacing region and extends to the first region, a portion of the second doped portion that corresponds to the spacing region is located on a side of the second dielectric layer that faces away from the first dielectric layer, and a portion of the second doped portion that corresponds to the first region is located on an upper portion of the third dielectric portion that faces away from the first doped semiconductor layer; and a doping concentration of the second doped portion is less than a doping concentration of the first doped portion.

12. The back contact solar cell according to claim 11, wherein the second dielectric layer extends onto the third dielectric portion comprised in the first dielectric layer, the portion of the second doped portion that corresponds to the first region is located on a portion of the second dielectric layer that corresponds to the first region, and the first conductive window extends through the second dielectric layer and the portion of the second doped portion that corresponds to the first region; and/or
the back contact solar cell further comprises a third dielectric layer located between the third dielectric portion and the first doped semiconductor layer, and the first conductive window extends through the third dielectric layer.

13. The back contact solar cell according to claim 10 or 11, wherein a thickness of the second doped portion is greater than or equal to 40 nm and less than or equal to 150 nm; and/or
the doping concentration of the second doped portion is greater than 0 and less than or equal to 1×10²⁰ cm⁻³; and/or
in the direction in which the first regions and the second regions are arranged, the width of the portion of the second dielectric layer that corresponds to the spacing region is greater than or equal to 40 nm and less than or equal to 150 nm.

14. The back contact solar cell according to claim 8 or 9, wherein the back contact solar cell further comprises a third dielectric layer located between the third dielectric portion and the first doped semiconductor layer, and the first conductive window extends through the third dielectric layer.

15. The back contact solar cell according to claim 14, wherein in the direction in which the first regions and the second regions are arranged, widths of portions of the third dielectric layer that are located on two sides of the first conductive window are equal; and/or
in the direction in which the first regions and the second regions are arranged, a width of a portion of the third dielectric layer that is located on at least one side of the first conductive window is greater than or equal to 40 µm and less than or equal to 220 µm.

16. The back contact solar cell according to claim 14, wherein a material of the first doped semiconductor layer includes a silicon element, and the third dielectric layer comprises a doped silicon glass layer.

17. The back contact solar cell according to claim 1, wherein the second doped semiconductor layer comprises a first doped portion and a third doped portion that are electrically connected to each other; the first doped portion is located on the second regions, and the third doped portion is located on the spacing regions; and a doping concentration of the third doped portion is less than a doping concentration of the first doped portion.

18. The back contact solar cell according to claim 17, wherein the doping concentration of the third doped portion is greater than or equal to 1×10¹⁵ cm⁻³ and less than or equal to 5×10²¹ cm⁻³; and/or
in a direction from the second region to the first region, the doping concentration of the third doped portion gradually decreases.

19. The back contact solar cell according to claim 17, wherein in the direction in which the first regions and the second regions are arranged, a width ratio of the third doped portion to the first doped portion is greater than or equal to 1:20000 and less than or equal to 2:700.

20. The back contact solar cell according to claim 17, wherein the back contact solar cell further comprises a first electrode and a second electrode, the first electrode is formed on the first doped semiconductor layer, and is in ohmic contact with the first doped semiconductor layer, and the second electrode is formed on the first doped portion, and is in ohmic contact with the first doped portion; and
in the direction in which the first regions and the second regions are arranged, a spacing between a geometric center of a portion of the second electrode that is adjacent to the third doped portion and the third doped portion is greater than or equal to 110 µm and less than or equal to 380 µm.

21. The back contact solar cell according to claim 1, 7, or 17, wherein a groove structure is provided on the back surface of the semiconductor substrate; and both the second regions and the spacing regions are located in the groove structure.

22. The back contact solar cell according to claim 21, wherein a portion of a bottom surface of the groove structure that corresponds to the spacing region is flush with a portion of the bottom surface of the groove structure that corresponds to the second region, or, in a direction from a light-receiving surface to the back surface of the semiconductor substrate, a portion of a bottom surface of the groove structure that corresponds to the spacing region is lower than a portion of the bottom surface of the groove structure that corresponds to the second region; and/or
a depth of the groove structure is greater than or equal to 0.3 µm and less than or equal to 3 µm.

23. The back contact solar cell according to claim 1, wherein the back contact solar cell further comprises a first passivation layer located between the first doped semiconductor layer and the semiconductor substrate; and/or
the back contact solar cell further comprises a second passivation layer located between the second doped semiconductor layer and the semiconductor substrate.

24. The back contact solar cell according to claim 23, wherein in a case that the back contact solar cell further comprises the second passivation layer,
the first dielectric layer and the second passivation layer are integrally continuous; and/or, a porosity of the first dielectric layer is less than that of the second passivation layer.

25. The back contact solar cell according to claim 1, 3, or 4, wherein the second dielectric layer and the second doped semiconductor layer are integrally continuous.

26. The back contact solar cell according to claim 1, wherein the back contact solar cell further comprises a surface passivation layer, and the surface passivation layer covers the second doped semiconductor layer, and extends above the first doped semiconductor layer in the direction in which the first regions and the second regions are arranged; and
an extended-through first conductive window is provided in a portion of the surface passivation layer that corresponds to the first region, at least a portion of the first doped semiconductor layer is exposed at a bottom of the first conductive window, an extended-through second conductive window is provided in a portion of the surface passivation layer that corresponds to the second region, and at least a portion of the second doped semiconductor layer is exposed at a bottom of the second conductive window.

27. The back contact solar cell according to claim 1, wherein the back contact solar cell further comprises a first electrode and a second electrode, the first electrode is formed on the first doped semiconductor layer, and is in ohmic contact with the first doped semiconductor layer, and the second electrode is formed on the second doped semiconductor layer, and is in ohmic contact with the second doped semiconductor layer, wherein
each of the first electrode and the second electrode comprises a plurality of fingers and a plurality of busbars, both the fingers comprised in the first electrode and the fingers comprised in the second electrode extend in a first direction and are alternately distributed at intervals in a second direction, the first direction is different from the second direction, both the busbars comprised in the first electrode and the busbars comprised in the second electrode extend in the second direction and are alternately distributed at intervals in the first direction, and each of the busbars is electrically connected to fingers having a same polarity as that of the busbar, and is insulated from fingers having a polarity opposite to that of the busbar; and
a width, in a width direction of the spacing region, of a portion of the structure formed by the first dielectric layer and the second dielectric layer that is between two adjacent fingers having opposite polarities is approximately the same as a thickness of the second doped semiconductor layer; and/or, a length, in an extension direction of the spacing region, of a portion of the structure formed by the first dielectric layer and the second dielectric layer that is between two adjacent fingers having opposite polarities is greater than or equal to 300 µm and less than or equal to 3000 µm; and/or, a width, in a width direction of the spacing region, of a portion of the structure formed by the first dielectric layer and the second dielectric layer that is between a finger and a busbar that have opposite polarities and that are adjacent to each other is approximately the same as a thickness of the second doped semiconductor layer; and/or, a length, in an extension direction of the spacing region, of a portion of the structure formed by the first dielectric layer and the second dielectric layer that is between a finger and a busbar that have opposite polarities and that are adjacent to each other is greater than or equal to 200 µm and less than or equal to 700 µm; and/or, a spacing between two adjacent fingers having opposite polarities is greater than or equal to 200 µm and less than or equal to 700 µm; and/or, a width of each of the fingers is greater than or equal to 15 µm and less than or equal to 60 µm.

28. The back contact solar cell according to claim 1, wherein corresponding portions of the first dielectric layer and the second dielectric layer that are between the first doped semiconductor layer and the second doped semiconductor layer are located on all regions of the spacing region in an extension direction of the spacing region, and are configured for electrically isolating the first doped semiconductor layer from the second doped semiconductor layer; or
corresponding portions of the first dielectric layer and the second dielectric layer that are between the first doped semiconductor layer and the second doped semiconductor layer have a discontinuity in an extension direction of the spacing region, the back contact solar cell further comprises a conductive structure located at least within the discontinuity, a conductivity type of the conductive structure is opposite to that of one of the first doped semiconductor layer and the second doped semiconductor layer, and only some regions of the first doped semiconductor layer and only some regions of the second doped semiconductor layer are respectively electrically connected to the conductive structure.

29. The back contact solar cell according to claim 28, wherein in a case that the back contact solar cell further comprises the conductive structure, at least a portion of the conductive structure is integrally continuous with the second doped semiconductor layer; and/or
in a case that the back contact solar cell further comprises the conductive structure, the structure formed by the first dielectric layer and the second dielectric layer is integrally continuous with the conductive structure.

30. The back contact solar cell according to claim 1, wherein a non-pyramid structure is formed on a surface of the first region, a one-dimensional size of a base of the non-pyramid structure on the surface of the first region is greater than or equal to 0.5 µm and less than or equal to 20 µm, and the base of the non-pyramid structure is closer to the semiconductor substrate than a top of the non-pyramid structure; and/or
a non-pyramid structure is formed on a surface of the second region, a one-dimensional size of a base of the non-pyramid structure on the surface of the second region is greater than or equal to 10 µm and less than or equal to 50 µm, and the base of the non-pyramid structure is closer to the semiconductor substrate than a top of the non-pyramid structure; and/or
a non-pyramid structure is formed on a surface of the spacing region, a one-dimensional size of a base of the non-pyramid structure on the surface of the spacing region is greater than or equal to 10 µm and less than or equal to 50 µm, and the base of the non-pyramid structure is closer to the semiconductor substrate than a top of the non-pyramid structure.

31. A method for manufacturing a back contact solar cell, comprising:
providing a semiconductor substrate, wherein first regions and second regions that are alternately distributed at intervals and a spacing region that is located between each of the first regions and a second region adjacent to the first region are provided on a back surface of the semiconductor substrate;
forming a first doped semiconductor layer on the first regions provided on the back surface;
forming a second doped semiconductor layer at least on the second regions provided on the back surface, wherein a conductivity type of the second doped semiconductor layer is opposite to that of the first doped semiconductor layer; and
forming a first dielectric layer and a second dielectric layer at least on the spacing regions provided on the back surface, wherein at least a portion of the first dielectric layer and at least a portion of the second dielectric layer are stacked between the first doped semiconductor layer and the second doped semiconductor layer in a direction in which the first regions and the second regions are arranged, at least a portion of the first dielectric layer is in contact with the first doped semiconductor layer, at least a portion of the second dielectric layer is in contact with the second doped semiconductor layer, and a material of the first dielectric layer is different from that of the second dielectric layer.

32. The method for manufacturing a back contact solar cell according to claim 31, wherein the forming a first doped semiconductor layer on the first regions provided on the back surface comprises:
forming the first doped semiconductor layer on the entire back surface and a third dielectric layer that is located on a portion of the first doped semiconductor layer that corresponds to the first region; or forming the first doped semiconductor layer and a third dielectric layer on the entire back surface, performing heat treatment on portions of the third dielectric layer that correspond to the second region and the spacing region by a laser irradiation process, and forming a mask on a portion of the third dielectric layer that corresponds to the first region after the heat treatment; and
under the mask of the portion of the third dielectric layer that corresponds to the first region, removing portions of the first doped semiconductor layer that correspond to the second region and the spacing region.

33. The method for manufacturing a back contact solar cell according to claim 31, wherein after the providing a semiconductor substrate, and before the forming a second doped semiconductor layer at least on the second regions provided on the back surface, the method for manufacturing a back contact solar cell comprises:
forming a first passivation layer on the first regions and the first doped semiconductor layer on a side of the first passivation layer that faces away from the semiconductor substrate.

34. The method for manufacturing a back contact solar cell according to claim 32, wherein after the forming a first doped semiconductor layer on the first regions provided on the back surface, and before the forming a second doped semiconductor layer at least on the second regions provided on the back surface, the method for manufacturing a back contact solar cell further comprises: forming a second passivation layer at least on the second regions provided on the back surface.

35. The method for manufacturing a back contact solar cell according to claim 34, wherein the forming a second doped semiconductor layer, a second passivation layer, a first dielectric layer, and a second dielectric layer comprises:
sequentially forming, in a thickness direction of the semiconductor substrate, a passivation material layer and an intrinsic semiconductor layer that are stacked over the first doped semiconductor layer, the spacing regions, and the second regions; and
selectively doping a portion of the intrinsic semiconductor layer that corresponds to the second region, wherein after the selective doping, the second doped semiconductor layer is formed in the portion of the intrinsic semiconductor layer that corresponds to at least the second region, the second dielectric layer is formed in portions of the intrinsic semiconductor layer that correspond to at least some spacing regions, the second passivation layer is formed in a portion of the passivation material layer that is located between the second doped semiconductor layer and the semiconductor substrate, and the first dielectric layer is formed in a portion of the passivation material layer that corresponds to at least some spacing regions.

36. The method for manufacturing a back contact solar cell according to claim 35, wherein after the selectively doping a portion of the intrinsic semiconductor layer that corresponds to the second region, the method for manufacturing a back contact solar cell comprises:
reserving a portion of the passivation material layer that corresponds to the first region and a portion of the intrinsic semiconductor layer that corresponds to the first region; and
forming, above the first regions, a first conductive window extending through the third dielectric layer, the passivation material layer, and the intrinsic semiconductor layer.

37. The method for manufacturing a back contact solar cell according to claim 35, wherein after the selectively doping a portion of the intrinsic semiconductor layer that corresponds to the second region, the method for manufacturing a back contact solar cell comprises:
selectively removing a portion of the intrinsic semiconductor layer that corresponds to the first region, and reserving a portion of the passivation material layer that corresponds to the first region; and
forming, above the first regions, a first conductive window extending through the third dielectric layer and the passivation material layer.

38. The method for manufacturing a back contact solar cell according to claim 35, wherein after the sequentially forming, in a thickness direction of the semiconductor substrate, a passivation material layer and an intrinsic semiconductor layer that are stacked over the first doped semiconductor layer, the spacing regions, and the second regions, and before the selectively doping a portion of the intrinsic semiconductor layer that corresponds to the second region, the method for manufacturing a back contact solar cell further comprises:
lightly doping a side of the intrinsic semiconductor layer that faces away from the semiconductor substrate.

39. The method for manufacturing a back contact solar cell according to claim 38, wherein after the selectively doping a portion of the intrinsic semiconductor layer that corresponds to the second region, the method for manufacturing a back contact solar cell comprises:
reserving a portion of the passivation material layer that corresponds to the first region and a portion of the intrinsic semiconductor layer that corresponds to the first region after the light doping; and
forming, above the first regions, a first conductive window extending through the third dielectric layer, the passivation material layer, and the intrinsic semiconductor layer after the light doping.

40. The method for manufacturing a back contact solar cell according to claim 35 or 38, wherein after the selectively doping a portion of the intrinsic semiconductor layer that corresponds to the second region, the method for manufacturing a back contact solar cell further comprises:
selectively removing portions of the intrinsic semiconductor layer and the passivation material layer that correspond to the first region; and
removing the portion of the third dielectric layer that corresponds to the first region.

41. The method for manufacturing a back contact solar cell according to claim 31, wherein after the forming a first doped semiconductor layer on the first regions provided on the back surface, and before the forming a second doped semiconductor layer at least on the second regions provided on the back surface, the method for manufacturing a back contact solar cell further comprises:
selectively etching the back surface of the semiconductor substrate to form a groove structure on the back surface, wherein both the second regions and the spacing regions are located in the groove structure.

42. The method for manufacturing a back contact solar cell according to claim 31, wherein after the forming a first dielectric layer and a second dielectric layer at least on the spacing regions provided on the back surface, the method for manufacturing a back contact solar cell further comprises:
forming a surface passivation layer on back surface, wherein the surface passivation layer covers the second doped semiconductor layer, and extends above the first doped semiconductor layer in the direction in which the first regions and the second regions are arranged; and
opening an extended-through first conductive window in a portion of the surface passivation layer that corresponds to the first region, and opening an extended-through second conductive window in a portion of the surface passivation layer that corresponds to the second region, wherein at least a portion of the first doped semiconductor layer is exposed at a bottom of the first conductive window, and at least a portion of the second doped semiconductor layer is exposed at a bottom of the second conductive window.
